# EUROPEAN PATENT APPLICATION

(11) **EP 4 763 381 A1**
(43) Date of publication of application: **24.06.2026**
(21) Application number: 23949154.1
(22) Date of filing: 15.08.2023
(51) Int. Cl.: B22F 10/80, B22F 10/25, B22F 10/66, B22F 12/90, B33Y 50/00

(54) **INFORMATION PROCESSING METHOD, COMPUTER PROGRAM, RECORDING MEDIUM, INFORMATION PROCESSING DEVICE, AND PROCESSING DEVICE**

(71) Applicant: NIKON CORPORATION, Tokyo 140-8601 (JP)
(72) Inventor: NAKAUNE, Yusuke, Tokyo 140-8601 (JP); NAKAGAWA, Tomoya, Tokyo 140-8601 (JP)
(74) Representative: Hoffmann Eitle
(86) International application number: PCT/JP2023/029518
(87) International publication number: WO 2025/037384

(57) **Abstract**

An information processing method including: acquiring a difference model indicating difference between an object model acquired by measuring a three-dimensional shape of an object and a target model indicating a target shape of the object after a processing, generated based on the object model; acquiring a post-processing model indicating at least a part of a three-dimensional shape of a post-processing object, which is the object processed based on the difference model, by measuring the post-processing object; and generating difference information relating to a difference between the difference model and the post-processing model.

## Description

### Technical Field

The present invention relates to a technical field of an information processing method, a computer program, a recording medium, an information processing apparatus, and a processing apparatus.

### Background Art

An example of a processing apparatus for processing objects is described in a Patent Literature 1. One technical problem of this processing apparatus is to appropriately generate processing control information for controlling a processing of the object.

### Citation List

### Patent Literature

Patent Literature 1: US2018/0029298A1

### Summary of Invention

A first aspect provides an information processing method including: acquiring a difference model indicating difference between an object model acquired by measuring a three-dimensional shape of an object and a target model indicating a target shape of the object after a processing, generated based on the object model; acquiring a post-processing model indicating at least a part of a three-dimensional shape of a post-processing object, which is the object processed based on the difference model, by measuring the post-processing object; and generating difference information relating to a difference between the difference model and the post-processing model.

A second aspect provides a computer program for causing a computer to execute the information processing method provided by the first aspect described above.

A third aspect provides a recording medium storing a computer program for causing a computer to execute the information processing method provided by the first aspect described above.

A fourth aspect provides an information processing apparatus configured to generate the display data using the information processing method provided by the first aspect described above.

A fifth aspect provides a processing apparatus configured to perform at least one of a removal processing and an additive processing on an object that has undergone the processing, based on the difference information generated by the information processing method provided by the first aspect described above.

A sixth aspect provides an information processing method including: acquiring an object model acquired by measuring a three-dimensional shape of an object; acquiring a target model indicating a target shape of the object after a processing, generated based on the object model; acquiring a difference model indicating difference between the object model and the target model; acquiring a post-processing model indicating at least a part of a three-dimensional shape of a post-processing object, which is the object processed based on the difference model, by measuring the post-processing object; and generating difference information relating to a difference between the difference model and the post-processing model.

A seventh aspect provides an information processing method including: acquiring a difference model indicating difference between an object model acquired by measuring a three-dimensional shape of an object and a target model indicating a target shape of the object after a processing; acquiring a post-processing model indicating at least a part of a three-dimensional shape of a post-processing object, which is the object processed based on the difference model, by measuring the post-processing object; and generating difference information relating to a difference between the difference model and the post-processing model.

A eighth aspect provides an information processing method including: acquiring a target model indicating a target shape of an object after a processing; acquiring a post-processing model indicating at least a part of a three-dimensional shape of a post-processing object, which is the object processed based on the object model and the target model, by measuring the post-processing object; and generating difference information relating to a difference between the target model and the post-processing model.

An operation and another advantage of the present invention will be apparent from an example embodiment described below.

### Brief Description of the Drawings

[FIG. 1] FIG. 1 is a block diagram that illustrates an entire configuration of a processing system in an example embodiment.
[FIG. 2] FIG. 2 is a block diagram that illustrates a configuration of a processing apparatus in the example embodiment.
[FIG. 3] FIG. 3 is a cross-sectional view that illustrates the configuration of the processing apparatus in the example embodiment.
[FIG. 4] FIG. 4 is a block diagram that illustrates a configuration of a measurement system in the example embodiment.
[FIG. 5] FIG. 5 is a block diagram that illustrates a configuration of a control information generation apparatus in the example embodiment.
[FIG. 6] Each of FIG. 6(a) to FIG 6(e) is a cross-sectional view that illustrates an aspect in which a certain area on a workpiece is irradiated with build light and a build material is supplied thereto.
[FIG. 7] Each of FIG. 7(a) to FIG. 7(c) is a cross-sectional view that illustrates a process for forming a three-dimensional structural object.
[FIG. 8] FIG. 8(a) is a figure that schematically illustrates a reference model, and FIG. 8(b) is a figure that schematically illustrates an object model.
[FIG. 9] FIG. 9(a) is a figure that schematically illustrates the reference model, FIG. 9(b) is a figure that schematically illustrates the object model, and FIG. 9(c) is a figure that schematically illustrates a difference model that is generated based on the reference model illustrated in FIG. 9(a) and the object model illustrated in FIG. 9(b).
[FIG. 10] FIG. 10(a) is a figure that schematically illustrates the reference model in a case where the workpiece is deformed due to a use of the workpiece, and FIG. 10(b) is a figure that schematically illustrates the object model in a case where the workpiece is deformed due to the use of the workpiece.
[FIG. 11] FIG. 11(a) is a figure that schematically illustrates the reference model in a case where the workpiece is deformed due to the use of the workpiece, FIG. 11(b) is a figure that schematically illustrates the object model in a case where the workpiece is deformed due to the use of the workpiece, and FIG. 11(c) is a figure that schematically illustrates the difference model that is generated based on the reference model illustrated in FIG. 11(a) and the object model illustrated in FIG. 11(b).
[FIG. 12] FIG. 12 is a flowchart that illustrates a flow of a control information generation operation in the present example embodiment.
[FIG. 13] FIG. 13 is a figure that schematically illustrates the reference model that is not deformed and the reference model that is deformed.
[FIG. 14] FIG. 14 is a figure that schematically illustrates the reference model that is not deformed and the reference model that is deformed.
[FIG. 15] FIG. 15(a) is a figure that schematically illustrates the reference model that is not deformed, and FIG. 15(b) is a figure that schematically illustrates the reference model that is deformed.
[FIG. 16] FIG. 16(a) is a figure that schematically illustrates the reference model in a case where the workpiece is deformed due to the use of the workpiece, FIG. 16(b) is a figure that schematically illustrates the object model in a case where the workpiece is deformed due to the use of the workpiece, and FIG. 16(c) is a figure that schematically illustrates the difference model that is generated based on the reference model illustrated in FIG. 16(a) and the object model illustrated in FIG. 16(b).
[FIG. 17] FIG. 17 is a flowchart that illustrates a flow of one specific example of an operation for generating a deformation model by deforming the reference model at a step S4 in FIG. 12.
[FIG. 18] FIG. 18 is a figure that schematically illustrates one example of an alignment of the reference model and the object model.
[FIG. 19] FIG. 19 is a figure that schematically illustrates one example of the reference model in which each vertex is specified as one of a fixed vertex, a control vertex, and a dependent vertex.
[FIG. 20] FIG. 20 is a figure that schematically illustrates the reference model that is not deformed and the reference model that is deformed.
[FIG. 21] FIG. 21(a) is a figure that schematically illustrates an object model, and FIG. 21(b) is a figure that schematically illustrates a deformed object model.
[FIG. 22] FIG. 22(a) is a figure that schematically illustrates a deformed object model, FIG. 22(b) is a figure that schematically illustrates an object model, and FIG. 22(c) is a figure that schematically illustrates a difference model generated based on the deformed object model illustrated in FIG. 22(a) and the object model illustrated in FIG. 22(b).
[FIG. 23] FIG. 23 is a flowchart that illustrates a flow of an operation of the processing system in the example embodiment.
[FIG. 24] FIG. 24(a) is a figure that illustrates an example of a reference model, FIG. 24(b) is a figure that illustrates an example of a post-processing model, and FIG. 24(c) is a figure that illustrates an example of a post-processing divisional model.
[FIG. 25] FIG. 25(a) is a figure that illustrates an example of a reference model, FIG. 25(b) is a figure that illustrates an example of a post-processing divisional model, and FIG. 25(c) is a figure that illustrates an example of an object model.
[FIG. 26] FIG. 26 is a figure that illustrates an example of a post-processing divisional model and an object model that are aligned.
[FIG. 27] FIG. 27(a) is a figure that schematically illustrates a post-processing divisional model, FIG. 27(b) is a figure that schematically illustrates an object model, and FIG. 27(c) is a figure that schematically illustrates a processed part model generated based on the post-processing divisional model illustrated in FIG. 27(a) and the object model illustrated in FIG. 27(b).
[FIG. 28] FIG. 28 is a figure that illustrates an example of a difference point display image.
[FIG. 29] FIG. 29 is a figure that illustrates an example of a point cloud cluster display image.
[FIG. 30] FIG. 30(a) is a figure that schematically illustrates a processed part model, FIG. 30(b) is a figure that schematically illustrates a difference model, and FIG. 30(c) is a figure that schematically illustrates a post-processing difference model generated based on the processed part model illustrated in FIG. 30(a) and the difference model illustrated in FIG. 30(b).
[FIG. 31] FIG. 31 is a figure that illustrates an example of a contour diagram.
[FIG. 32] FIG. 32 is a conceptual diagram that illustrates an example of a method for calculating a difference amount.
[FIG. 33] FIG. 33 is a figure that illustrates an example of an inspection information image indicating information relating to inspection.
[FIG. 34] FIG. 34(a) is a figure that illustrates another example of a post-processing model, FIG. 34(b) is a figure that illustrates a part of the post-processing model illustrated in FIG. 34(a), and FIG. 34(c) is a figure that illustrates an example of a jig model.
[FIG. 35] FIG. 35(a) is a perspective view that illustrates a structure of a holding tool that does not actually hold a workpiece, and FIG. 35(b) is a perspective view that illustrates a structure of the holding tool that actually holds the workpiece..
[FIG. 36] FIG. 36 is a flowchart that illustrates a flow of a calibration operation.
[FIG. 37] FIG. 37 is a cross-sectional view that illustrates one example of a base plate.
[FIG. 38] FIG. 38(a) is a cross-sectional view that illustrates the base plate processed by the processing apparatus, and FIG. 38(b) is a top view that illustrates the base plate processed by the processing apparatus.
[FIG. 39] FIG. 39(a) is a cross-sectional view that illustrates one example of the base plate, and FIG. 39(b) is a top view that illustrates one example of the base plate.
[FIG. 40] Each of FIG. 40(a) and FIG. 40(c) is a cross-sectional view that illustrates the base plate that is irradiated with a plurality of guide lights, and each of FIG. 40(b) and FIG. 40(d) is a top view that illustrates the base plate that is irradiated with the plurality of guide lights.
[FIG. 41] FIG. 41 is a top view that illustrates a positional relationship between a processed part of the base plate and a reference part of the holding tool.
[FIG. 42] FIG. 42 is a cross-sectional view that illustrates the positional relationship between the processed part of the base plate and the reference part of the holding tool.
[FIG. 43] FIG. 43 is a flowchart that illustrates a flow of a processing path generation operation.
[FIG. 44] FIG. 44 illustrates a measurement model, a target model, and a processing model.
[FIG. 45] FIG. 45 illustrates the measurement model, the target model, and the processing model.

### Description of Example embodiment

The following describes example embodiments of an information processing method, a computer program, a recording medium, an information processing apparatus, and a processing apparatus with reference to drawings. In the below-described description, the example embodiment of the information processing method, the computer program, the recording medium, the information processing apparatus, and the processing apparatus will be described by using a processing system SYS that is configured to process a workpiece W that is one example of an object.

In the below-described description, a turbine blade constituting a turbine is given as a specific example of at least one of the workpiece W and the build object. Incidentally, at least one of a power generation turbine and an aircraft engine turbine is given as an example of the turbine. Incidentally, at least one of the workpiece W and the build object may be at least one of: (i) a propeller-shaped part, (ii) a body part for vehicles such as automobiles, motorcycles, electric vehicles, and railway vehicles, (iii) a part for engines such as automobile engines, motorcycle engines, and aerospace engines, and (iv) a part for electric vehicle batteries.

### (1) Configuration of the Processing System SYS

### (1-1) Entire Configuration of Processing System SYS

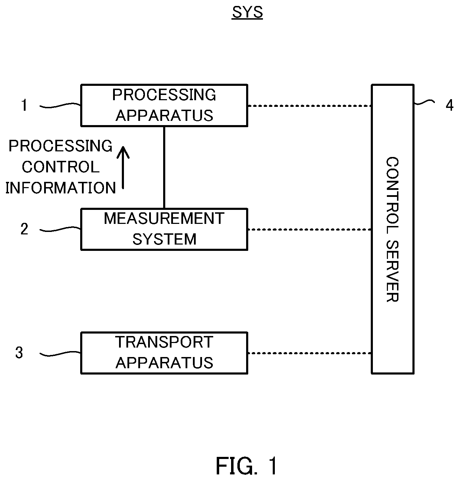

First, with reference to FIG. 1, an entire configuration of the processing system SYS will be described. FIG. 1 is a block diagram that illustrates the entire configuration of the processing system SYS.

As illustrated in FIG. 1, the processing system SYS includes a processing apparatus 1, a measurement system 2, and a transport apparatus 3. Incidentally, the processing system SYS includes the single processing apparatus 1 in an example illustrated in FIG. 1, however, it may include a plurality of processing apparatuses 1. In this case, the number of the measurement system 2 may be less than the number of the processing apparatus 1. The processing system SYS includes the single measurement system 2 in an example illustrated in FIG. 1, however, it may include a plurality of measurement systems 2. In this case, the number of the processing apparatus 1 is less than the number of the measurement system 2. The processing system SYS includes the single transport apparatus 3, however, it may include a plurality of transport apparatuses 3. The transport apparatus 3 may be, for example, an automated guided vehicle (AGV), a robot, a belt conveyor, etc. The transport apparatus 3 may be provided with an arm, a pallet, a belt, or a chain as a transport means for transporting the workpiece W. Incidentally, the processing system SYS may not include the transport apparatus 3.

The processing apparatus 1 is configured to process the workpiece W. In the present example embodiment, an example in which the processing apparatus 1 is a processing apparatus that is configured to process the workpiece W by irradiating the workpiece W with processing light EL (namely, an energy beam in the form of light). However, the processing apparatus 1 may process the workpiece W without using the processing light EL.

The processing apparatus 1 is configured to perform an additive manufacturing on the workpiece W. Namely, the processing apparatus 1 is configured to build a build object on the workpiece W by performing the additive manufacturing on the workpiece W. In this case, the processing apparatus 1 may build the build object that is integrated with or separable from the workpiece W by performing the additive processing on the workpiece W. The build object that is built by the processing apparatus 1 may mean any object that is built by the processing apparatus 1. For example, the processing apparatus 1 may build a three-dimensional structural object ST (namely, a three-dimensional structure having a size in each of three-dimensional directions, a solid object, in other words, an object having a size in an X-axis direction, a Y-axis direction, and a Z-axis direction) as one example of the build object.

The processing apparatus 1 may perform the additive processing by using any additive manufacturing method (namely, a build method) that is capable of building the build object. At least one of a Laser Metal Deposition (LMD), a Powder Bed Fusion (PBF) such as a Selective Laser Sintering (SLS), a Binder Jetting (BJ), a Material Jetting, a Stereo Lithography, and a Laser Metal Fusion (LMF) is one example of the additive manufacturing method. Incidentally, the Laser Metal Deposition may be referred to as a Directed Energy Deposition (DED).

The workpiece W may be an item that needs to be repaired having a lost part. In this case, the processing apparatus 1 may perform a repair processing for repairing (in other words, restoring) the item that needs to be repaired by performing the additive manufacturing for building the build object for filling in the lost part. Namely, the additive manufacturing performed by the processing apparatus 1 may include the additive manufacturing for adding, to the workpiece W, the build object for filling in the lost part. A worn turbine blade is one example of the item that needs to be repaired having the lost part.

The workpiece W may be a base for building the three-dimensional structural object ST. In this case, the processing apparatus 1 may manufacture the three-dimensional structural object ST from scratch by performing the additive manufacturing for building the three-dimensional structural object ST on the workpiece W. As one example, the processing apparatus 1 may manufacture the turbine blade from scratch by performing the additive manufacturing for building the three-dimensional structural object ST corresponding to the turbine blade on the workpiece W.

The workpiece W may be an intermediate product manufactured in a process of building the three-dimensional structural object ST. In this case, the processing apparatus 1 may manufacture the three-dimensional structural object ST from the intermediate product by performing the additive manufacturing for completing the three-dimensional structural object ST on the workpiece W that is the intermediate product of the three-dimensional structural object ST. As one example, the processing apparatus 1 may manufacture a completed product of the turbine blade from the intermediate product of the turbine blade by performing the additive manufacturing for completing the turbine on the workpiece W that is the intermediate product of the turbine blade.

The processing apparatus 1 may be configured to perform a subtractive manufacturing on the workpiece W, in addition to or instead of performing the additive manufacturing. Namely, the processing apparatus 1 may be configured to perform the subtractive manufacturing for removing a part of the workpiece W. Incidentally, the processing apparatus 1 may perform the subtractive manufacturing on the build object built on the workpiece W by the processing apparatus 1, in addition to or instead of performing the subtractive manufacturing on the workpiece W. Moreover, an item that needs to be repaired may be repaired by performing the subtractive manufacturing. This repair by the subtractive manufacturing may be combined with the additive manufacturing.

The measurement system 2 measures the workpiece W before the processing apparatus 1 actually starts processing the workpiece W. In the present example embodiment, the measurement system 2 measures a three-dimensional shape of the workpiece W. Incidentally, when the three-dimensional shape of the workpiece W is determined, a position of the workpiece W (e.g., a position of a surface of the workpiece W) in a three-dimensional space in a measurement coordinate system of the measurement system 2 is also determined. Therefore, measuring the three-dimensional shape of the workpiece W is substantially equivalent to measuring a position of the workpiece W.

Then, the measurement system 2 generates processing control information. The processing control information is control information that is used for controlling the processing apparatus 1 to process the workpiece W. For example, the processing control information may include a processing path information. The processing path information may indicate a target irradiation position that should be irradiated with the processing light EL to process the workpiece W. Specifically, the processing path information may indicate a target movement path that is a path of the target irradiation position that should be irradiated with the processing light EL to process the workpiece W. The target movement path may be referred to as a processing path or a tool path. In this case, the measurement system 2 may generate, as the processing control information, a G-code indicating the processing path or the tool path. The measurement system 2 may generate, as the processing control information, a file whose extension is gcode or gco. The processing control information generated by the measurement system 2 is transmitted from the measurement system 2 to the processing apparatus 1 through a non-illustrated communication network.

The processing apparatus 1 receives (namely, acquires) the processing control information transmitted from the measurement system 2. The processing apparatus 1 that has received the processing control information processes the workpiece W based on the received processing control information. Therefore, the workpiece W is transported from the measurement system 2 to the processing apparatus 1 after the measurement system 2 measures the three-dimensional shapes of the workpiece W. Specifically, the workpiece W is detached from the measurement system 2, and the detached workpiece W is transported to the processing apparatus 1. For example, the workpiece W may be transported from the measurement system 2 to the processing apparatus 1 by the transport apparatus 3. Incidentally, the workpiece W may be transported from the measurement system 2 to the processing apparatus 1 by a user (in other words, by a means differing from the transport apparatus 3) of the processing system SYS. The workpiece W transported to the processing apparatus 1 is set to (in other words, placed in or attached to) the processing apparatus 1. As a result, the processing apparatus 1 is able to process the workpiece W.

Incidentally, in the example illustrated in FIG. 1, the processing system SYS includes the processing apparatus 1 and the measurement system 2 that are separate apparatuses, respectively. However, the processing system SYS may include an apparatus in which the processing apparatus 1 and the measurement system 2 are integrated. Namely, the processing apparatus 1 and the measurement system 2 may be integrated.

The processing system SYS may further include a control server 4. However, the processing system SYS may not include the control server 4.

The control server 4 may control an operation of the entire processing system SYS. For example, the control server 4 may control an operation of the processing apparatus 1. For example, the control server 4 may control an operation of the measurement system 2. For example, the control server 4 may control an operation of the transport apparatus 3.

The control server 4 may serve as a cloud server. In this case, the control server 4 may be configured to communicate with at least one of the processing apparatus 1, the measurement system 2, and the transport apparatus 3 through a communication network including Internet. Alternatively, the control server 4 may serve as an edge server. In this case, the control server 4 may be configured to communicate with at least one of the processing apparatus 1, the measurement system 2, and the transport apparatus 3 through a communication network including an intranet or local area network.

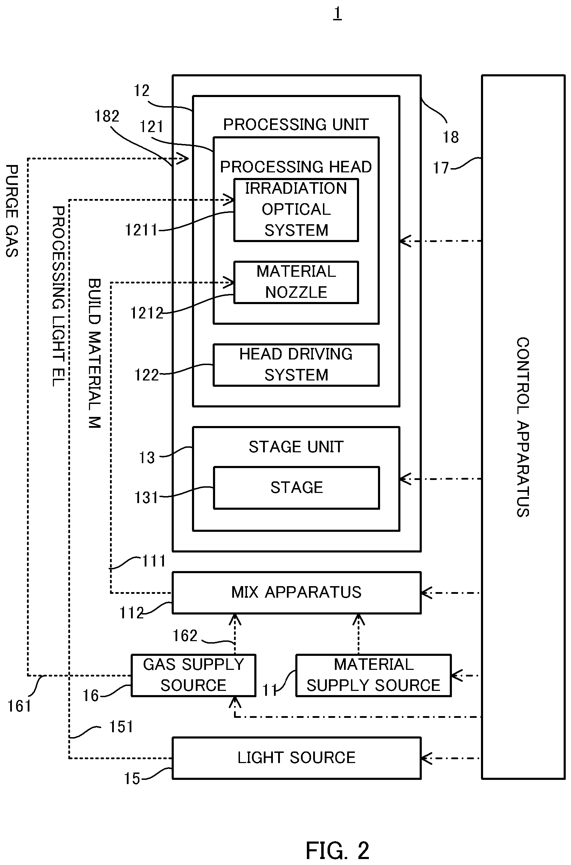

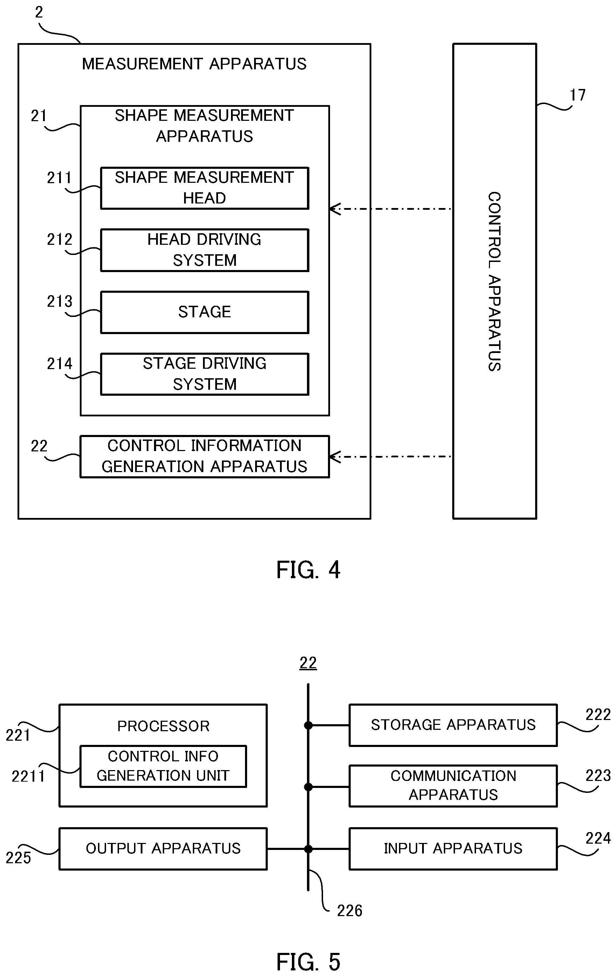

The processing system SYS may include a first computer that controls the processing apparatus 1 as a part of the processing apparatus 1, in addition to or instead of the control server 4 that controls the processing apparatus 1. Namely, the processing apparatus 1 may include the first computer. The first computer may be a laptop computer or any other type of computer such as a desktop computer. The first computer may serve as a below-described control apparatus 17 (see FIG. 2). The processing system SYS may include a second computer that controls the measurement system 2 as a part of the measurement system 2, in addition to or instead of the control server 4 that controls the measurement system 2. Namely, the measurement system 2 may include the second computer. The second computer may be a laptop computer or any other type of computer such as a desktop computer. The second computer may serve as a below-described control information generation apparatus 22 (see FIG. 4). The processing system SYS may include a third computer that controls the transport apparatus 3 as a part of the transport apparatus 3, in addition to or instead of the control server 4 that controls the transport apparatus 3. Namely, the transport apparatus 3 may include the third computer. The third computer may be a laptop computer or any other type of computer such as a desktop computer.

### (1-2) Configuration of Processing Apparatus 1

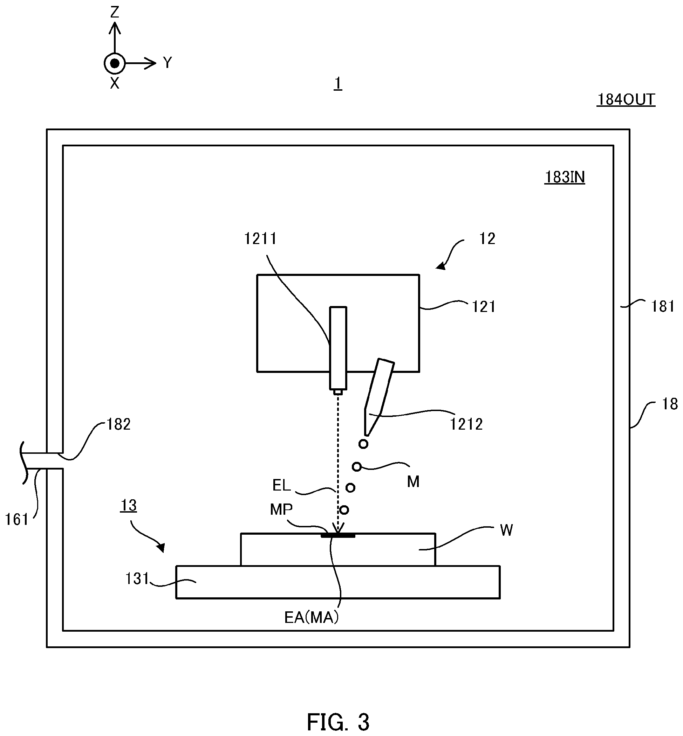

Next, with reference to FIG. 2 and FIG. 3, a configuration of the processing apparatus 1 will be described. FIG. 2 is a block diagram that illustrates a system configuration of the processing apparatus 1. FIG. 3 is a cross-sectional view that illustrates the configuration of the processing apparatus 1.

Incidentally, in the below described description, a positional relationship of various components that constitute the processing apparatus 1 will be described by using an XYZ rectangular coordinate system that is defined by an X-axis, a Y-axis and a Z-axis that are perpendicular to one another. Note that each of an X-axis direction and a Y-axis direction is assumed to be a horizontal direction (namely, a predetermined direction in a horizontal plane) and a Z-axis direction is assumed to be a vertical direction (namely, a direction that is orthogonal to the horizontal plane, and substantially an up-down direction), for the purpose of simple description, in the below described description. Moreover, rotational directions (in other words, inclination directions) around the X-axis, the Y-axis and the Z-axis are referred to as a θX direction, a θY direction and a θZ direction, respectively. Here, the Z-axis direction may be a gravity direction. Moreover, an XY plane may be a horizontal direction.

Moreover, in the below-described description, the configuration of the processing apparatus 1 that performs the additive manufacturing will be described as one example of the configuration of the processing apparatus 1 for convenience of description. Especially, in the below-described description, the configuration of the processing apparatus 1 that performs the additive manufacturing by using the Laser Metal Deposition will be described as one example of the configuration of the processing apparatus 1.

The processing apparatus 1, which performs the additive manufacturing by using the Laser Metal Deposition, performs the additive manufacturing by processing a build material M by using the processing light EL. The build material M is a material that is molten by an irradiation with the processing light EL having a predetermined intensity or more intensity. At least one of a metal material and a resin material is usable as the build material M, for example. However, another material that is different from the metal material and the resin material may be used as the build material M. The build material M is powder-like or grain-like material. Namely, the build material M is powdery material. However, the build material M may not be the powdery material. For example, at least one of a wired-like build material and a gas-like build material may be used as the build material M.

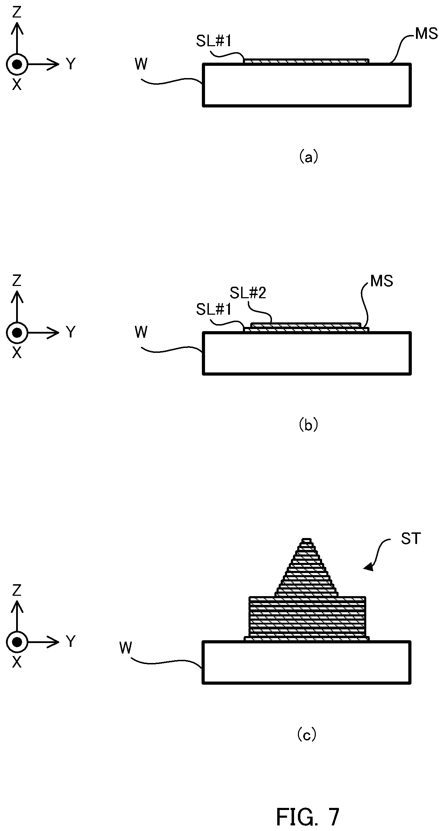

The processing apparatus 1, which performs the additive manufacturing by using the Laser Metal Deposition, builds the three-dimensional structural object ST in which a plurality of structural layers SL (see FIG. 7 below) are stacked by forming the plurality of structural layers SL in sequence. In this case, the processing apparatus 1 first sets a surface of the workpiece W to be a build surface MS on which the build object is actually built, and builds a first structural layer SL on the build surface MS. Then, the processing apparatus 1 sets a surface of the first structural layer SL to be a new build surface MS, and builds a second structural layer SL on the build surface MS. Then, the processing apparatus 1 repeats the same operation to build the three-dimensional structural object ST in which the plurality of structural layers SL are stacked.

In order to perform the additive manufacturing, the processing apparatus 1 includes a material supply source 11, a processing unit 12, a stage unit 13, a light source 15, a gas supply source 16, and a control apparatus 17, as illustrated in FIG. 2 and FIG. 3. The processing unit 12 and the stage unit 13 may be contained in a chamber space 183IN in a housing 18. Incidentally, at least one of the processing unit 12 and the stage unit 13 may not be contained in the chamber space 183IN in a housing 18.

The material supply source 11 supplies the build material M to the processing unit 12. The material supply source 11 supplies, to the processing unit 12, the build material M the amount of which is necessary for performing the additive manufacturing per unit time by supplying the build material M the amount of which is based on the necessary amount.

The processing unit 12 builds the build object by processing the build material M supplied from the material supply source 11. In order to build the build object, the processing unit 12 include a processing head 121 and a head driving system 122. Furthermore, the processing head 121 includes an irradiation optical system 1211 and a material nozzle 1212. Incidentally, in the example illustrated in FIG. 2 and FIG. 3, the processing head 121 includes a single irradiation optical system 1211, but the processing head 121 may include a plurality of irradiation optical systems 1211. Moreover, in the example illustrated in FIG. 2 and FIG. 3, the processing head 121 includes a single material nozzle 1212, but the processing head 121 may include a plurality of material nozzles 1212.

The irradiation optical system 1211 is an optical system (for example, a condensing optical system) for emitting the processing light EL. Specifically, the irradiation optical system 1211 is optically connected to the light source 15 that generates the processing light EL through a light transmitting member 151 such as an optical fiber and a light pipe. The irradiation optical system 1211 emits the processing light EL transmitted from the light source 15 through the light transmitting member 151. The irradiation optical system 1211 emits the processing light EL in a downward direction (namely, toward a -Z side) from the irradiation optical system 1211. The stage 131 is positioned below the irradiation optical system 1211. In a case where the workpiece W is placed on the stage 131, the irradiation optical system 1211 irradiates the workpiece W with the emitted processing light EL. In this case, the irradiation optical system 1211 irradiates the workpiece W with the emitted processing light EL from a position above the workpiece W. Specifically, the irradiation optical system 1211 is configured to irradiate a target irradiation area EA, which is set on the workpiece W or near the workpiece W as an area that is irradiated with the processing light EL (typically, in which the light is condensed), with the processing light EL. Furthermore, a state of the irradiation optical system 1211 is switchable between a state where the target irradiation area EA is irradiated with the processing light EL and a state where the target irradiation area EA is not irradiated with the processing light EL under the control of the control apparatus 17.

The material nozzle 1212 supplies (for example, injects, jets, blows out or sprays) the build material M. The material nozzle 1212 is physically connected to the material supply source 11, which is a supply source of the build material M, through a supply pipe 111 and a mix apparatus 112. The material nozzle 1212 supplies the build material M supplied from the material supply source 11 through the supply pipe 111 and the mix apparatus 112. The material nozzle 1212 may pressure-feed the build material M supplied from the material supply source 11 through the supply pipe 111. Namely, the build material M from the material supply source 11 and gas for feeding (namely, pressure-feed gas, and inert gas such as Nitrogen or Argon, for example) may be mixed by the mix apparatus 112 and then pressure-fed to the material nozzle 1212 through the supply pipe 111. As a result, the material nozzle 1212 supplies the build material M together with the gas for feeding. Purge gas supplied from the gas supply source 16 is used as the gas for feeding, for example. However, gas supplied from a gas supply source that is different from the gas supply source 16 may be used as the gas for feeding. The material nozzle 1212 supplies the build material M in a downward direction (namely, toward the -Z side) from the material nozzle 1212. The stage 131 is positioned below the material nozzle 1212. In a case where the workpiece W is placed on the stage 131, the material nozzle 1212 supplies the build material M toward the workpiece W or a vicinity of the workpiece W.

In the present example embodiment, the material nozzle 1212 supplies the build material M to an irradiation position of the processing light EL (namely, the target irradiation area EA that is irradiated with the processing light EL from the irradiation optical system 1211). Therefore, the material nozzle 1212 and the irradiation optical system 1211 are aligned so that a target supply area MA, which is set on the workpiece W or near the workpiece W as an area to which the material nozzle 1212 supplies the build material M, coincides with (alternatively, overlaps at least partially with) the target irradiation area EA. In this case, the build material M supplied from the material nozzle 1212 is irradiated with the processing light EL emitted from the irradiation optical system 1211. As a result, the build material M is molten. Namely, a melt pool MP including the molten build material M is formed on the workpiece W.

Note that the material nozzle 1212 may supply the build material M to the melt pool MP that is formed by the processing light EL emitted from the irradiation optical system 1211. For example, the processing apparatus 1 may melt the build material M by the irradiation optical system 1211 before the build material M from the material nozzle 1212 reaches the workpiece W and may make the molten build material M adhere to the workpiece W.

The head driving system 122 moves the processing head 121 under the control of the control apparatus 17. Namely, the head driving system 122 moves the irradiation optical system 1211 and the material nozzle 1212 under the control of the control apparatus 17. The head driving system 122 moves the processing head 121 along at least one of the X-axis, the Y-axis, the Z-axis, the θX direction, the θY direction, and the θZ direction, for example. When the head driving system 122 moves the processing head 121, a relative positional relationship between the processing head 121 and each of the stage 131 and the workpiece W placed on the stage 131 changes. As a result, the target irradiation area EA and the target supply area MA (furthermore, the melt pool MP) moves relative to the workpiece W.

The stage unit 13 includes the stage 131 and a stage driving system 132.

The workpiece W is placed on the stage 131. The stage 131 is configured to support the workpiece W placed on the stage 131. The stage 131 may be configured to hold the workpiece W placed on the stage 131. In this case, the stage 131 may include at least one of a mechanical chuck, an electrostatic chuck, and a vacuum suction chuck to hold the workpiece W. Alternatively, the stage 131 may not be configured to hold the workpiece W placed on the stage 131. In this case, the workpiece W may be placed on the stage 131 without clamp. Moreover, the workpiece W may be attached to a holding tool such as a jig, and the holding tool to which the workpiece W has been attached may be placed on, supported by, or held by the stage 131. Incidentally, the workpiece W may not be placed on the stage 131, and may be placed on a floor surface, for example.

The stage driving system 132 moves the stage 131 under the control of the control apparatus 17. For example, the stage driving system 132 moves the stage 131 along at least one of the X-axis, the Y-axis, the Z-axis, the θX direction, the θY direction and the θZ direction. When the stage driving system 132 moves the stage 131, the relative positional relationship between the processing head 121 and each of the stage 131 and the workpiece W placed on the stage 131 changes. As a result, the target irradiation area EA and the target supply area MA (furthermore, the melt pool MP) moves relative to the workpiece W.

The light source 15 emits at least one of infrared light, visible light, and ultraviolet light as the processing light EL, for example. However, other type of light may be used as the processing light EL. The processing light EL may include a plurality of pulsed lights (namely, a plurality of pulsed beams). The processing light EL may include continuous light (CW: Continuous Wave). The processing light EL may be a laser light. In this case, the light source 15 may include a semiconductor laser such as a laser light source (for example, a Laser Diode (LD)). The laser light source may include at least one of a fiber laser, a CO2 laser, a YAG laser, an Excimer laser, and the like. However, the processing light EL may not be the laser light. The light source 15 may include any light source (for example, at least one of a LED (Light Emitting Diode), a discharge lamp and the like).

The gas supply source 16 is a supply source of the purge gas for purging the chamber space 183IN in the housing 18. The purge gas includes inert gas. At least one of Nitrogen gas and Argon gas is one example of the inert gas. The gas supply source 16 is connected to the chamber space 183IN through a supply port 182 formed in a wall member 181 of the housing 18 and a supply pipe 161 connecting the gas supply source 16 to the supply port 182. The gas supply source 16 supplies the purge gas to the chamber space 183IN through the supply pipe 161 and the supply port 182. As a result, the chamber space 183IN becomes a space purged by the purge gas. The purge gas supplied to the chamber space 183IN may be discharged from a non-illustrated outlet port formed in the wall member 181. Note that the gas supply source 16 may be a tank that stores the inert gas. In a case where the purge gas is the Nitrogen gas, the gas supply source 16 may be a Nitrogen gas generation apparatus that generates the Nitrogen gas by using air as material.

In a case where the material nozzle 1212 supplies the build material M together with the purge gas as described above, the gas supply source 16 may supply the purge gas to the mix apparatus 112 to which the build material M is supplied from the material supply source 11. Specifically, the gas supply source 16 may be connected to the mix apparatus 112 through a supply pipe 162 that connects the gas supply source 16 and the mix apparatus 112. As a result, the gas supply source 16 supplies the purge gas to the mix apparatus 112 through the supply pipe 162. In this case, the build material M from the material supply source 11 may be supplied (specifically, pressure-fed) to the material nozzle 1212 through the supply pipe 111 by the purge gas supplied from the gas supply source 16 through the supply pipe 162. Namely, the gas supply source 16 may be connected to the material nozzle 1212 through the supply pipe 162, the mix apparatus 112 and the supply pipe 111. In this case, the material nozzle 1212 supplies the build material M together with the purge gas for pressure-feeding the build material M.

The control apparatus 17 controls an operation of the processing apparatus 1. For example, the control apparatus 17 may control the processing unit 12 (for example, at least one of the processing head 121 and the head driving system 122) of the processing apparatus 1 to process the workpiece W. For example, the control apparatus 17 may control the stage unit 13 (for example, stage driving system 132) of the processing apparatus 1 to process workpiece W.

The control apparatus 17 may include a processor and a storage apparatus. The processor may include at least one of a CPU (Central Processing unit) and a GPU (Graphic Processing unit), for example. The storage apparatus may include a memory. The control apparatus 17 serves as an apparatus for controlling the operation of the processing apparatus 1 by means of the processor executing a computer program. The computer program is a computer program that allows the processor to execute (namely, to perform) a below-described operation that should be executed by the control apparatus 17. Namely, the computer program is a computer program that allows the control apparatus 17 to function so as to make the processing apparatus 1 execute the below-described operation. The computer program executed by the processor may be recorded in the storage apparatus (namely, a recording medium) of the control apparatus 17, or may be recorded in any recording medium (for example, a hard disk or a semiconductor memory) that is built in the control apparatus 17 or that is attachable to the control apparatus 17. Alternatively, the processor may download the computer program that should be executed from an apparatus positioned at an outside of the control apparatus 17 through a network interface.

The control apparatus 17 may control an emitting aspect of the processing light EL by the irradiation optical system 1211. The emitting aspect may include at least one of an intensity of the processing light EL and an emitting timing of the processing light EL, for example. In a case where the processing light EL includes the plurality of pulsed lights, the emitting aspect may include at least one of an ON time of the pulsed light, an emission cycle of the pulsed light and a ratio (what we call a duty ratio) of a length of the ON time of the pulsed light and a length of the emission cycle of the pulsed light, for example. Furthermore, the control apparatus 17 may control a movement aspect of the processing head 121 by the head driving system 122. The control apparatus 17 may control a movement aspect of the stage 131 by the stage driving system 132. The movement aspect may include at least one of a movement distance, a movement speed, a movement direction, and a movement timing (a movement period), for example. Moreover, the control apparatus 17 may control a supply aspect of the build material M by the material nozzle 1212. The supply aspect may include at least one of a supplied amount (especially, a supplied amount per unit time) and a supply timing (a supply period).

The control apparatus 17 may not be positioned in the processing apparatus 1. For example, the control apparatus 17 may be positioned at the outside of the processing apparatus 1 as a server or the like. In this case, the control apparatus 17 may be connected to the processing apparatus 1 through a wired and / or wireless network (alternatively, a data bus and / or a communication line). A network using a serial-bus-type interface such as at least one of IEEE1394, RS-232x, RS-422, RS-423, RS-485, and USB may be used as the wired network. A network using a parallel-bus-type interface may be used as the wired network. A network using an interface that is compatible to Ethernet such as at least one of 10-BASE-T, 100BASE-TX or 1000BASE-T may be used as the wired network. A network using an electrical wave may be used as the wireless network. A network that is compatible to IEEE802.1x (for example, at least one of a wireless LAN and Bluetooth (registered trademark)) is one example of the network using the electrical wave. A network using an infrared ray may be used as the wireless network. A network using an optical communication may be used as the wireless network. In this case, the control apparatus 17 and the processing apparatus 1 may be configured to transmit and receive various information through the network. Moreover, the control apparatus 17 may be configured to transmit information such as a command and a control parameter to the processing apparatus 1 through the network. The processing apparatus 1 may include a reception apparatus that is configured to receive the information such as the command and the control parameter from the control apparatus 17 through the network. The processing apparatus 1 may include a transmission apparatus that is configured to transmit the information such as the command and the control parameter to the control apparatus 17 through the network (namely, an output apparatus that is configured to output information to the control apparatus 17). Alternatively, a first control apparatus that is configured to perform a part of the arithmetic processing performed by the control apparatus 17 may be positioned in the processing apparatus 1 and a second control apparatus that is configured to perform another part of the arithmetic processing performed by the control apparatus 17 may be positioned at the outside of the processing apparatus 1.

An arithmetic model that is buildable by machine learning may be implemented in the control apparatus 17 by the processor executing the computer program. One example of the arithmetic model that is buildable by the machine learning is an arithmetic model including a neural network (so-called Artificial Intelligence (AI)), for example. In this case, the learning of the arithmetic model may include learning of parameters of the neural network (for example, at least one of weights and biases). The control apparatus 17 may control the operation of the processing apparatus 1 by using the arithmetic model. Namely, the operation for controlling the operation of the processing apparatus 1 may include an operation for controlling the operation of the processing apparatus 1 by using the arithmetic model. Note that the arithmetic model that has been built by off-line machine learning using training data may be implemented in the control apparatus 17. Moreover, the arithmetic model implemented in the control apparatus 17 may be updated by online machine learning on the control apparatus 17. Alternatively, the control apparatus 17 may control the operation of the processing apparatus 1 by using the arithmetic model implemented in an apparatus that is positioned at an outside of the control apparatus 17 (namely, an apparatus that is positioned at an outside of the processing apparatus 1), in addition to or instead of the arithmetic model implemented on the control apparatus 17.

Note that at least one of an optical disc such as a CD-ROM, a CD-R, a CD-RW, a flexible disc, a MO, a DVD-ROM, a DVD-RAM, a DVD-R, a DVD+R, a DVD-RW, a DVD+RW and a Blu-ray (registered trademark), a magnetic disc such as a magnetic tape, an optical-magnetic disc, a semiconductor memory such as a USB memory, and another medium that is configured to store the program may be used as the recording medium recording therein the computer program that should be executed by the control apparatus 17. The recording medium may include a device that is configured to record the computer program (for example, a device for a universal use or a device for an exclusive use in which the computer program is embedded to be executable in a form of at least one of a software, a firmware, and the like). Moreover, various arithmetic processing or functions included in the computer program may be realized by a logical processing block that is realized in the control apparatus 17 by means of the control apparatus 17 (namely, a computer) executing the computer program, may be realized by a hardware such as a predetermined gate array (a FPGA, an ASIC) of the control apparatus 17, or may be realized in a form in which the logical process block and a partial hardware module that realizes a partial element of the hardware are combined.

### (1-3) Configuration of Measurement System 2

Next, with reference to FIG. 4, a configuration of the measurement system 2 will be described. FIG. 4 is a block diagram that illustrates the configuration of the measurement system 2. As illustrated in FIG. 4, the measurement system 2 includes a shape measurement apparatus 21 and a control information generation apparatus 22. Incidentally, the shape measurement apparatus 21 and the control information generation apparatus 22 may operate under control of the control apparatus 17. The control apparatus 17 illustrated in FIG. 4 may be a different apparatus from the control apparatus 17 of the processing system SYS illustrated in FIG. 2. Even if the control apparatus 17 illustrated in FIG. 4 is a different apparatus from the control apparatus 17 illustrated in FIG. 2, the configuration of the control apparatus 17 illustrated in FIG. 4 may be the same as that of the control apparatus 17 illustrated in FIG. 2.

The shape measurement apparatus 21 is configured to measure a three-dimensional shape of a measurement target object. In the present example embodiment, the measurement system 2 measures the workpiece W before the processing apparatus 1 actually starts processing the workpiece W, as described above. Therefore, the measurement target object of the shape measurement apparatus 21 may include the workpiece W. Incidentally, the measurement apparatus 2 may measure a holding tool that actually holds the workpiece W before the processing apparatus 1 actually begins processing the workpiece W. Therefore, the measurement target object of the shape measurement apparatus 21 may include the holding tool that actually holds the workpiece W. In other words, the measurement target object of the shape measurement apparatus 21 may include both the holding tool that actually holds the workpiece W and the workpiece W held by that holding tool.

The shape measurement apparatus 21 may have any configuration as long as it is configured to measure the three-dimensional shape of the measurement target object. For example, the shape measurement apparatus 21 may measure the three-dimensional shape of the measurement target object by using a pattern projection method or a light section method that projects a light pattern on a surface of the measurement target object by irradiating the surface with measurement light and measures a shape of the projected pattern. For example, the shape measurement apparatus 21 may measure the three-dimensional shape of the measurement target object by using a time of flight method that performs an operation, which emits measurement light to the surface of the measurement target object, calculates a time until the emitted measurement light returns from the measurement target object to the shape measurement apparatus 21, and measures a distance to the measurement target object based on the time, at plurality of positions on the measurement target object. For example, the shape measurement apparatus 21 may measure the three-dimensional shape of the measurement target object by using at least one of a moiré topography method (specifically, a grid irradiation method or a grid projection method), a holography interference method, an auto collimation method, a stereo method, an astigmatism method, a critical angle method, and a knife edge method. In this way, the shape measurement apparatus 21 may perform optical shape measurement of the measurement target object or may perform non-contact measurement of the measurement target object.

Incidentally, the shape measurement apparatus 21 is not limited to an apparatus that measures the three-dimensional shape of the measurement target object contained in its housing. For example, the shape measurement apparatus 21 may be attached to a robot arm so as to be movable around the measurement target object.

An example of configuration of the shape measurement apparatus 21 is illustrated in FIG. 4. As illustrated in FIG. 4, the shape measurement apparatus 21 is provided with a shape measurement head 211, a head driving system 212, a stage 213, and a stage driving system 214. However, the shape measurement apparatus 21 need not necessarily include at least one of the head driving system 212 and the stage driving system 214.

The shape measurement head 211 is a measurement apparatus configured to measure a three-dimensional shape of a measurement target object. For example, the shape measurement head 211 may measure the three-dimensional shape of the measurement target object using at least one of the following methods: a pattern projection method, an optical sectioning method, a time-of-flight method, a moiré topography method (specifically, a grid illumination method or a grid projection method), a holographic interference method, an autocollimation method, a stereo method, a astigmatism method, a critical angle method, and a knife-edge method.

The head driving system 212 moves the shape measurement head 211. The head driving system 212 moves the shape measurement head 211 along at least one of the X-axis, the Y-axis, the Z-axis, the θX direction, the θY direction, and the θZ direction in the measurement coordinate system of the measurement system 2. When the head driving system 212 moves the shape measurement head 211, the positional relationship between a measurement range of the shape measurement head 211 and the measurement target object changes. As a result, the shape measurement head 211 becomes more likely to be able to measure the three-dimensional shape of a part of the measurement target object that it could not measure before moving. That is, the blind spot of the shape measurement head 211 becomes narrower or disappears.

The measurement target object is placed on the stage 213. The stage 213 can support the workpiece W placed on the stage 131. The stage 213 may also be capable of holding the workpiece W placed on the stage 213. In this case, stage 213 may be provided with at least one of a mechanical chuck, an electrostatic chuck, and a vacuum suction chuck to hold workpiece W. Alternatively, stage 213 may not be capable of holding workpiece W placed on stage 213. In this case, workpiece W may be placed on stage 213 clamp-free.

The stage driving system 214 moves the stage 213. The stage driving system 214 moves the stage 213 along at least one of the X-axis, the Y-axis, the Z-axis, the θX direction, the θY direction, and the θZ direction in the measurement coordinate system of the measurement system 2. When the stage driving system 214 moves the stage 213, the positional relationship between the measurement range of the shape measurement head 211 and the measurement target object placed on the stage 213 changes. As a result, similar to when the shape measurement head 211 moves, the blind spot of the shape measurement head 211 narrows or disappears.

The control information generation apparatus 22 generates processing control information. FIG. 5 illustrates one example of a configuration of the control information generation apparatus 22 that is configured to generate the processing control information. As illustrated in FIG. 5, the control information generation apparatus 22 includes a processor 221, a storage apparatus 222, and a communication apparatus 223. Furthermore, the control information generation apparatus 22 may include an input apparatus 224 and an output apparatus 225. However, the control information generation apparatus 22 may not include at least one of the input apparatus 224 and the output apparatus 225. The processor 221, the storage apparatus 222, the communication apparatus 223, the input apparatus 224, and the output apparatus 225 may be connected through a data bus 326.

The processor 221 may include at least one of a CPU and a GPU, for example. The processor 221 read a computer program. For example, the processor 221 may read the computer program recorded in the storage apparatus 222. For example, the processor 221 may read the computer program recorded in a non-transitory computer-readable recording medium by using a non-illustrated recording medium reading apparatus. The processor 221 may acquire (namely, download or read) the computer program from a non-illustrated apparatus that is positioned at an outside of the control information generation apparatus 22 through the communication apparatus 223. Namely, the processor 221 may acquire (namely, download or read) the computer program recorded in a storage apparatus of the non-illustrated apparatus that is positioned at an outside of the control information generation apparatus 22 through the communication apparatus 223. The processor 221 executes the read computer program. As a result, a logical functional block for performing an operation that should be performed by the control information generation apparatus 22 (for example, an operation for generating the processing control information) is implemented in the processor 221. Namely, the processor 221 is configured to serve as a controller for implementing the logical functional block for performing the operation that should be performed by the control information generation apparatus 22. In this case, any apparatus (typically, a computer) that executes the computer program may serve as the control information generation apparatus 22.

FIG. 5 illustrates one example of the logical functional block implemented in the processor 221. As illustrated in FIG. 5, a control information generation unit 2211 is implemented in the processor 221. The control information generation unit 2211 generates the processing control information. Incidentally, an operation for generating the processing control information will be described in detail later.

An arithmetic model that is buildable by machine learning may be implemented in the processor 221 by the processor executing the computer program. One example of the arithmetic model that is buildable by the machine learning is an arithmetic model including a neural network (so-called Artificial Intelligence (AI)), for example. In this case, the learning of the arithmetic model may include learning of parameters of the neural network (for example, at least one of weights and biases). The processor 221 may generate the processing control information by using the arithmetic model. Note that the arithmetic model that has been built by off-line machine learning using training data may be implemented in the processor 221. Moreover, the arithmetic model implemented in the processor 221 may be updated by online machine learning on the processor 221. Alternatively, the processor 221 may control the operation of the processing apparatus 1 by using the arithmetic model implemented in an apparatus that is positioned at an outside of the processor 221 (namely, an apparatus that is positioned at an outside of the control information generation apparatus 22), in addition to or instead of the arithmetic model implemented on the processor 221.

The storage apparatus 222 is configured to store desired data. For example, the storage apparatus 222 may temporarily store the computer program that is executed by the processor 221. The storage apparatus 222 may temporarily store data temporarily used by the processor 221 when the processor 221 executes the computer program. The storage apparatus 222 may store data stored for a long term by the control information generation apparatus 22. Incidentally, the storage apparatus 222 may include at least one of a RAM (Random Access Memory), a ROM (Read Only Memory), a hard disk apparatus, a magneto-optical disc, a SSD (Solid State Drive), and a disk array apparatus. Namely, the storage apparatus 222 may include a non-transitory recording medium.

The communication apparatus 223 is configured to communicate with the processing apparatus 1 through a non-illustrated communication network. In the present example embodiment, the communication apparatus 223 is configured to transmit the processing control information generated by the control information generation apparatus 22 to the processing apparatus 1.

The input apparatus 224 is an apparatus that receives an input of information from an outside of the control information generation apparatus 22 to the control information generation apparatus 22. For example, the input apparatus 224 may include an operating apparatus (for example, at least one of a keyboard, a mouse, and a touch panel) that is operable by a user. For example, the input apparatus 224 may include a reading apparatus that is configured to read information recorded as data on a recording medium that is attachable to the control information generation apparatus 22. For example, the input apparatus 224 may receive the input of the information from a robot that is positioned at an outside of the control information generation apparatus 22. For example, the input apparatus 224 may receive the input of the information from a computer that is positioned at an outside of the control information generation apparatus 22.

The output apparatus 225 is an apparatus that outputs information to the outside of the control information generation apparatus 22. For example, the output apparatus 225 may output the information as an image. Namely, the output apparatus 225 may include a display apparatus (a so-called display) that is configured to display an image indicating the information that should be output. For example, the output apparatus 225 may output the information as audio. Namely, the output apparatus 225 may include an audio apparatus (so-called a speaker) that is configured output the audio. For example, the output apparatus 225 may output the information on a paper. Namely, the output apparatus 225 may include a printing apparatus (so-called a printer) that is configured to print desired information on the paper.

The output apparatus 225 may be attached to a robot. In this case, the robot to which the output apparatus 225 is attached may output the information to the outside of the control information generation apparatus 22. For example, the robot to which the output apparatus 225 is attached may output the information as the image.

### (2) Operation of Processing System SYS

Next, an operation performed by the processing system SYS will be described. In the present example embodiment, the processing system SYS may perform a processing operation for processing the workpiece W by mainly using the processing apparatus 1. Furthermore, the processing system SYS may perform a control information generation operation for generating the processing control information by mainly using the measurement system 2. Therefore, in the below-described description, the processing operation and the control information generation operation will be described in sequence.

### (2-1) Processing Operation

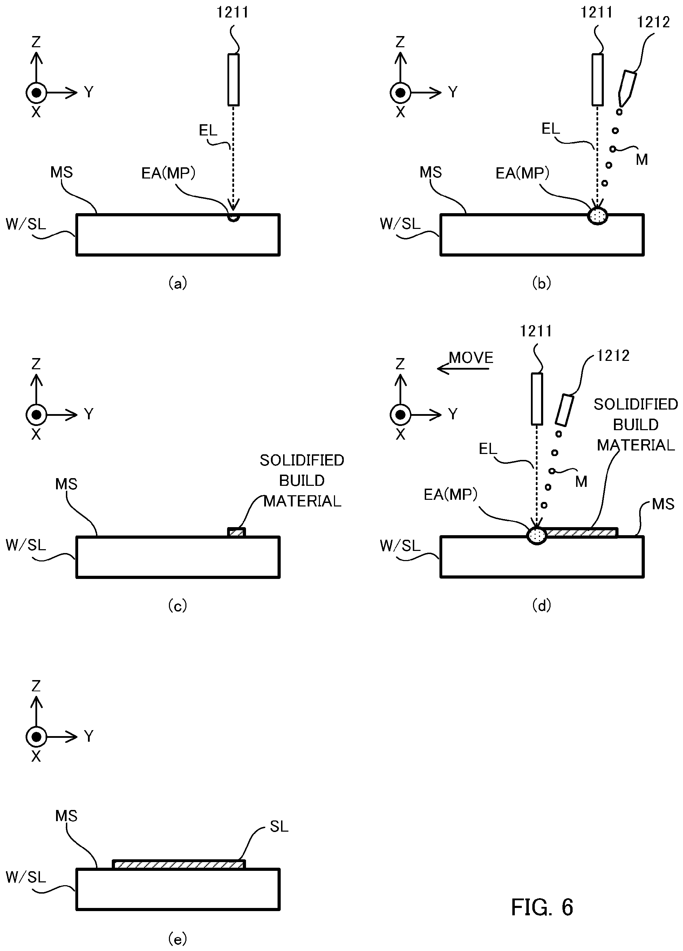

First, with reference to FIG. 6 and FIG. 7, the processing operation will be described. Especially, an additive manufacturing operation performed by the processing apparatus 1 will be described as one example of the processing operation. As described above, the processing apparatus 1 builds the three-dimensional structural object ST by using the Laser Metal Deposition. Therefore, the processing apparatus 1 may build the three-dimensional structural object ST by performing an existing additive manufacturing operation based on the Laser Metal Deposition. In the below-described description, one example of the processing operation of building the three-dimensional structural object ST by using the Laser Metal Deposition will be briefly described.

The processing apparatus 1 sequentially builds a plurality of layered partial structural objects (it is referred to as the "structural layer" in the below described description) SL that are arranged along the Z-axis direction in order to build the three-dimensional structural object ST, for example. For example, the processing apparatus 1 builds, one by one in sequence, the plurality of structural layers SL that are generated by slicing the three-dimensional structural object ST along the Z-axis direction. As a result, the three-dimensional structural object ST that is a layered structural body in which the plurality of structural layers SL are stacked is built. Next, a flow of an operation for building the three-dimensional structural object ST by building the plurality of structural layers SL one by one in sequence will be described.

First, with reference to FIG. 6(a) to FIG. 6(e), an operation for building each structural layer SL will be described. The processing apparatus 1 moves at least one of the processing head 121 and the stage 131 so that the target irradiation area EA is set at a desired area on the build surface MS that corresponds to a surface of the workpiece W or a surface of the built structural layer SL, under the control of the control apparatus 17. Then, the processing system SYS emits the processing light EL from the irradiation optical system 1211 to the target irradiation area EA. In this case, a condensed plane on which the processing light EL is condensed in the Z-axis direction may be positioned on the build surface MS. Alternatively, the condensed position may be away from the build surface MS.

As a result, as illustrated in FIG. 6(a), the melt pool (namely, a pool of a metal molten by the processing light EL) MP is formed on the build surface MS that is irradiated with the processing light EL. Moreover, the processing apparatus 1 supplies the build material M from the material nozzle 1212 under the control of the control apparatus 17. As a result, the build material M is supplied to the melt pool MP. The build material M supplied to the melt pool MP are molten by the processing light EL with which the melt pool MP is irradiated. Alternatively, the build material M supplied from the material nozzle 1212 may be molten by the processing light EL before reaching the melt pool MP, and the molten build material M may be supplied to the melt pool MP. Then, when the melt pool MP is no longer irradiated with the processing light EL due to the movement of at least one of the processing head 121 and the stage 131, the build material M molten in the melt pool MP is cooled and solidified (namely, coagulated). As a result, as illustrated in FIG. 6(c), the build object including the solidified build material M is deposited on the build surface MS.

The processing apparatus 1 repeats a series of build process including the formation of the melt pool MP by the irradiation of the processing light EL, the supply of the build material M to the melt pool MP, the melting of the supplied build material M and the solidification of the molten build material M while relatively moving the processing head 121 relative to the build surface MS along at least one of the X-axis direction and the Y-axis direction, as illustrated in FIG. 6(d). In this case, the processing apparatus 1 irradiates an area in which the build object should be built on the build surface MS with the processing light EL, but does not irradiate an area in which the build object should not be built on the build surface MS with the processing light EL. Namely, the processing apparatus 1 irradiates the build surface MS with the processing light EL at a timing based on an aspect of a distribution of the area in which the build object should be built, while moving the target irradiation area EA along a predetermined movement path on the build surface MS.

The movement path of the target irradiation area EA on the build surface MS may be referred to as a processing path (in other words, a tool path). The above-described processing control information includes information related to this processing path as processing path information. Therefore, the control information generation apparatus 22 may generate the processing control information including the processing path information. The processing apparatus 1 irradiates the build surface MS with the processing light EL at the timing based on the aspect of the distribution of the area in which the build object should be built, while moving the target irradiation area EA along the predetermined movement path on the build surface MS based on the processing control information. Incidentally, the processing path (tool path) may also be a movement path of the target supply area MA. The processing apparatus 1 may move the target supply area MA along a predetermined movement path on the molding surface MS based on the processing control information. At this time, the build material M may be supplied to the melt pool MP or the processing light EL at timings corresponding to the distribution pattern of the areas where the build object is to be built, or the build material M may be continuously supplied throughout the movement of the target supply area MA. Wherein, the movement path of the target supply area MA may be the same as or different from the movement path of the target irradiation area EA.

As a result, the melt pool MP also moves on the build surface MS along a movement path based on the movement path of the target irradiation area EA. Specifically, the melt pool MP is formed in sequence at a part that is irradiated with the processing light EL in the area along the movement path of the target irradiation area EA on the build surface MS. As a result, as illustrated in FIG. 6(e), the structural layer SL corresponding to the build object that is an aggregation of the build material M, which is solidified after being molten, is built on the build surface MS. Namely, the structural layer SL corresponding to an aggregation of the build object built in a pattern based on the movement path of the melt pool MP on the build surface MS (namely, the structural layer SL having a shape based on the movement path of the melt pool MP in a planar view) is built. Incidentally, when the target irradiation area EA is set at the area in which the build object should not be built, the processing apparatus 1 may irradiate the target irradiation area EA with the processing light EL and stop the supply of the build material M. Moreover, when the target irradiation area EA is set at the area in which the build object should not be built, the processing apparatus 1 may supply the build material M to the target irradiation area EA and irradiate the target irradiation area EA with the processing light EL having an intensity by which the melt pool MP is not formed.

The processing apparatus 1 repeats the operation for forming the structural layer

SL based on the processing control information under the control of the control apparatus 17. Specifically, the processing apparatus 1 first performs an operation for building the first structural layer SL#1 on the build surface MS corresponding to the surface of the workpiece W based on the processing control information (especially, information related to the processing path for building the structural layer SL#1). As a result, the structural layer SL#1 is built on the build surface MS, as illustrated in FIG. 7(a). Then, the processing apparatus 1 sets a surface (namely, an upper surface) of the structural layer SL#1 as a new build surface MS, and builds the second structural layer SL#2 on the new build surface MS. In order to build the structural layer SL#2, the control apparatus 17 first controls at least one of the head driving system 122 and the stage driving system 132 so that the processing head 121 moves along the Z-axis relative to the stage 131. Specifically, the control apparatus 17 controls at least one of the head driving system 122 and the stage driving system 132 to move the processing head 121 toward the +Z side and / or to move the stage 131 toward the -Z side so that the target irradiation area EA is set on the surface of the structural layer SL#1 (namely, the new build surface MS). Then, the processing apparatus 1 builds the structural layer SL#2 on the structural layer SL#1 by an operation that is the same as the operation for building the structural layer SL#1 based on the processing control information (especially, information related to the processing path corresponding to the structural layer SL#2) under the control of the control apparatus 17. As a result, the structural layer SL#2 is built as illustrated in FIG. 7(b). Then, the same operation is repeated until all of the structural layers SL that constitute the three-dimensional structural object ST to be built on the workpiece W are built. As a result, as illustrated in FIG. 7(c), the three-dimensional structural object ST is built by the layered structural body in which the plurality of structural layers SL are stacked.

### (2-2) Control Information Generation Operation

Next, the control information generation operation will be described.

### (2-2-1) Overview of Control Information Generation Operation

As described above, the measurement system 2 (especially, the control information generation unit 2211 of the control information generation apparatus 22) generates the processing control information by performing the control information generation operation.

The control information generation unit 2211 may generate the processing control information based on object information indicating an actual three-dimensional shape of an object that is the workpiece W which the processing apparatus 1 expected to process.

Measurement information indicating a measured result of the three-dimensional shape of the workpiece W by the shape measurement apparatus 21 is one example of the object information. In this case, in order to generate the processing control information, the shape measurement apparatus 21 may measure the three-dimensional shape of the workpiece W, and the control information generation unit 2211 may generate the processing control information based on the measurement information. In a case where the processing apparatus 1 processes a plurality of workpieces W, the shape measurement apparatus 21 may measure the three-dimensional shape of each of the plurality of workpieces W collectively or sequentially, and the control information generation unit 2211 may sequentially generate a plurality of processing control information, which are used to process the plurality of workpieces W, respectively, based on the measurement information of the plurality of workpieces W.

However, in a case where the processing apparatus 1 processes the plurality of workpieces W which are expected to have the same characteristic (for example, shape), the shape measurement apparatus 21 may not measure the three-dimensional shapes of all of the plurality of workpieces W in order to generate the processing control information. For example, the shape measurement apparatus 21 may measure the three-dimensional shape of one workpiece W of the plurality of workpieces W, but may not measure the three-dimensional shape of the other workpiece W of the plurality of workpieces W. In this case, the control information generation unit 2211 may generate the processing control information, which is commonly used to process each of the plurality of workpieces W, based on the measurement information indicating the measured result of the three-dimensional shape of the one workpiece W.

A plurality of turbine blades attached to a rotor that is included in a turbine and that is rotatable around a rotation axis is examples of the plurality of workpieces W that are expected to have the same characteristic. Usually, the plurality of turbine blades that have the same characteristic are attached to the rotor. However, when the turbine is used, the turbine blades are worn due to a friction between fluid and the turbine blades. As a result, there is a possibility that the characteristics (especially, the shapes) of at least two of the plurality of turbine blades, which had the same characteristic before the turbine was used, are different from each other due to the use of the turbine. However, even in this case, there is a high possibility that worn amounts of the plurality of turbine blades are roughly the same. As a result, the characteristics of at least two of the plurality of turbine blades, which had the same characteristic before the turbine was used, are may be considered to be the same as each other, although they are strictly different from each other. Moreover, during repair of worn turbine blades, a part of a worn part of a turbine blade may be performed the removal processing so that shapes of the plurality of turbine blades that are items that need to be repaired become roughly the same. In these cases, the shape measurement apparatus 21 may measure the three-dimensional shape of one turbine blade of the plurality of worn turbine blades, but may not measure the three-dimensional shape of the other turbine blade of the plurality of worn turbine blades. The control information generation unit 2211 may generate the processing control information, which is commonly used to process (typically, repair) each of the plurality of worn turbine blades, based on the measurement information indicating the measured result of the three-dimensional shape of one turbine blade.

The object information may be any information as long as it directly or indirectly indicates the actual three-dimensional shape of the workpiece W. For example, the object information may be point-cloud information that indicates the actual three-dimensional shape of the workpiece W by using a plurality of points. In the present example embodiment, an example in which an object model OM is used as the object information will be described. In other words, in the present example embodiment, an example in which model information indicating the object model OM is used as the object information. The object model OM is a three-dimensional model that indicates the actual three-dimensional shape of the workpiece W. Namely, the object model OM is a three-dimensional model having the three-dimensional shape that is the same as the actual three-dimensional shape of the workpiece W. At least one of a wireframe model, a surface model, and a solid model is one example of the three-dimensional models. In the present example embodiment, an example in which a mesh model (typically, a polygonal mesh model, the same applies to the below-described description), which is one specific example of the surface model, is used as the object model OM will be described. The mesh model is a three-dimensional model that represents the three-dimensional shape of the object by using vertices, edges, and surfaces. The mesh model is a three-dimensional model that represents the three-dimensional shape of the object by using a plurality of meshes (in other words, facets, or computational grids) having polygonal shapes.

The object model OM may be generated based on the measurement information indicating the measured result of the three-dimensional shape of the workpiece W by the shape measurement apparatus 21. Namely, the object model OM may be generated based on the measured result of the three-dimensional shape of the workpiece W by the shape measurement apparatus 21. In this case, the control information generation unit 2211 may generate the object model OM based on the measurement information. Alternatively, an apparatus (for example, the shape measurement apparatus 21) that is different from the control information generation unit 2211 may generate the object model OM based on the measurement information.

Alternatively, the object model OM may be generated without using the measurement information indicating the measured result of the three-dimensional shape of the workpiece W by the shape measurement apparatus 21. For example, the control information generation unit 2211 (alternatively, an apparatus that is different from the control information generation unit 2211, the same applies to this paragraph) may estimate the actual three-dimensional shape of the workpiece W based on a factor that affects the three-dimensional shape of the workpiece W, and generate the object model OM based on an estimated result. Namely, the control information generation unit 2211 may generate, as the object model OM, the three-dimensional model that indicates the estimated three-dimensional shape. In this case, the control information generation unit 2211 may estimate the actual three-dimensional shape of the workpiece W by using an arithmetic model that is buildable by a machine learning (for example, an arithmetic model that includes a neural network (so-called artificial intelligence (AI))). Alternatively, the user of the processing system SYS may estimate the actual three-dimensional shape of the workpiece W based on the factor that affects the three-dimensional shape of the workpiece W, and generate the object model OM based on the estimated result. Namely, the user may generate, as the object model OM, the three-dimensional model that indicates the estimated three-dimensional shape. Alternatively, the control information generation unit 2211 may generate the object model OM based on the estimated result of the actual three-dimensional shape of the workpiece W by the user.

An environment in which the workpiece W is used is one example of the factor that affects the three-dimensional shape of the workpiece W. A force that is applied to the workpiece W in a situation where the workpiece W is used is another example of the factor that affects the three-dimensional shape of the workpiece W. A time period during which the workpiece W is used is another example of the factor that affects the three-dimensional shape of workpiece W. For example, in a case where the workpiece W is the above-described turbine blade, at least one of an environment in which the turbine blade is used, a force that is applied to the turbine blade, and a time period during which the turbine blade is used is one example of the factor that affects the three-dimensional shape of the turbine blade. In this case, the control information generation unit 2211, the apparatus that is different from the control information generation unit 2211, or the user may estimate the worn amount of the turbine blade (namely, the lost part of the turbine blade) based on the factor that affects the three-dimensional shape of the turbine blade, and may estimate the actual three-dimensional shape of the turbine blade based on the estimated worn amount.

The three-dimensional model indicated by a file indicating CAD (Computer Aided Design) data may be used as the object model OM. At least one of a file whose extension is DWF, a file whose extension is DXF, a file whose extension is DWG, and a file whose extension is STP is one example of the file indicating the CAD data. In a case where the mesh model is used as the object model OM, the three-dimensional model indicated by a file whose extension is STL may be used as the object model OM.

The control information generation unit 2211 may generate the processing control information based on reference information indicating a target shape of the workpiece W, in addition to or instead of the above-described object information. Namely, the control information generation unit 2211 may generate the processing control information based on the reference information indicating the designed, nominal, or ideal three-dimensional shape of the workpiece W.

The reference information may be any information as long as it directly or indirectly indicates the target shape of the workpiece W. For example, the reference information may be point-cloud information that indicates the target shape of the workpiece W by using a plurality of points. In the present example embodiment, an example in which a reference model RM is used as the reference information will be described. In other words, in the present example embodiment, an example in which model information indicating the reference model RM is used as the reference information will be described. The reference model RM is a three-dimensional model that indicates the target shape of the workpiece W. Namely, the reference model RM is a three-dimensional model having the three-dimensional shape that is the same as the target shape of the workpiece W. In the present example embodiment, an example in which the mesh model that is one specific example of the surface model is used as the reference model RM.

A CAD model of the workpiece W having the target shape may be used as the reference model RM. The three-dimensional model that is generated based on information acquired by actually measuring the three-dimensional shape of the workpiece W having the target shape may be used as the reference model RM. In this case, the three-dimensional model indicated by the file indicating the CAD data may be used as the reference model RM. At least one of a file whose extension is DWF, a file whose extension is DXF, a file whose extension is DWG, and a file whose extension is STP is one example of the file indicating the CAD data. In a case where the mesh model is used as the reference model RM, the three-dimensional model indicated by a file whose extension is STL may be used as the reference model RM.

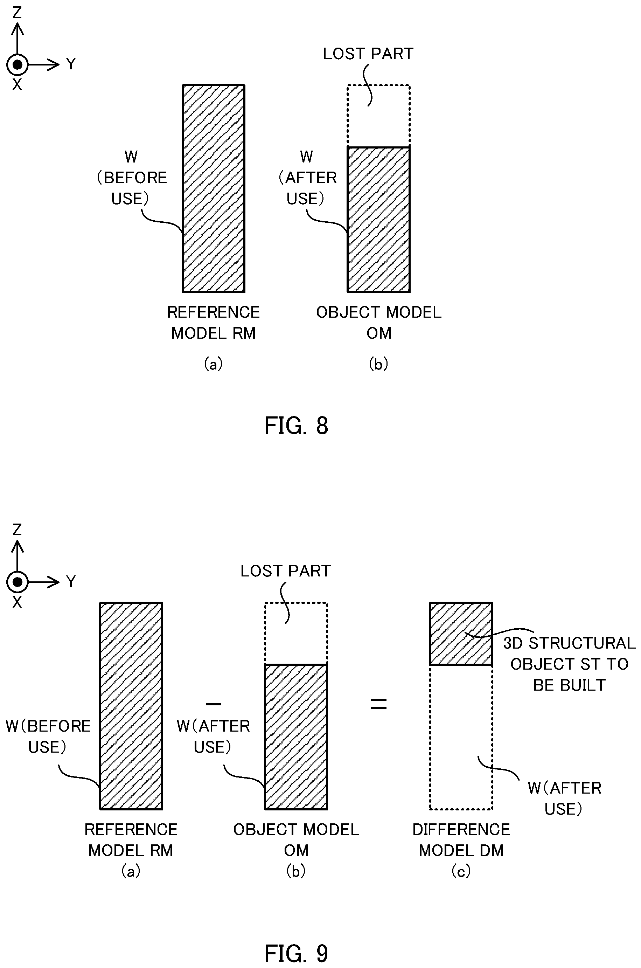

As illustrated in FIG. 8(a) and FIG. 8(b) that schematically illustrates the reference model RM and the object model OM, respectively, the target shape of the workpiece W (namely, the designed or ideal three-dimensional shape of the workpiece W) indicated by the reference model RM is typically different from the actual three-dimensional shape of the workpiece W indicated by the object model OM. For example, in a case where the item that needs to be repaired having the lost part is used as the workpiece W as described above, the object model OM indicates the three-dimensional shape of the workpiece W a part of which is lost due to the use as illustrated in FIG. 8(b), while the reference model RM indicates the three-dimensional shape of the workpiece W that is not lost as illustrated in FIG. 8(a). Namely, the object model OM indicates the three-dimensional shape of the workpiece W that has actually been used, while the reference model RM indicates the three-dimensional shape of the workpiece W before it is actually used. As one example, in a case where the workpiece W is the turbine blade a part of which is worn, the object model OM indicates the three-dimensional shape of the turbine blade a part of which is worn, while the reference model RM indicates the three-dimensional shape of the turbine blade that is not worn. Namely, the object information indicates the three-dimensional shape of the turbine blade after the turbine blade has actually been used as the component of the turbine, while the reference information indicates the three-dimensional shape of the turbine blade before the turbine blade is used as the component of the turbine. In other words, the object information indicates the three-dimensional shape of the used turbine blade, while the reference information indicates the three-dimensional shape of the unused turbine blade. Therefore, in a case where a part of the workpiece W is lost (for example, worn) due to the use of the workpiece W, the target shape of the workpiece W indicated by the reference model RM is usually different from the actual three-dimensional shape of the workpiece W indicated by the object model OM. Incidentally, the reference model RM may be referred to as a target model, because the reference model RM indicates the target shape of the workpiece W.

Incidentally, "the use of the workpiece W" in the present example embodiment may include using the workpiece W in a way that is appropriate for an intended use of the workpiece W. In a case where the workpiece W is used as a component of a product, "the use of the workpiece W" may include using the product including the workpiece W in a way that is appropriate for an intended use of the product. For example, in a case where the workpiece W includes the turbine blade, the use of the turbine blade may include using the turbine including the turbine blade in a way that is appropriate for an intended use of the turbine.

Moreover, considering that the above-described situation where a part of the workpiece W is lost (for example, worn) due to the user of the workpiece W is one example of a situation where the processing system SYS in the present example embodiment is used, "the use of the workpiece W" may include a use of the workpiece W that causes a loss of a part of the workpiece W. For example, "the use of the workpiece W" may include a use of the workpiece W over a long time period that causes the loss of a part of the workpiece W. Therefore, the actually used the workpiece W may include the workpiece W that has been used to the extent that a part of the workpiece W is lost. On the other hand, the workpiece W before it is actually used may include the workpiece W that has not been used to the extent that a part of the workpiece W is lost although it has been used. For example, the unuse workpiece W may include the use of the workpiece W over a short time period (for example, a trial operation of the workpiece W or the product including the workpiece W) that does not cause the loss of a part of the workpiece W. Of course, the workpiece W before it is actually used may literally include the workpiece W that has not yet been used. For example, the workpiece W before it is actually used may include the workpiece W before it is shipped as the product or the component. For example, the workpiece W before it is actually used may include the workpiece W in a design stage.

The reference model RM may be generated based on the measured result of the three-dimensional shape of the workpiece W before it is actually used. In this case, the shape measurement apparatus 21 (alternatively, an apparatus that is different from the shape measurement apparatus 21, the same applies to this paragraph) may measure the three-dimensional shape of the workpiece W before it is actually used, and the reference model RM may be generated based on the measured result by the shape measurement apparatus 21. Alternatively, the reference model RM may be generated based on the CAD data indicates the designed three-dimensional shape of the workpiece W.

In the present example embodiment, the control information generation unit 2211 generates the processing control information based on both the object model OM, which is one example of the object information, and the reference model RM, which is one example of the reference information. Specifically, as described above, the reference model RM indicates the target shape of the workpiece W, and the object model OM indicates the actual three-dimensional shape of the workpiece W. In this case, a difference between the reference model RM and the object model OM corresponds to a three-dimensional model that indicates the three-dimensional shape of the build object (namely, the three-dimensional structural object ST) that should be built by the processing apparatus 1 performing the additive manufacturing. Therefore, the control information generation unit 2211 may generate the three-dimensional model corresponding to the difference between the reference model RM and the object model OM as a difference model DM that indicates the three-dimensional shape of the three-dimensional structural object ST that should be built by the processing apparatus 1 performing additive manufacturing. The difference model DM is typically the three-dimensional model that corresponds to a part of the reference model RM. Incidentally, FIG. 9(a) schematically illustrates the reference model RM, FIG. 9(b) schematically illustrates the object model OM, and FIG. 9(c) schematically illustrates the difference model DM that is generated based on the reference model RM illustrated in FIG. 9(a) and the object model OM illustrated in FIG. 9(b). Then, the control information generation unit 2211 may generate the processing control information based on the difference model DM. For example, the control information generation unit 2211 may generate a plurality of slice data, which correspond to the plurality of structural layers SL included in the three-dimensional structural object ST, respectively, by performing a slicing process for dividing the difference model DM into a plurality of layered models with a layered pitch corresponding to a thickness of the structural layer SL. Then, the control information generation unit 2211 may generate the plurality of pieces of processing control information, which are used to build the plurality of structural layers SL, respectively, based on the plurality of slice data.

The three-dimensional model indicated by a file indicating CAD data may be used as the difference model DM. At least one of a file whose extension is DWF, a file whose extension is DXF, a file whose extension is DWG, and a file whose extension is STP is one example of the file indicating the CAD data. In a case where the mesh model is used as the difference model DM, the three-dimensional model indicated by a file whose extension is STL may be used as the difference model DM.

A file (for example, a CAD file that indicates the CAD data, the same applies to this paragraph) may include assembly information. Wherein, the "assembly information" may be mean information for associating data relating to a plurality of parts with each other. For example, the file may include assembly information associating information relating to the difference model DM with information relating to the object model OM. The file may include assembly information associating information relating to the difference model DM, information relating to the object model OM and information relating to the reference model RM to each other. In this case, the object model OM and the difference model DM, or the object model OM, the difference model DM and the reference model RM may be included in the file in an information format of assembly information. The file may include a first object model OM acquired by measuring the workpiece W with a first measurement accuracy and a second object model OM acquired by measuring the workpiece W with a second measurement accuracy that is higher than the first measurement accuracy. In this case, the file may include information related to the measurement accuracy that is used to acquire the object model OM. For example, the first object model OM may be associated with information related to the measurement accuracy that is used to acquire the first object model OM in the file. For example, the second object model OM may be associated with information related to the measurement accuracy that is used to acquire the second object model OM in the file.

Alternatively, the file (for example, the CAD file indicating the CAD data, the same applies to this paragraph) may include at least one of the object model OM, the reference model RM, and the difference model DM in an information format that is different from an information format of the assembly information. Alternatively, at least one of a file including the object model OM, a file including the reference model RM, and a file including the difference model DM may be stored in the storage apparatus 222 or the like. Namely, the object model OM, the reference model RM, and the difference model DM may be included in separate files, respectively. In this case, a management file that includes information indicating that at least two of the file including the object model OM, the file including the reference model RM, and the file including the difference model DM are associated with each other may be stored in the storage apparatus 222 or the like.

However, the control information generation unit 2211 may generate the processing control information by using the object model OM but without using the reference model RM. The control information generation unit 2211 may generate the processing control information by using the reference model RM but without using the object model OM.

### (2-2-2) Technical Issues occurred in a case where Processing Control Information is generated

As described above, a part of the workpiece W is lost due to the use of the workpiece W. On the other hand, there is a possibility that at least a part of the workpiece W is physically deformed due to the use of the workpiece W, in addition to or instead of a part of the workpiece W being lost. For example, there is a possibility that the workpiece W is physically deformed due to a load applied to the workpiece W that is used in a high-temperature environment. Namely, there is a possibility that a creep occurs. For example, there is a possibility that the workpiece W is physically deformed due to an aging or other factors.

In a case where the workpiece W is deformed, "the use of the workpiece W" may include a use of the workpiece W that causes a deformation of the workpiece W. For example, "the use of the workpiece W" may include a use of the workpiece W over a long time period that causes the deformation of the workpiece W. Therefore, the actually used the workpiece W may include the workpiece W that has been used to the extent that the workpiece W is deformed. On the other hand, the workpiece W before it is actually used may include the workpiece W that has not been used to the extent that the workpiece W is deformed although it has been used. For example, the unuse workpiece W may include the use of the workpiece W over a short time period (for example, a trial operation of the workpiece W or the product including the workpiece W) that does not cause the deformation of the workpiece W.

Incidentally, the three-dimensional shape of the workpiece W changes even in a case where a part of the workpiece W is lost (for example, worn) due to the use of the workpiece W. Therefore, it can be said that a part of the workpiece W being lost (for example, worn) is the workpiece W being deformed. However, in the present example embodiment, the "deformation of the workpiece W" means the deformation of the workpiece W that occurs due to the use of the workpiece W and the deformation of the workpiece W caused by a factor that is different from the loss of the workpiece W.

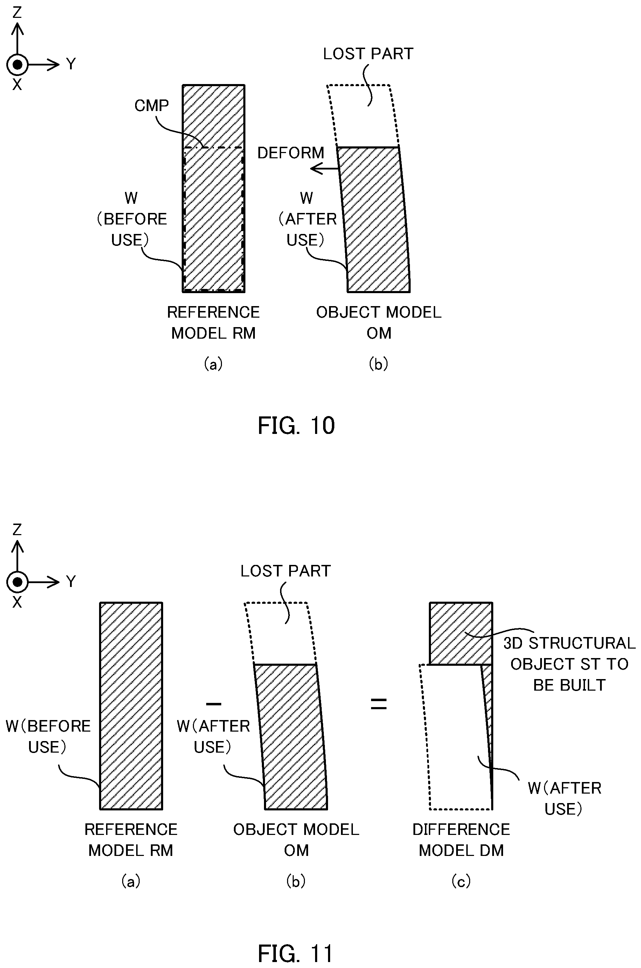

Here, as described above, the object model OM indicates the three-dimensional shape of the actually used workpiece W. Therefore, in a case where the workpiece W is deformed due to the use of the workpiece W, the object model OM indicates the actual three-dimensional shape of the workpiece W that has been deformed due to the use of the workpiece W, as illustrated in FIG. 10(b) that schematically illustrates the object model OM that is generated in a case where the workpiece W is deformed. Namely, the object model OM reflects the deformation of the workpiece W caused by the use of the workpiece W. Incidentally, the direction of the deformation of the workpiece W may be any of the X-direction, the Y-direction, or the Z-direction. The workpiece W may be deformed in two or more of the X-direction, the Y-direction, and the Z-direction. The workpiece W may also be deformed only in the X-direction, the Y-direction, or the Z-direction. On the other hand, as described above, the reference model RM indicates the three-dimensional shape of the workpiece W before it is actually used. Therefore, the reference model RM does not reflect the deformation of the workpiece W caused by the use of the workpiece W at all. Therefore, as illustrated in FIG. 10(a), the reference model RM indicates the target shape of the undeformed workpiece W.

In this case, although the three-dimensional shape of the object model OM should be the same as a three-dimensional shape of a corresponding model part CMP, which corresponds to the object model OM, of the reference model RM, the three-dimensional shape of the object model OM is different from the three-dimensional shape of the corresponding model part CMP of the reference model RM due to the deformation of the workpiece W, as illustrated in FIG. 10(a) and FIG. 10(b). As a result, as illustrated in FIG. 10(c) that schematically illustrates the difference model DM that is generated in a case where the workpiece W is deformed, the difference model DM, which corresponds to the difference between the reference model RM and the object model OM, indicates a three-dimensional shape that is different from the three-dimensional shape of the three-dimensional structural object ST that should be built by the processing apparatus 1 performing the additive manufacturing. Incidentally, FIG. 11(a) schematically illustrates the reference model RM in a case where the workpiece W is deformed due to the use of the workpiece W, and FIG. 11(b) schematically illustrates the object model OM in a case where the workpiece W is deformed, and FIG. 11(c) schematically illustrates the difference model DM that is generated based on the reference model RM illustrated in FIG. 11(a) and the object model OM illustrated in FIG. 11(b). For example, the difference model DM indicates a three-dimensional shape that is different from the three-dimensional shape of the lost part of the workpiece W. As a result, in a case where the processing control information is generated based on this difference model DM, the processing apparatus 1 builds the three-dimensional structural object ST whose shape is different from the desired shape. Namely, the processing apparatus 1 is unable to build the three-dimensional structural object ST whose shape is the desired shape. For example, the processing apparatus 1 is unable to build the three-dimensional structural object ST for appropriately filling in the lost part. Thus, in a case where the workpiece W is deformed due to the use of the workpiece W, the measurement system 2 (especially, the control information generation apparatus 22) has a technical issues that there is a possibility that it is unable generate the processing control information for controlling the processing apparatus 1 to build the three-dimensional structural object ST whose shape is the desired shape.

Therefore, in the present example embodiment, the measurement system 2 performs the below-described control information generation operation in order to solve the above described technical issues. As a result, even in a case where the workpiece W is deformed due to the use of the workpiece W, the measurement system 2 (especially, the control information generation apparatus 22) is able to generate the processing control information for controlling the processing apparatus 1 to build the three-dimensional structural object ST whose shape is the desired shape. Therefore, even in a case where the workpiece W is deformed due to the use of the workpiece W, the processing apparatus 1 is able to build the three-dimensional structural object ST whose shape is the desired shape.

Incidentally, one reason why the above-described technical issues occurs is that the three-dimensional shape of the object model OM is different from the three-dimensional shape of the corresponding model part CMP of the reference model RM as described above. Therefore, even in a case where the workpiece W is not deformed, there is a possibility that the above-described technical issues occurs in a case where the three-dimensional shape of the object model OM is different from the three-dimensional shape of the corresponding model part CMP of the reference model RM. For example, there is a possibility that the three-dimensional shape of the object model OM is different from the three-dimensional shape of the corresponding model part CMP of the reference model RM in a case where the three-dimensional shape of the workpiece W is different from the designed three-dimensional shape due to a manufacturing error of the workpiece W. For example, there is a possibility that the three-dimensional shape of the object model OM, which is generated based on the measured result by the shape measurement apparatus 21, is different from the three-dimensional shape of the corresponding model part CMP of the reference model RM due to a measurement error of the shape measurement apparatus 21 that measures the three-dimensional shape of the workpiece W. For example, there is a possibility that the three-dimensional shape of the object model OM is different from the three-dimensional shape of the corresponding model part CMP of the reference model RM due to a size error of the reference model RM. Even in this case, the measurement system 2 may perform the below-described control information generation operation. As a result, the measurement system 2 (especially, the control information generation apparatus 22) is able to generate the processing control information for controlling the processing apparatus 1 to build the three-dimensional structural object ST whose shape is the desired shape in any case where the three-dimensional shape of the object model OM is different from the three-dimensional shape of the corresponding model part CMP of the reference model RM, Therefore, the processing apparatus 1 is able to build the three-dimensional structural object whose size is the desired shape in any case where the three-dimensional shape of the object model OM is different from the three-dimensional shape of the corresponding model part CMP of the reference model RM.

However, in the below-described description, the control information generation operation that is performed in a situation where the three-dimensional shape of the object model OM is different from the three-dimensional shape of the corresponding model part CMP of the reference model RM due to the deformation of the workpiece W will be described for simplicity of the description. However, even in a situation where the three-dimensional shape of the object model OM is different from the three-dimensional shape of the corresponding model part CMP of the reference model RM due to a factor that is different from the deformation of the workpiece W, the measurement system 2 may perform the below-described control information generation operation.

Incidentally, in this example embodiment, a turbine blade, which has a shape where a X-direction size is larger than a Y-direction size and a Z-direction size is larger than both the X-direction size and the Y-direction size in the workpiece W, is described as an example. During the turbine blade operation, forces typically act in an extension direction (the Z-direction) and a rotation direction of the turbine blade. Here, because the X-direction size of the turbine blade is larger than its Y-direction size, bending deformation about the X-axis is likely to occur. Therefore, the following description illustrates the view of workpiece W from the X-direction.

Incidentally, the deformation of the workpiece W may appear bent when viewed from the Y-direction or the Z-direction, or it may be scaling.

### (2-2-3) Flow of Control Information Generation Operation

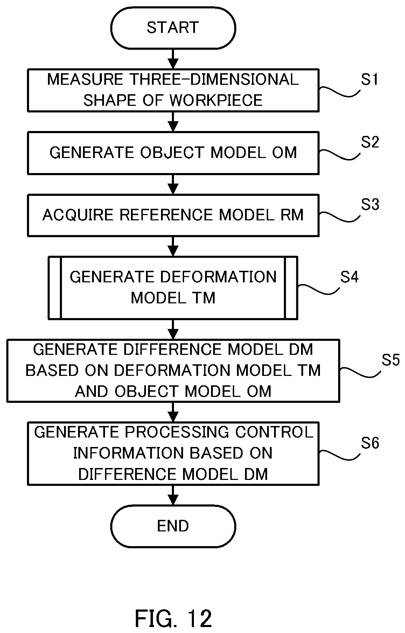

Next, with reference to FIG. 12, a flow of the control information generation operation in the present example embodiment will be described. FIG. 12 is a flowchart that illustrates the flow of the control information generation operation in the present example embodiment.

As illustrated in FIG. 12, the control apparatus 17 instructs the shape measurement apparatus 21 to measure the three-dimensional shape of the workpiece W (a step S1). the shape measurement apparatus 21 measures the three-dimensional shape of the workpiece W in accordance with the instruction from the control apparatus 17. Especially, in the present example embodiment, the shape measurement apparatus 21 measures the three-dimensional shape of the used workpiece W. As a result, the shape measurement apparatus 21 generates the measurement information that indicates the three-dimensional shape of the workpiece W. The shape measurement apparatus 21 outputs (for example, transmits) the generated measurement information to the control information generation apparatus 22.

However, in the step S1, any measurement apparatus that is different from the shape measurement apparatus 21 may measure the three-dimensional shape of the workpiece W. For example, a measurement apparatus positioned at an outside of the measurement system 2 may measure the three-dimensional shape of the workpiece W. For example, a measurement apparatus positioned at an outside of the processing system SYS may measure the three-dimensional shape of the workpiece W. Any measurement apparatus outputs (for example, transmits) the generated measurement information to the control information generation apparatus 22.

Then, the control information generation unit 2211 of the control information generation apparatus 22 generates the object model OM, which indicates the actual three-dimensional shape of the workpiece W, based on the measurement information generated at the step S1 (a step S2). Namely, the control information generation unit 2211 generates the model information that indicates the object model OM (the step S2).

However, in a case where the model generation apparatus that is different from the control information generation unit 2211 generates the object model OM as described above, the control information generation unit 2211 may not generate the object model OM. In this case, the control information generation unit 2211 may acquire the object model OM from the model generation apparatus. Alternatively, in a case where the object model OM (specifically, the model information indicating the object model OM) is stored in advance on a recording medium such as the storage apparatus 222, the control information generation unit 2211 may acquire the object model OM by reading the object model OM from the recording medium. Alternatively, in a case where the object model OM (specifically, the model information indicating the object model OM) is stored in an external apparatus that is configured to communicate with the measurement system 2 through a communication network, the control information generation unit 2211 may acquire the object model OM by downloading the object model OM from the external apparatus. Incidentally, in the example illustrated in FIG. 12, it can be said that the control information generation apparatus 22 acquires the object model OM by generating the object model OM.

The control information generation apparatus 22 may control the output apparatus 225, which is configured to serve as the display apparatus, to display the object model OM generated at the step S2. The user of the processing system SY may use the input apparatus 224 to operate the object model OM displayed on the output apparatus 225. For example, the user may use the input apparatus 224 to perform an operation for changing a display aspect of the object model OM displayed on the output apparatus 225. As one example, the user may use the input apparatus 224 to perform an operation for rotating the object model OM displayed on the output apparatus 225. As another example, the user may use the input apparatus 224 to perform an operation for changing a display size of the object model OM displayed on the output apparatus 225.

In parallel with, before, or after the operations from the step S1 to the step S2, the control information generation unit 2211 acquires the reference model RM (a step S3). For example, in a case where the reference model RM (specifically, the model information indicating the reference model RM) is stored in advance on a recording medium such as the storage apparatus 222, the control information generation unit 2211 may acquire the reference model RM by reading the reference model RM from the recording medium. Alternatively, in a case where the reference model RM (specifically, the model information indicating the reference model RM) is stored in an external apparatus that is configured to communicate with the measurement system 2 through a communication network, the control information generation unit 2211 may acquire the reference model RM by downloading the reference model RM from the external apparatus.

The control information generation unit 2211 may acquire the reference model RM based on an instruction of the user of the processing system SYS. Specifically, the user may use the input apparatus 224 to input, to the control information generation apparatus 22, an instruction for selecting one reference model RM of the plurality of different reference models RM. In this case, the output apparatus 225, which is configured to serve as the display apparatus, may display the plurality of different reference models RM. The user may select one reference model RM of the plurality of different reference models RM displayed by the output apparatus 225. Then, the control information generation apparatus 2211 may acquire the one reference model RM selected by the user.

The control information generation apparatus 22 may control the output apparatus 225, which is configured to serve as the display apparatus, to display the reference model RM acquired at the step S3. The control information generation apparatus 22 may control the output apparatus 225, which is configured to serve as the display apparatus, to display both the reference model RM and the object model OM. The user of the processing system SY may use the input apparatus 224 to operate the reference model RM displayed on the output apparatus 225. For example, the user may use the input apparatus 224 to perform an operation for changing a display aspect of the reference model RM displayed on the output apparatus 225. As one example, the user may use the input apparatus 224 to perform an operation for rotating the reference model RM displayed on the output apparatus 225. As another example, the user may use the input apparatus 224 to perform an operation for changing a display size of the reference model RM displayed on the output apparatus 225.

Then, in the present example embodiment, the control information generation unit 2211 generates a deformation model TM (a step S4). The deformation model TM is a three-dimensional model that indicates the target shape of the workpiece W after the processing. Incidentally, since the deformation model TM indicates the target shape of the workpiece W, it may be referred to as the target model as with the reference model RM.

The deformation model TM is different from the reference model RM in the following point. Specifically, the deformation model TM is different from the reference model RM, which is the three-dimensional model indicating the target shape of the undeformed workpiece W (for example, an ideal workpiece W), in that it is the three-dimensional model indicating the target shape of the deformed workpiece W. Namely, the deformation model TM is different from the reference model RM, which is the three-dimensional model indicates the target shape that does not reflect the deformation of the workpiece W, in that it is the three-dimensional model indicating the target shape that reflects the deformation of the workpiece W.

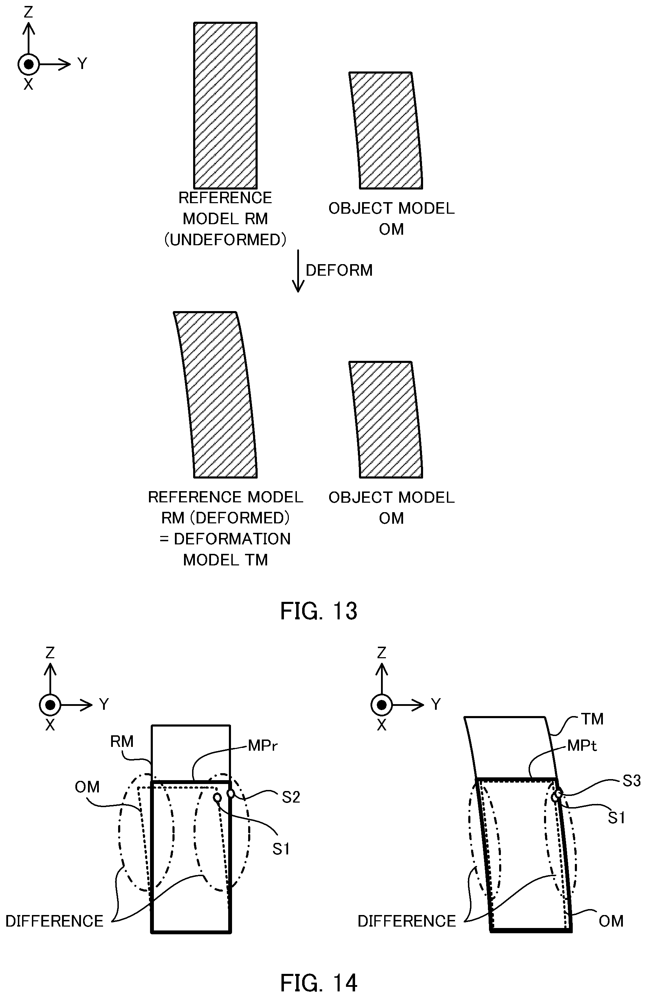

In order to generate the deformation model TM, the control information generation unit 2211 may deform the reference model RM in accordance with the deformation of the workpiece W. Namely, the control information generation unit 2211 may deform the reference model RM to generate the deformed reference model RM as the deformation model TM. Specifically, as described above, the object model OM reflects the deformation of the workpiece W. On the other hand, as described above, the reference model RM does not reflect the deformation of the workpiece W. In this case, as illustrated in FIG. 13 that schematically illustrates the undeformed reference model RM and the deformed reference model RM (namely, the deformation model TM), the control information generation unit 2211 may deform the reference model RM, which does not reflect the deformation of the workpiece W, based on the object model OM, which reflects the deformation of the workpiece W. Namely, the control information generation unit 2211 may deform the reference model RM, which does not reflect the deformation of the workpiece W, in accordance with the actual shape of the workpiece W indicated by the object model OM (namely, the shape of the deformed workpiece W). However, the control information generation unit 2211 may deform the reference model RM without using the object model OM, as long as it is possible to deform the reference model RM in accordance with the deformation of the workpiece W.

As illustrated in FIG. 14 that schematically illustrates the undeformed reference model RM and the deformed reference model RM (namely, the deformation model TM), the control information generation unit 2211 may deform the reference model RM so that a difference between the object model OM and a corresponding model part MPt, which corresponds to the object model OM, of the deformation model TM is smaller than a difference between the object model OM and a corresponding model part MPr, which corresponds to the object model OM, of the reference model RM. Incidentally, the difference between object model OM and the corresponding model part MPr of the reference model RM may be considered to be equivalent to a deformed amount of the workpiece W.

As illustrated in FIG. 14, the difference between the object model OM and the corresponding model part MPt of the deformation model TM may mean a difference between a three-dimensional shape of a first part S11 of a surface of the object model OM and a three-dimensional shape of a second part S12, which corresponds to the first part S11 of the object model OM, of a surface of the deformation model TM. Similarly, as illustrated in FIG. 14, the difference between the object model OM and the corresponding model part MPr of the reference model RM may mean a difference between a three-dimensional shape of the first part S11 of the surface of the object model OM and a three-dimensional shape of a third part S13, which corresponds to the first part S11 of the object model OM, of a surface of the reference model RM.

As one example, in a case where the object model OM is the mesh model as described above, a vertex of the mesh is positioned on the surface of the object model OM. Similarly, in a case where the reference model RM is the mesh model, the vertex of the mesh is positioned on the surface of the reference model RM. Similarly, in a case where the deformation model TM is the mesh model, the vertex of the mesh is positioned on the surface of the deformation model TM. In this case, the difference between the object model OM and the corresponding model part MPt of the deformation model TM may be defined by using the vertex of the mesh. Similarly, the difference between the object model OM and the corresponding model part MPr of the reference model RM may be defined by using the vertex of the mesh.

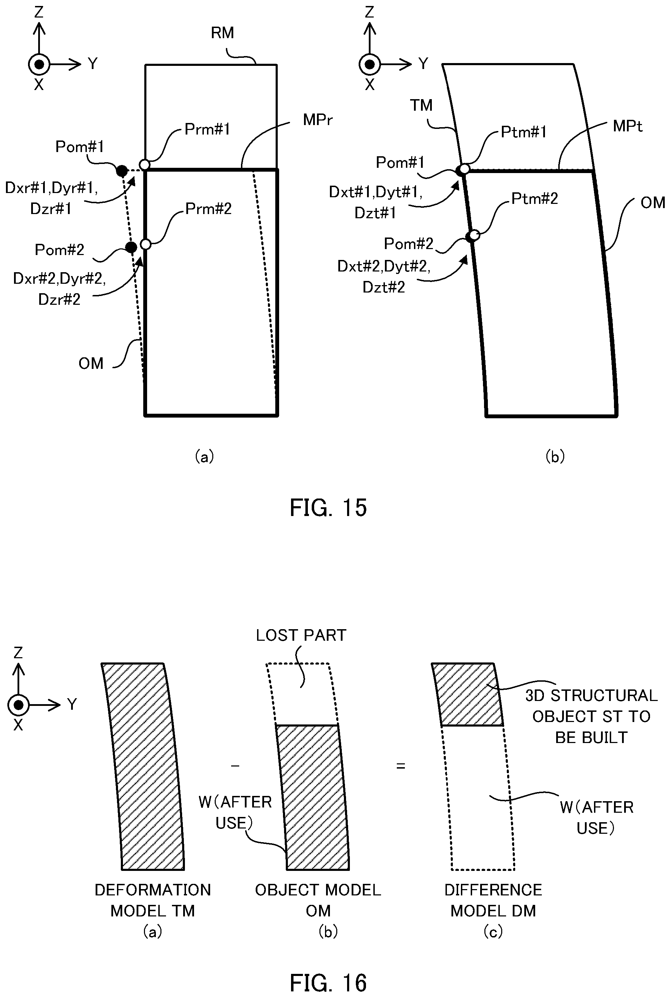

For example, FIG. 15(a) illustrates an example in which a vertex Pom#1 of a first mesh of the object model OM, which is the mesh model, corresponds to a vertex Prm#1 of a first of the reference model RM, which is the mesh model. Furthermore, FIG. 15(a) illustrates an example in which a vertex Pom#2 of a second mesh of the object model OM corresponds to a vertex Prm#2 of a second of the reference model RM. Namely, FIG. 15(a) illustrates an example in which the vertex Pom#1 of the object model OM coincides with the vertex Prm#1 of the reference model RM and the vertex Pom#2 of the object model OM coincides with the vertex Prm#2 of the reference model RM in a case where the workpiece W is not deformed. In this case, a difference between the vertex Pom#1 and the vertex Prm#1 may be considered to be equivalent to the deformed amount of one part of the workpiece W. Similarly, a difference between the vertex Pom#2 and the vertex Prm#2 may be considered to be equivalent to the deformed amount of another part of the workpiece W.

On the other hand, FIG. 15(b) illustrates an example in which the vertex Pom#1 of the object model OM corresponds to a vertex Ptm#1 of a first mesh of the deformation model TM, which is the mesh model. Furthermore, FIG. 15(b) illustrates an example in which the vertex Pom#2 of the object model OM corresponds to a vertex Ptm#2 of a second mesh of the deformation model TM. Incidentally, since the deformed reference model RM is used as the deformation model TM, the vertex Ptm#1 of the deformation model TM is equivalent to the vertex Prm#1 of the deformed reference model RM. Similarly, the vertex Ptm#2 of the deformation model TM is equivalent to the vertex Prm#2 of the deformed reference model RM.

In this case, the control information generation unit 2211 may use a distance between the vertex Pom#1 of the object model OM and the vertex Prm#1 of the reference model RM as an index value indicating the difference between the object model OM and the corresponding model part MPr of and the reference model RM. The control information generation unit 2211 may use a distance between the vertex Pom#2 of the object model OM and the vertex Prm#2 of the reference model RM as the index value indicating the difference between the object model OM and the corresponding model part MPr of the reference model RM. Similarly, the control information generation unit 2211 may use a distance between the vertex Pom#1 of the object model OM and the vertex Ptm#1 of the deformation model TM as an index value indicating the difference between the object model OM and the corresponding model part MPt of the deformation model TM. The control information generation unit 2211 may use a distance between the vertex Pom#2 of the object model OM and the vertex Ptm#2 of the deformation model TM as the index value indicating the difference between the object model OM and the corresponding model part MPt of the deformation model TM.

In this case, as illustrated in FIG. 15(a) and FIG. 15(b), the control information generation unit 2211 may deform the reference model RM so that the distance between the vertex Pom#1 and the vertex Ptm#1 (see FIG. 15(b)) is shorter than the distance between the vertex Pom#1 and the vertex Prm#1 (see FIG. 15(a)). For example, the control information generation unit 2211 may deform the reference model RM so that a distance Dxt#1 between the vertex Pom#1 and the vertex Ptm#1 in the X-axis direction is shorter than a distance Dxr#1 between the vertex Pom#1 and the vertex Prm#1 in the X-axis direction. For example, the control information generation unit 2211 may deform the reference model RM so that a distance Dyt#1 between the vertex Pom#1 and the vertex Ptm#1 in the Y-axis direction is shorter than a distance Dyr#1 between the vertex Pom#1 and the vertex Prm#1 in the Y-axis direction. For example, the control information generation unit 2211 may deform the reference model RM so that a distance Dzt#1 between the vertex Pom#1 and the vertex Ptm#1 in the Z-axis direction is shorter than a distance Dzr#1 between the vertex Pom#1 and the vertex Prm#1 in the Z-axis direction.

Incidentally, the control information generation unit 2211 may deform the reference model RM so that the distance Dyt#1 is shorter than the distance Dyr#1 and / or the distance Dzt#1 is shorter than the distance Dzr#1 while the distance Dxt#1 is not shorter than the distance Dxr#1. The control information generation unit 2211 may deform the reference model RM so that the distance Dxt#1 is shorter than the distance Dxr#1 and / or the distance Dzt#1 is shorter than the distance Dzr#1 while the distance Dyt#1 is not shorter than the distance Dyr#1. The control information generation unit 2211 may deform the reference model RM so that the distance Dxt#1 is shorter than the distance Dxr#1 and / or the distance Dyt#1 is shorter than the distance Dyr#1 while the distance Dzt#1 is not shorter than the distance Dzr#1.

Similarly, as illustrated in FIG. 15(a) and FIG. 15(b), the control information generation unit 2211 may deform the reference model RM so that the distance between the vertex Pom#2 and the vertex Ptm#2 (see FIG. 15(b)) is shorter than the distance between the vertex Pom#2 and the vertex Prm#2 (see FIG. 15(a)). For example, the control information generation unit 2211 may deform the reference model RM so that a distance Dxt#2 between the vertex Pom#2 and the vertex Ptm#2 in the X-axis direction is shorter than a distance Dxr#2 between the vertex Pom#2 and the vertex Prm#2 in the X-axis direction. For example, the control information generation unit 2211 may deform the reference model RM so that a distance Dyt#2 between the vertex Pom#2 and the vertex Ptm#2 in the Y-axis direction is shorter than a distance Dyr#2 between the vertex Pom#2 and the vertex Prm#2 in the Y-axis direction. For example, the control information generation unit 2211 may deform the reference model RM so that a distance Dzt#2 between the vertex Pom#2 and the vertex Ptm#2 in the Z-axis direction is shorter than a distance Dzr#2 between the vertex Pom#2 and the vertex Prm#2 in the Z-axis direction.

Incidentally, the control information generation unit 2211 may deform the reference model RM so that the distance Dyt#2 is shorter than the distance Dyr#2 and / or the distance Dzt#2 is shorter than the distance Dzr#2 while the distance Dxt#2 is not shorter than the distance Dxr#2. The control information generation unit 2211 may deform the reference model RM so that the distance Dxt#2 is shorter than the distance Dxr#2 and / or the distance Dzt#2 is shorter than the distance Dzr#2 while the distance Dyt#2 is not shorter than the distance Dyr#2. The control information generation unit 2211 may deform the reference model RM so that the distance Dxt#2 is shorter than the distance Dxr#2 and / or the distance Dyt#2 is shorter than the distance Dyr#2 while the distance Dzt#2 is not shorter than the distance Dzr#2.

The control information generation unit 2211 may deform the reference model RM so that the corresponding model part MPt of the deformation model TM coincides with the object model OM. For example, the control information generation unit 2211 may deform the reference model RM so that the vertex Pom#1 of the object model OM coincides with the vertex Ptm#1 of the deformation model TM. The control information generation unit 2211 may deform the reference model RM so that the distance between the vertex Pom#1 and the vertex Ptm#1 becomes zero. For example, the control information generation unit 2211 may deform the reference model RM so that at least one of the distances Dxt#1, Dyt#1, Dzt#1, Dxt#2, Dyt#2, and Dzt#2 becomes zero.

Incidentally, in FIG. 15(a), the distance between the vertex Pom#1 of the object model OM and the vertex Prm#1 of the reference model RM may be different from the distance between the vertex Pom#2 of the object model OM and the vertex Prm#2 of the reference model RM. Namely, the deformed amount of one part of the workpiece W may be different from the deformed amount of another part of the workpiece W. As one example, in a case where the workpiece W is the turbine blade, the deformed amount of one part of the turbine blade generally becomes larger as the one part is closer to a tip of the turbine blade because the turbine blade undergoes bending deformation. Namely, the deformed amount of one part of the turbine blade generally becomes smaller as the one part is closer to a base of the turbine blade. Incidentally, the base of the turbine blade may mean a shank of the turbine blade (namely, a part that is attached to the rotatable rotor). The tip of the turbine blade may mean a tip of a blade body that extends from the shank. In this case, the vertices Pom#1, Prm#1 and Ptm#1 are closer to the tip of the turbine blade than the vertices Pom#2, Prm#2 and Ptm#2 are, the distance between the vertex Pom#1 and the vertex Prm#1 may be larger than the distance between the vertex Pom#2 and the vertex Prm#2.

In a case where the deformation model TM is generated, a file (for example, a CAD file that indicates the CAD data, the same applies to this paragraph) may include assembly information associating information relating to the deformation model TM with information relating to the object model OM. The file may include assembly information associating information relating to the deformation model TM, information relating to the object model OM and information relating to the reference model RM to each other. The file may include assembly information associating information relating to the deformation model TM, information relating to the object model OM, information relating to the reference model RM and information relating to the difference model DM to each other.

Alternatively, the file (for example, the CAD file indicating the CAD data, the same applies to this paragraph) may include at least one of the object model OM, the reference model RM, the deformation model TM, and the difference model DM in an information format that is different from an information format of the assembly information. Alternatively, at least one of a file including the object model OM, a file including the reference model RM, a file including the deformation model TM, and a file including the difference model DM may be stored in the storage apparatus 222 or the like. Namely, the object model OM, the reference model RM, the deformation model TM, and the difference model DM may be included in separate files, respectively. In this case, a management file that includes information indicating that at least two of the file including the object model OM, the file including the reference model RM, the file including the deformation model TM, and the file including the difference model DM are associated with each other may be stored in the storage apparatus 222 or the like.

Again in FIG. 12, after the deformation model TM is generated, the control information generation unit 2211 generates the difference model DM (a step S5). In the present example embodiment, the control information generation unit 2211 generates the difference model DM based on the object model OM generated (acquired) at the step S2 and the deformation model TM generated at the step S4. Specifically, the control information generation unit 2211 may generate, as the difference model DM, a three-dimensional model corresponding to a difference between the deformation model TM and the object model OM. The difference model DM is typically the three-dimensional model corresponding to a part of the deformation model TM. Incidentally, FIG. 16(a) schematically illustrates the reference model RM in a case where the workpiece W is deformed due to the use of the workpiece, FIG. 16(b) schematically illustrates the object model OM in a case where the workpiece W is deformed due to the use of the workpiece, and FIG. 16(c) schematically illustrates the difference model DM that is generated based on the reference model RM illustrated in FIG. 16(a) and the object model OM illustrated in FIG. 16(b).

As a result, as illustrated in FIG. 16(c), the difference model DM, which corresponds to the difference between the deformation model TM and the object model OM, is closer to the three-dimensional shape of the three-dimensional structural object ST that should be built by the processing apparatus 1, compared to the three-dimensional shape indicated by the difference model DM (see FIG. 11(c)), which corresponds to the difference between the reference model RM and the object model OM. For example, the difference model DM (see FIG. 16(c)), which corresponds to the difference between the deformation model TM and the object model OM, is closer to the three-dimensional shape of the lost part of the workpiece W, compared to the three-dimensional shape indicated by the difference model DM (see FIG. 11(c)), which corresponds to the difference between the reference model RM and the object model OM. Typically, the difference model DM (see FIG. 16(c)), which corresponds to the difference between the deformation model TM and the object model OM, indicates the three-dimensional shape that is the same as the three-dimensional shape of the three-dimensional structural object ST that should be built by the processing apparatus 1 performing the additive manufacturing. For example, the difference model DM (see FIG. 16(c)), which corresponds to the difference between the deformation model TM and the object model OM, indicates the three-dimensional shape that is the same as the three-dimensional shape of the lost part of the workpiece W.

Thus, an accuracy of the difference model DM is improved in the present example embodiment. Namely, the difference model DM appropriately indicates the three-dimensional shape of the three-dimensional structural object ST that should be built by the processing apparatus 1 so that the three-dimensional shape of the workpiece W becomes the target shape. Specifically, the difference model DM appropriately indicates the three-dimensional shape of the three-dimensional structural object ST that should be built by the processing apparatus 1 so that the three-dimensional shape of the deformed workpiece W becomes the target shape that has been appropriately modified in accordance with the deformation of the workpiece W. Namely, the difference model DM appropriately indicates the three-dimensional shape of a processing part that is necessary for making the three-dimensional shape of the workpiece W become the target shape.

The control information generation apparatus 22 may control the output apparatus 225, which is configured to serve as the display apparatus, to display the deformation model TM generated at the step S5. The control information generation apparatus 22 may control the output apparatus 225, which is configured to serve as the display apparatus, to display at least two of the reference model RM, the object model OM, and the deformation model TM. The user of the processing system SYST may use the input apparatus 224 to operate the deformation model TM displayed on the output apparatus 225. For example, the user may use the input apparatus 224 to perform an operation for changing a display aspect of the deformation model TM displayed on the output apparatus 225. For example, the user may use the input apparatus 224 to perform an operation for rotating the deformation model TM displayed on the output apparatus 225. As another example, the user may use the input apparatus 224 to perform an operation for changing a display size of the deformation model TM displayed on the output apparatus 225.

Then, the control information generation unit 2211 generates the processing control information based on the difference model DM generated at the step S5 (a step S6). For example, the control information generation unit 2211 may generate the plurality of slice data, which correspond to the plurality of structural layers SL included in the three-dimensional structural object ST, respectively, by performing the slicing process for dividing the difference model DM into the plurality of layered models with the layered pitch corresponding to the thickness of the structural layer SL. Then, the control information generation unit 2211 may generate the plurality of pieces of processing control information, which are used to build the plurality of structural layers SL, respectively, based on the plurality of slice data.

As a result, the processing apparatus 1 is able to build the three-dimensional structural object ST having the desired shape. For example, the processing apparatus 1 is able to build the three-dimensional structural object ST that is able to appropriately filling in the lost part. Thus, even in a case where the workpiece W is deformed due to the use of the workpiece W, the measurement system 2 (especially, the control information generation apparatus 22) is able to generate the processing control information for controlling the processing apparatus 1 to build the three-dimensional structural object ST having the desired shape.

It can be said that an operation for building the three-dimensional structural object ST is equivalent to an operation for building the three-dimensional structural object ST, whose three-dimensional shape is indicated by the difference model DM, on the workpiece W, whose three-dimensional shape is indicated by the object model OM. In this case, the control apparatus 17 of the processing apparatus 1 may control the processing apparatus 1 to build the three-dimensional structural object ST, whose three-dimensional shape is indicated by the difference model DM, on the workpiece W, whose three-dimensional shape is indicated by the object model OM.

The control apparatus 17 may perform the control information generation operation illustrated in FIG. 12, in addition to or instead of the control information generation apparatus 22. Namely, the control apparatus 17 may generate the deformation model TM by deforming the reference model RM based on the object model OM, and may generate the difference model DM based on the deformation model TM and the object model OM. Alternatively, the control apparatus 17 (alternatively, the control information generation apparatus 22) may deform a three-dimensional model, which indicates a three-dimensional structure of the three-dimensional structural object ST that should be formed on the undeformed workpiece W, based on the object model OM that indicates the three-dimensional shape of the deformed workpiece W to generate the deformed three-dimensional model as the difference model DM. An operation for deforming the three-dimensional model of the three-dimensional structural object ST based on the object model OM may be the same as an operation for deforming the reference model RM based on the object model OM. Namely, the control apparatus 17 (alternatively, the control information generation apparatus 22) may deform the three-dimensional model of the three-dimensional structural object ST by performing an alignment of the three-dimensional model of the three-dimensional structural object ST and the object model OM, then setting each vertex of the three-dimensional model of the three-dimensional structural object ST to one of a control vertex, a dependent vertex, and a fixed vertex, and then moving the control vertex and the dependent vertex.

The control apparatus 17 (alternatively, the control information generation apparatus 22, the same applies to this paragraph) may use, as the three-dimensional model of the three-dimensional structural object that should be formed on the undeformed workpiece W, the slice data that is acquired by performing the slicing process, which is for dividing this three-dimensional model with the layered pitch corresponding to the thickness of the structural layer SL, on the three-dimensional model. Alternatively, the control apparatus 17 may use slice data that is acquired by performing the slicing processing on the three-dimensional model that is acquired by deforming the three-dimensional model of the three-dimensional structural object ST based on the object model OM, as described above. The slice data may include data (file) indicating the G-code. In this case, the control apparatus 17 may generate the difference model DM based on the slice data and at least one of the object model OM, the reference model RM, and the deformation model TM. The control apparatus 17 may generate the processing control information based on the slice data and at least one of the object model OM, the reference model RM, and the deformation model TM. The control apparatus 17 may control the processing apparatus 1 to build the three-dimensional structural object ST on the workpiece W based on the slice data and at least one of the object model OM, the reference model RM, and the deformation model TM. In a case where the slice data includes the data (the file) indicating the G-code, the control apparatus 17 may edit the G-code to build the three-dimensional structural object ST on the workpiece W. For example, the control apparatus 17 may align the data of the G-code to build the three-dimensional structural object ST on the workpiece W.

### (2-2-4) Operation for Generating Deformation Model TM by Deforming Reference Model RM

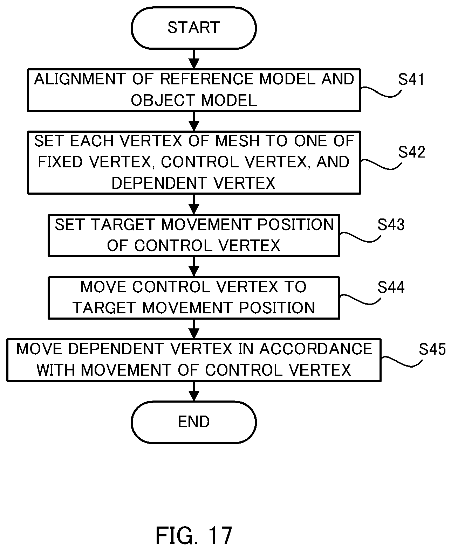

Next, with reference to FIG. 17, an operation of generating the deformation model TM by deforming the reference model RM at the step S4 in FIG. 12 will be further described. FIG. 17 is a flowchart that illustrates a flow of the operation of generating the deformation model TM by deforming the reference model RM at the step S4 in FIG. 12.

In the below-described description, an operation for generating the deformation model TM by deforming the reference model RM using Laplacian Coordinates Representation will be described as one specific example of the operation for generating the deformation model TM by deforming the reference model RM. In this case, deforming the reference model RM may be referred to as a Laplacian deformation. Incidentally, the control information generation apparatus 22 may deform the reference model RM by performing an operation that is different from the operation illustrated in FIG. 17 to generate the deformation model TM.

As illustrated in FIG. 17, the control information generation unit 2211 performs an alignment of the reference model RM and the object model OM (a step S41). In order to perform the alignment of the reference model RM and the object model OM, the control information generation unit 2211 may perform an alignment method using at least one of a RANSAC (Random Sample Consensus), a SIFT (Scale-Invariant Feature Transform), an ICP (Iterative Closest Point), and a DSO (Direct Sparse Odometry). In other words, the control information generation unit 2211 may perform the alignment of the reference model RM and the object model OM by using an existing alignment method.

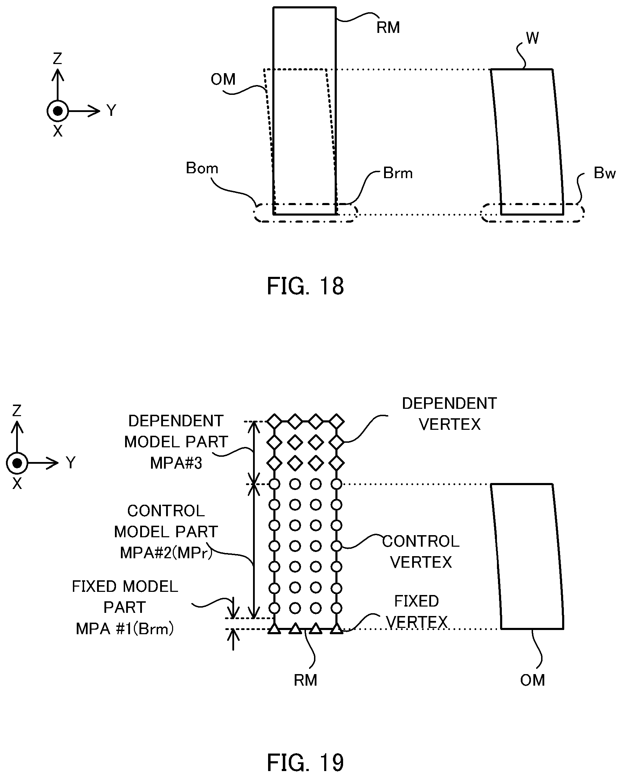

FIG. 18 illustrates one example of the alignment of the reference model RM and the object model OM. As illustrated in FIG. 18, the control information generation unit 2211 may perform the alignment of the reference model RM and the object model OM so that a base part Brm of the reference model RM coincides with a base part Bom of the object model OM. Namely, the control information generation unit 2211 may perform the alignment of the reference model RM and the object model OM so that the base part Brm of the reference model RM and the base part Bom of the object model OM are positioned at the same position. The base part Brm of the reference model RM may be a model part of the reference model that corresponds to a base part Bw of the workpiece W. The base part Bom of the object model OM may be a model part corresponding to the base part Bw of the workpiece W of the object model OM.

As described above, in this example embodiment, an example, in which each of the reference model RM and the object model OM is the mesh model, is described. In a case where the reference model RM is the mesh model (namely, includes the plurality of meshes that form the surface of the reference model RM), the base part Brm of the surface of the reference model RM may be used as the base part Brm of the reference model RM. Similarly, in a case where the object model OM is the mesh model (namely, includes the plurality of meshes that form the surface of the object model OM), the base part Bom of the surface of the object model OM may be used as the base part Bom of the object model OM.

The base part Bw of the workpiece W may include a part at which the deformed amount due to the use of the workpiece W is equal to or smaller than an allowable amount. The base part Bw of the workpiece W may include a part that is not deformed due to the use of the workpiece W. The base part Bw of the workpiece W may be a part to which the jig used to place the workpiece W on the stage 131 is attached. The base part Bw of the workpiece may be a predetermined part.

The control information generation unit 2211 may perform the alignment of the reference model RM and the object model OM based on an instruction of the user of the processing system SYS. Specifically, the user may use the input apparatus 224 to input, to the control information generation apparatus 22, an instruction for performing the alignment of the reference model RM and the object model OM. In this case, the output apparatus 225, which is configured to serve as the display apparatus, may display the reference model RM and the object model OM. The user may perform the alignment of the reference model RM and the object model OM by moving at least one of the reference model RM and the object model OM displayed on the output apparatus 225 by using the input apparatus 224.

Again in FIG. 17, in parallel with, before, or after the operation at the step S41, the control information generation unit 2211 sets each vertex of each mesh of the reference model RM, which is the mesh model, to one of the fixed vertex, the control vertex, and the dependent vertex (a step S42).

For example, the control information generation unit 2211 may set each vertex of the reference model RM to one of the fixed vertex, the controlled vertex, and the dependent vertex based on an instruction of the user of the processing system SYS. Specifically, the user may use the input apparatus 224 to input, to the control information generation apparatus 22, an instruction for setting each vertex of the reference model RM to one of the fixed vertex, the control vertex, and the dependent vertex. In this case, the output apparatus 225, which is configured to serve as the display apparatus, may display the reference model RM. The user may set each vertex of the reference model RM to one of the fixed vertex, the control vertex, and the dependent vertex on the reference model RM displayed on the output apparatus 225 by using the input apparatus 224. In this case, considering that the reference model RM is deformed by moving the control vertex and the dependent vertex as described later, it can be said that the user sets a deformed part of the reference model RM.

Alternatively, for example, the control information generation unit 2211 may automatically set each vertex of the reference model RM to one of the fixed vertex, the control vertex, and the dependent vertex, based on a predetermined vertex setting condition, without using the instruction of the user.

FIG. 19 illustrates one example of the reference model RM in which each vertex is set to one of the fixed vertex, the control vertex, and the dependent vertex. The fixed vertex corresponds to a vertex that does not move when the reference model RM is deformed to generate the deformation model TM. The fixed vertex may be a vertex that is used as a non-ROI (non-Region Of Interest), for example.

The control vertex corresponds to a vertex that moves when the reference model RM is deformed to generate the deformation model TM. Especially, the control vertex is a vertex for which a target movement position, to which the control vertex should move, is set. Therefore, the control vertex moves to the set target movement position when the reference model RM is deformed to generate the deformation model TM. Incidentally, in a case where the target movement position is set, a movement distance and a movement direction of the control vertex are effectively set. Therefore, the control vertex may be regarded as a vertex whose movement distance and the movement direction are set.

The dependent vertex corresponds to a vertex that is moved when the reference model RM is deformed to generate the deformation model TM, as with the control vertex. The dependent vertex is a vertex for which the target movement position, to which the dependent vertex should move, is not set, compared to the control vertex. The dependent vertex may be regarded a vertex whose movement distance and the movement direction are not set. In this case, the dependent vertex moves in accordance with the movement of the control vertex. Namely, the dependent vertex moves passively as a result of the deformation of the reference model RM caused by the movement of the control vertex. In this case, the dependent vertex may be regarded as a vertex that moves by a movement distance that is determined based on the movement of the control vertex. The dependent vertex may be regarded as a vertex that moves in the movement direction that is determined based on the movement of the control vertex. Incidentally, the dependent vertex may be a vertex that is used as a ROI (Region Of Interest), for example.

As illustrated in FIG. 19, the control information generation unit 2211 may set vertex, which is included in the base part Brm of the reference model RM, to the fixed vertex, for example. In this case, as illustrated in FIG. 19, the base part Brm of the reference model RM may be regarded as a fixed mode part MPA#1 of the reference model RM that should not be deformed.

As illustrated in FIG. 19, the control information generation unit 2211 may set vertex, which is included in at least a part of the corresponding model part MPr, that corresponds to the object model OM, of the reference model RM, to the control vertex, for example. In this case, as illustrated in FIG. 19, at least the part of the corresponding model MPr of the reference model RM may be regarded as a control model part MPA#2 of the reference model that should be deformed by moving the control vertex.

As illustrated in FIG. 19, the control information generation unit 2211 may set a vertex, which is included in a dependent model part MPA#3 of the reference model RM that is different from the fixed model part MPA#1 and the control model part MPA#2, to the dependent vertex, for example.

Incidentally, the control information generation unit 2211 may set all of the vertices, which are included in the reference model RM, to one of the fixed vertex, the control vertex, and the dependent vertex one by one. Alternatively, the control information generation unit 2211 may set two or more of the vertex, which is included in the reference model RM, to one of the fixed vertices, the control vertices, and the dependent vertices collectively. For example, the control information generation unit 2211 may designate a model part corresponding to a part of the reference model RM, and may set two or more of the vertex, which is included in the designated model part, to one of the fixed vertices, the control vertices, and the dependent vertices collectively. As a result, a processing load required to set each of the plurality of vertices to one of the fixed vertex, the control vertex, and the dependent vertex is reduced, compared to a case where all of the plurality of vertices are set to one of the fixed vertex, the control vertex, and the dependent vertex.

Again in FIG. 17, then, the control information generation unit 2211 sets the target movement position of the control vertex (a step S43). Namely, the control information generation unit 2211 sets the target movement position of the vertex of the reference model RM that has been set to the control vertex at the step S42 (the step S43). For example, the control information generation unit 2211 may set the target movement position of the control vertex so that the movement of the control vertex to the target movement position decreases a difference between the control model part MPA#2 (see FIG. 19) and the object model OM. Namely, the control information generation unit 2211 may set the target movement position of the control vertex so that the movement of the control vertex to the target movement position decreases a difference between a three-dimensional shape of the control model part MPA#2 that is a part of the surface of the reference model RM and a three-dimensional shape of a model part of the surface the object model OM that corresponds to the control model part MPA#2.

The control information generation unit 2211 may set the target movement position of the control vertex in the model part of the surface the object model OM that corresponds to the control model part MPA#2 in order to decrease the difference between the control model part MP#2 and the object model OM. In this case, the control information generation unit 2211 may extract the model part of the object model OM that corresponds to the control model part MPA#2 from the object model OM, and set the target movement position in the extracted model part.

The control information generation unit 2211 may set the target movement position of the control vertex based on an instructions of the user of the processing system SYS. Specifically, the user may use the input apparatus 224 to input, to the control information generation apparatus 22, an instruction for setting the target position. In this case, the output apparatus 225, which is configured to serve as the display apparatus, may display the reference model RM. The user may use the input apparatus 224 to set the target movement position for the reference model RM displayed on the output apparatus 225. In this case, it can be said that the user sets the deformed amount of the reference model RM.

The control information generation unit 2211 may determine based on the target movement position set at the step S43 whether or not it is possible to generate the deformation model TM. For example, considering that the control vertex moves to the target movement position, it can be said that an operation for setting the target movement position is equivalent to an operation for setting the movement distance of the control vertex. Here, the movement distance of the control vertex should be larger as the deformed amount of the workpiece W is larger. In this case, in a case where the deformed amount of the workpiece W is equal to or larger than an allowable deformed amount, there is a possibility that the three-dimensional shape of the repaired workpiece W is greatly different from an expected three-dimensional shape even in a case where the workpiece W is repaired by building the three-dimensional structural object ST on the workpiece W. Namely, there is a possibility that it is difficult to say that the workpiece W has been repaired appropriately. Therefore, the control information generation unit 2211 may determine whether or not it is possible to generate the deformation model TM by determining based on the target movement position whether or not the movement distance of at least one control vertex is equal to or larger than an allowable movement distance. For example, the control information generation unit 2211 may determine that it is not possible to generate the deformation model TM in a case where the movement distance of at least one control vertex is equal to or larger than the allowable movement distance.

In a case where it is determined that it is not possible to generate the deformation model TM, the control information generation apparatus 22 may use the output apparatus 225 to output notification information to inform the user of the processing system SYS that it is not possible to generate the deformation model TM. For example, the control information generation apparatus 22 may use the output apparatus 225, which is configured to serve as the display apparatus, to display a notification image to inform the user that it is not possible to generate the deformation model TM.

In a case where it is determined that it is not possible to generate the deformation model TM, the control information generation apparatus 22 may control the control information generation unit 2211 so as not to generate the processing control information, in addition to or instead of outputting the notification information to inform the user that it is not possible to generate the deformation model TM. The control information generation apparatus 22 may control the communication apparatus 223 so as not to transmit the processing control information to the processing apparatus 1, in addition to or instead of outputting the notification information.

In a case where it is determined that it is possible to generate the deformation model TM, the control information generation unit 2211 generates the deformation model TM by deforming the reference model RM (a step S44 to a step S45).

Specifically, the control information generation unit 2211 moves the control vertex to the target movement position in a state where the alignment of the reference model RM and the object model OM has been performed (the step S44). Namely, the control information generation unit 2211 moves the vertex of the reference model RM, which is set to the control vertex at the step S42, to the target movement position, which is set at the step S43 (the step S44).

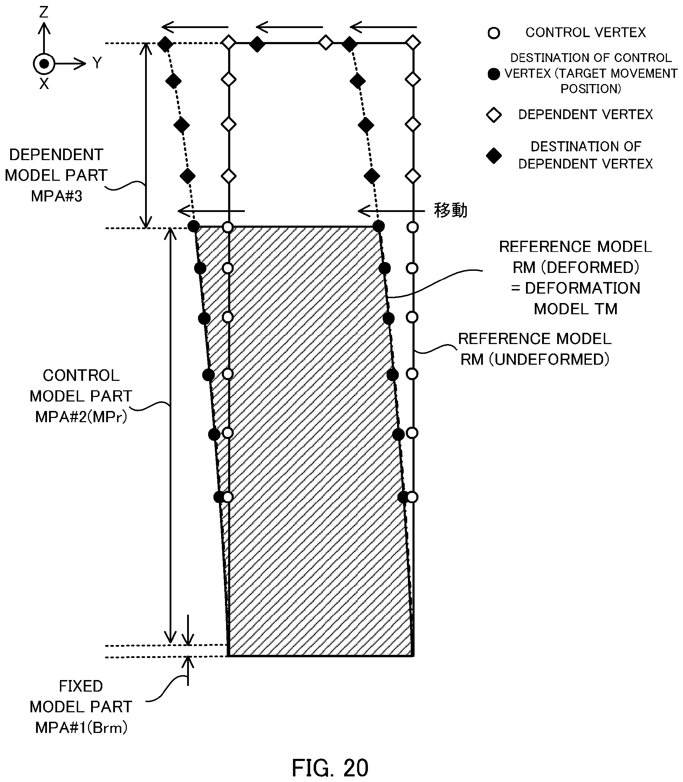

As a result, as illustrated in FIG. 20 that schematically illustrates the undeformed reference model RM and the deformed reference model RM, the control model part MPA#2 of the reference model RM is deformed in accordance with the movement of the control vertex. Namely, the three-dimensional shape of the control model part MPA#2 of the reference model RM is changed. Specifically, the control model part MPA#2 of the reference model RM is deformed so that the control model part MPA#2 of the reference model RM moves to a position of the model part of the object model OM that corresponds to the control model part MPA#2. Therefore, it can be said that an operation for moving the control vertex is equivalent to an operation for deforming the control model part MPA#2 of the reference model RM. It can be said that an operation of moving the control vertex to the target movement position is equivalent to an operation for deforming the control model part MPA#2 of the reference model RM so that the control model part MPA#2 of the object model OM moves to the position of the model part of the object model OM that corresponds to the control model part MPA#2.

Furthermore, the control information generation unit 2211 moves the dependent vertex in accordance with the movement of the control vertex (the step S45). Namely, the control information generation unit 2211 moves the vertex of the reference model RM, which is set to the dependent vertex at the step S42, in accordance with the movement of the control vertex at the step S44 (the step S45). For example, the control information generation unit 2211 may move the dependent vertex in accordance with the movement of the control vertex by performing a Mesh Deformation.

As a result, as illustrated in FIG. 20, the dependent model part MPA#3 of the reference model RM is deformed in accordance with the movement of the dependent vertex. Namely, the three-dimensional shape of the dependent model part MPA#3 of the reference model RM is changed. In this case, it can be said that the dependent model part MPA#3 of the reference model RM is deformed in accordance with the deformation of the control model part MPA#2 of the reference model RM.

Incidentally, the control information generation unit 2211 may move the control vertex based on an instruction of the user of the processing system SYS. Specifically, the user may use the input apparatus 224 to input, to the control information generation apparatus 22, an instruction for moving the control vertex. In this case, the output apparatus 225, which is configured to serve as the display apparatus, may display the reference model RM. Especially, the output apparatus 225, which is configured to serve as the display apparatus, may display the control vertex of the reference model RM. The user may use the input apparatus 224 to move the control vertex displayed on the output apparatus 225. In this case, it can be said that the user sets the deformed amount of the reference model RM.

The control information generation unit 2211 may move the dependent vertex based on an instruction of the user of the processing system SYS. Specifically, the user may use the input apparatus 224 to input, to the control information generation apparatus 22, an instruction for moving the dependent vertex. In this case, the output apparatus 225, which is configured to serve as the display apparatus, may display the reference model RM. Especially, the output apparatus 225, which is configured to serve as the display apparatus, may display the dependent vertex of the reference model RM. The user may use the input apparatus 224 to move the dependent vertex displayed on the output apparatus 225. In this case, it can be said that the user sets the deformed amount of the reference model RM.

On the other hand, as illustrated in FIG. 20, the control information generation unit 2211 does not move the fixed vertex. Namely, a position of the fixed vertex is fixed even when the control vertex and the dependent vertex move.

As a result of the operation illustrated in FIG. 17, as illustrated in FIG. 20, the deformed reference model RM is generated as the deformation model TM. In this case, as can be seen from FIG. 16 and FIG. 20, the difference model DM generated from the deformation model TM may typically include at least a part of the deformed dependent model part MPA#3.

As described above, the control information generation unit 2211 deforms the control model part MPA#2 of the reference model RM so that the control model part MPA#2 of the reference model RM moves to the position of a model part corresponding to the control model part MPA#2 of the object model OM. In other words, the control information generation unit 2211 deforms the reference model RM such that difference between a three-dimensional shape of the control model part MPA#2 on a surface of the reference model RM and a three-dimensional shape of a part, which corresponds to the control model part MPA#2, of a surface of the object model OM becomes small.

Incidentally, as described in the explanation of step S4 in FIG. 12, the deformation model TM (i.e., the deformed reference model RM) may be referred to as the target model. It can be said that the control information generation unit 2211 deforms the reference model RM so that difference between a three-dimensional shape of the control model part MPA#2 on a surface of the reference model RM and a three-dimensional shape of a part, which corresponds to the control model part MPA#2, of a surface of the object model OM becomes small, in order to generate the deformed model TM, which may also be called the target model.

### (2-2-5) Operation to Generate the Deformation Model TM by Deforming the Object Model OM

The control information generation apparatus 22 (e.g., the control information generation unit 2211) may generate the deformed object model OM as the deformation model TM by deforming at least a part of the object model OM in the step S4 of FIG. 12. In this case, the control information generation unit 2211 can generate the deformation model TM even when the reference model RM cannot be acquired in the step S3 of FIG. 12.

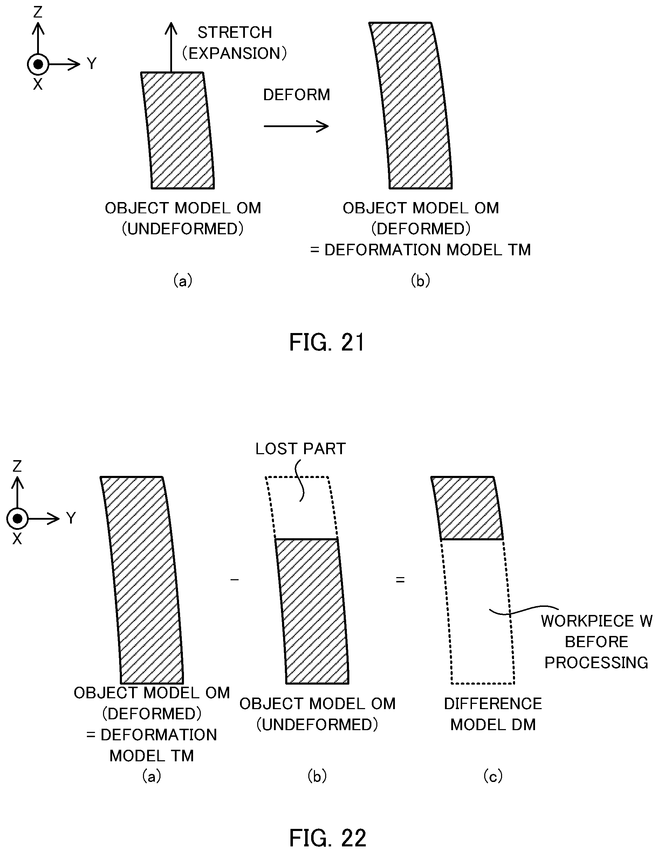

The control information generation unit 2211 may deform the object model OM such that at least a part of the object model OM is stretched, as illustrated in FIG. 21 illustrating the deformed object model OM. In other words, the control information generation unit 2211 may deform the object model OM such that at least a part of the object model OM is enlarged. For example, the control information generation unit 2211 may deform the object model OM such that a first object plane of the object model OM, which faces a predetermined direction, uniformly moves by a desired distance. As one example, FIG. 21 illustrates an example where the control information generation unit 2211 deforms the object model OM such that the upper surface of the object model OM (e.g., the surface opposite the fiducial part, which is the bottom surface) uniformly moves by a desired distance. Specifically, FIG. 21 illustrates an example where the control information generation unit 2211 deforms the object model OM such that its upper surface uniformly moves a desired distance along the normal direction of said upper surface. In this case, it can be said that the control information generation unit 2211 deforms the object model OM to elongate it in the lengthwise direction. As another example, the control information generation unit 2211 may deform the object model OM such that the surfaces other than the top and bottom surfaces (e.g., the side surfaces) uniformly move by a desired distance. The control information generation unit 2211 may deform the object model OM such that the surfaces other than the top and bottom surfaces (e.g., the side surfaces) uniformly move a desired distance along the normal direction of the respective surface. In this case, it can be said that the control information generation unit 2211 is deforming the object model OM to stretch it in the width direction.

The control information generation unit 2211 may deform the object model OM such that at least a part of the object model OM shrinks. In other words, the control information generation unit 2211 may deform the object model OM such that at least a part of the object model OM is reduced in size. For example, the control information generation unit 2211 may deform the object model OM such that it shrinks in the length direction. For example, the control information generation unit 2211 may deform the object model OM such that it shrinks in the width direction. Incidentally, when the entire object model OM is stretched or shrunk, it may be said that the object model OM is being scaled.

Furthermore, when the object model OM is deformed such that a first surface uniformly moves by a desired distance, the control information generation unit 2211 may deform the object model OM such that a second surface of the object model OM, which is different from and connected to the first surface, follows the movement of the first surface. In the example illustrated in FIG. 21, the control information generation unit 2211 deforms the object model OM such that the side surface (specifically, the upper edge of the side surface connected to the top surface) moves upward (typically, extends) in response to the upward movement of the top surface of the object model OM.

The control information generation unit 2211 may generate the deformed model TM by removing a part of the object model OM after deforming the object model OM such that the first surface of the object model OM moves a distance longer than the desired distance. For example, control information generation unit 2211 may remove a part of object model OM by performing a Boolean operation (e.g., a difference Boolean operation) between the deformed object model OM and a model assumed to be the surface shape of deformation model TM.

Even when the deformed model TM is generated by deforming the object model OM in this manner, as illustrated in FIG. 22, the control information generation unit 2211 may generate a three-dimensional model corresponding to difference between the deformed model TM and the object model OM as a difference model DM. In other words, the control information generation unit 2211 may generate a three-dimensional model corresponding to the difference between the deformed model TM generated by deforming the object model OM and the undeformed object model OM as a difference model DM.

Incidentally, the control information generation unit 2211 may generate a three-dimensional model corresponding to difference between the deformed object model OM and the undeformed object model OM. The control information generation unit 2211 may generate the difference model DM by performing a Boolean operation between the generated three-dimensional model and a model assumed to represent the surface shape of the deformation model TM. This configuration reduces the processing load on the control information generation unit 2211 compared to performing a Boolean operation between the deformed object model OM and the model assumed to represent the surface shape of the deformation model TM.

Through this operation, the control information generation unit 2211 can easily generate the deformation model TM by deforming the object model OM as illustrated in FIG. 21, under conditions where the upper surface of the workpiece W (e.g., the tip of a turbine blade) is uniformly worn. Therefore, the control information generation unit 2211 can generate the difference model DM without acquiring the reference model RM.

On the other hand, if a crack has formed on the upper surface of the workpiece W or if the upper surface of the workpiece W is partially worn, simply deforming the object model OM as illustrated in FIG. 21 may result in the deformed object model OM potentially being unusable as a deformation model TM that accurately represents the target shape of the workpiece W. In this case, the control information generation unit 2211 may designate a part of the upper surface of the object model OM as a first surface to be deformed and designate another part of the upper surface of the object model OM as a second surface not to be deformed. As a result, even if a crack exists on the upper surface of the workpiece W or the upper surface of the workpiece W is partially worn, the control information generation unit 2211 can generate a deformation model TM that accurately represents the target shape of the workpiece W by deforming a part of the upper surface of the object model OM.

Incidentally, depending on the three-dimensional shape of the workpiece W, the degree of correspondence between the part of the deformed model TM generated by deforming the object model OM and the object model OM itself may not be sufficient. In this case, the control information generation unit 2211 may further deform the deformed model TM generated by deforming the object model OM to match the object model OM. By configuring the system in this manner, when the degree of matching between the part of the deformation model TM corresponding to the object model OM and the object model OM itself is insufficient, the degree of matching between the two can be improved. Furthermore, in this case, a Boolean operation may be performed between the deformation model TM, further deformed to match the object model OM, and the model assumed as the surface shape of the deformation model TM. In other words, a Boolean operation may be performed after two deformations are performed on the object model OM.

For example, as illustrated in FIG. 21, the control information generation unit 2211 may first generate the deformation model TM by deforming the object model OM such that its upper surface uniformly moves a desired distance in the Z-direction. Subsequently, the control information generation unit 2211 may further deform the deformation model TM such that at least a part of the deformation model TM moves in at least one of the X-direction and the Y-direction, so that the three-dimensional shape of the part of the deformation model TM corresponding to the object model OM approaches the three-dimensional shape of the object model OM.

Incidentally, if the difference model DM is generated by deforming the object model OM, the reference model RM need not be acquired as described above. Therefore, the processing of the step S3 in the flowchart illustrated in FIG. 13 (i.e., acquiring the reference model RM) need not be performed. In other words, in this case, after the processing of the step S2 in the flowchart of FIG. 13, the processing of the step S4 may be performed.

Incidentally, the differential model DM may be generated by deforming the reference model RM. In this case, the control information generation unit 2211 may deform the reference model RM to match the object model OM. The control information generation unit 2211 may generate a three-dimensional model corresponding to the difference between the deformed reference model RM and the object model OM. The control information generation unit 2211 may generate the difference model DM by performing a Boolean operation between the generated three-dimensional model and the model assumed to be the deformation model TM.

### (3) Inspection after Building

Next, the inspection after building is described. "After building" may mean after the three-dimensional structure ST has been built by the processing apparatus 1, controlled based on the processing control information generated, for example, in the step S6 of FIG. 12. The following description gives as an example the inspection after the processing apparatus 1 has built the three-dimensional structure ST capable of filling the missing part of the item requiring repair.

### (3-1) Operation Flow of the Processing System SYS

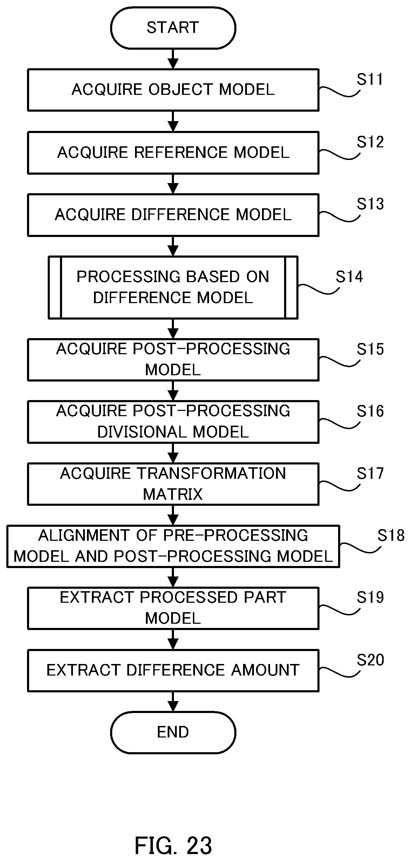

With reference to FIG. 23, the operation flow of the processing system SYS of this example embodiment will be described. FIG 23 is a flowchart that illustrates the operation flow of the processing system SYS according to the example embodiment. Incidentally, the start condition for the operation of the processing system SYS illustrated in the flowchart of FIG. 23 may include, for example, the user of the processing system SYS inputting an instruction indicating the start of processing via an input apparatus.

As illustrated in FIG. 23, the control information generation unit 2211 of the measurement system 2 of the processing system SYS acquires an object model OM (a step S11). Parallel to or in conjunction with the operation of the step S11, the control information generation unit 2211 acquires a reference model RM (a step S12).

Subsequently, the control information generation unit 2211 acquires a difference model DM based on the object model OM and the reference model RM (step a S13). The difference model DM may be a three-dimensional model corresponding to the difference between the object model OM and the reference model RM. The difference model DM may also be a three-dimensional model corresponding to the difference between the object model OM and a deformation model TM generated by deforming the reference model RM (in other words, the deformed reference model RM). Incidentally, the step S12 may be omitted, and the difference model DM may be acquired based on the object model OM (the step S13). In this case, the difference model DM may also be a three-dimensional model corresponding to the difference between the object model OM and the deformed model TM (in other words, the deformed object model OM) acquired by deforming the object model OM.

Subsequently, the control information generation unit 2211 generates processing control information based on the difference model DM. The processing apparatus 1 of the processing system SYS builds a three-dimensional structure ST having a desired shape based on the generated processing control information (a step S14). Since the processing control information is generated based on the difference model DM, the processing apparatus 1 building the three-dimensional build object ST based on the processing control information can be said to be processing based on the difference model DM.

Incidentally, at least a part of the operations from the step S11 to the step S14 in FIG. 23 corresponds to at least a part of the control information generation operation illustrated in the flowchart of FIG. 12. Therefore, a detailed description of the operations from the step S11 to the step S14 is omitted.

After the operation of the step S14, the workpiece W processed by the processing apparatus 1 (e.g., where a three-dimensional structural object ST has been formed) may be removed from the processing apparatus 1. The removed workpiece W may be transported from the processing apparatus 1 to the measurement system 2 by the transport device 3. Alternatively, the workpiece W may be transported from the measurement apparatus 2 to the processing apparatus 1 by a user of the processing system SYS. The workpiece W transported to the measurement apparatus 2 is installed (i.e., placed or mounted) on the measurement apparatus 2. At this time, the workpiece W may be transported while still attached to the holding tool.

The shape measurement apparatus 21 of the measurement system 2 measures the three-dimensional shape of the workpiece W after processing. As a result, the shape measurement apparatus 21 generates measurement information indicating the three-dimensional shape of the workpiece W after processing. The shape measurement apparatus 21 outputs (e.g., transmits) the generated shape information to the control information generation device 22. The shape information may be any type of information capable of directly or indirectly indicating the actual three-dimensional shape of the workpiece W. For example, the shape information may be point cloud information indicating the actual three-dimensional shape of the workpiece W using a plurality of points.

Incidentally, the processing of the step S15 may be performed continuously with the processing of the step S14. Alternatively, after the processing of the step S14, the operation of the processing system SYS may be temporarily interrupted. The processing of the step S15 may then be performed. A condition for performing the processing of the step S14 and the processing of the step S15 consecutively may include the workpiece W after processing being installed on the measurement system 2. In other words, if the workpiece W after processing is in a state where it cannot be measured by the measurement system 2 (e.g., a state where the workpiece W after processing is not placed on the measurement system 2, a state where the three-dimensional shape of the workpiece W cannot be acquired due to its characteristics, a state where the measurement system 2 is damaged, etc.), the operation of the processing system SYS may be temporarily interrupted after the processing of the step S14 (in other words, the transition from the step S14 to the step S15 may be interrupted). If the operation of the processing system SYS is interrupted after the processing of the step S14, the operation of the system SYS may be resumed when predetermined restart conditions are satisfied (i.e., the processing of the step S15 may be performed). The predetermined restart conditions may include, for example, at least one of the following: the workpiece W after processing being placed on the measurement system 2, and an input being made indicating that an inspection of the workpiece W after processing is to be performed.

Incidentally, in the step S15, any measurement apparatus different from the shape measurement apparatus 21 may measure the three-dimensional shape of the workpiece W after processing. For example, a measurement apparatus placed outside the measurement system 2 may measure the three-dimensional shape of the workpiece W after processing. For example, a measurement apparatus placed outside the processing system SYS may measure the three-dimensional shape of the workpiece W after processing. The arbitrary measurement apparatus outputs (e.g., transmits) the generated measurement information to the control information generation apparatus 22. Incidentally, the measurement conditions when the workpiece W before processing is measured in the step S1 of FIG. 12 may be the same as the measurement conditions when the post-processing workpiece W is measured.

Then, the control information generation unit 2211 of the control information generation apparatus 22 generates a post-processing model PM representing the actual three-dimensional shape of the workpiece W after processing based on the generated measurement information. In other words, the control information generation unit 2211 generates model information representing the post-processing model PM. As a result, the control information generation unit 2211 acquires the post-processing model PM (the step S15).

The control information generation apparatus 22 may control an output apparatus 225, which can function as a display apparatus, to display the post-processing model PM generated in the step S15. A user of the processing system SYS may operate the post-processing model PM displayed on the output apparatus 225 using the input apparatus 224. For example, the user may perform operations using the input apparatus 224 to change the display mode of the post-processing model PM displayed on the output apparatus 225. As one example, the user may use the input apparatus 224 to perform an operation to rotate the post-processing model PM displayed on the output apparatus 225. As another example, the user may use the input apparatus 224 to perform an operation to change the display size of the post-processing model PM displayed on the output apparatus 225.

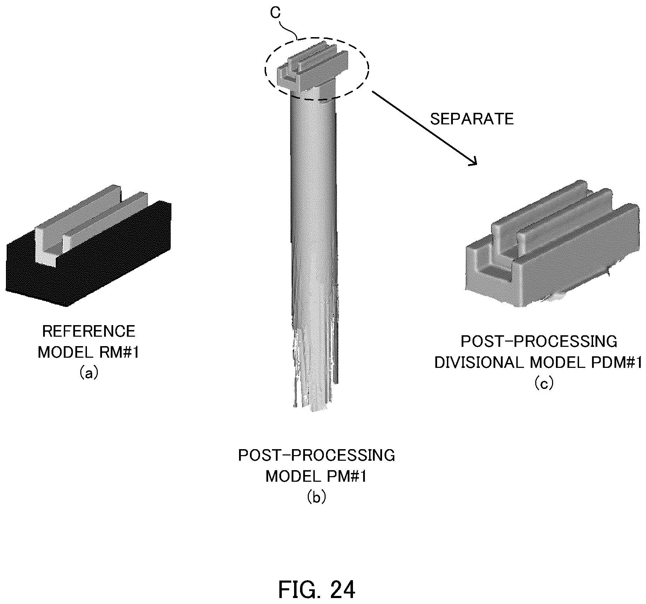

The control information generation unit 2211 may acquire the part of the post-processing model PM corresponding to the reference model RM as a post-processing divisional model PDM (a step S16). The operation of the step S16 is explained with reference to FIG. 24. FIG. 24(a) is a diagram that illustrates an example of the reference model RM, namely a reference model RM#1. FIG. 24(b) is a diagram that illustrates an example of the post-processing model PM, namely a post-processing model PM#1. FIG. 24(c) is a diagram that illustrates an example of the post-processing divisional model PDM, namely a post-processing divisional model PDM#1. Incidentally, the reference model RM#1 may be a three-dimensional model corresponding to the deformed model TM (in other words, the reference model RM after deformation). Alternatively, the object model OM may be used instead of the reference model RM (e.g., the reference model RM#1).

In the step S16, the control information generation unit 2211 may align the reference model RM#1 with the post-processing model PM#1 such that the reference model RM#1 and the part of the post-processing model PM#1 corresponding to the reference model RM#1 (see dashed circle C in FIG. 24) coincide.

The control information generation unit 2211 may align the reference model RM#1 with the post-processing model PM#1 based on the user's instruction of the processing system SYS. Specifically, the user may input instructions to the control information generation apparatus 22 for aligning the reference model RM#1 and the processed model PM#1 using the input apparatus 224. In this case, the output apparatus 225, which can function as a display apparatus, may display the reference model RM#1 and the processed model PM#1. The user may align the reference model RM#1 and the processed model PM#1 by moving at least one of the reference model RM#1 and the processed model PM#1 displayed by the output apparatus 225 using the input apparatus 224.

The control information generation unit 2211 may align the reference model RM#1 and the processed model PM#1 by performing a matching process using the reference model RM#1. The matching process itself may be similar to existing matching processes. Therefore, a detailed description of the matching process is omitted, but an overview is provided below. The matching process using the reference model RM#1 may also be referred to as a three-dimensional matching process.

The control information generation unit 2211 may, for example, translate, scale, and/or rotate the reference model RM#1 so that at least some of the plurality of feature points of the three-dimensional shape indicated by the reference model RM#1 approach (typically, match) at least some of the plurality of feature points of the three-dimensional shape indicated by the post-processing model PM#1. In other words, the control information generation unit 2211 may change the positional relationship between the coordinate system of the reference model RM#1 and the coordinate system of the post-processing model PM#1 so that at least some of the plurality of feature points of the three-dimensional shape indicated by the reference model RM#1 approach (typically match) at least some of the plurality of feature points of the three-dimensional shape indicated by the post-processing model PM#1. The control information generation unit 2211 may change the positional relationship between the coordinate system of the reference model RM#1 and the coordinate system of the post-processing model PM#1.

Incidentally, the control information generation unit 2211 may perform the matching process using the reference model RM#1 after aligning the reference model RM#1 and the post-processing model PM#1 based on the user's instruction. In other words, the control information generation unit 2211 may perform detailed alignment between the reference model RM#1 and the processed model PM#1 by first performing a rough alignment between them based on user instructions, followed by a matching process using the reference model RM#1.

Based on the results of the alignment between the reference model RM#1 and the post-processing model PM#1, the control information generation unit 2211 may acquire the post-processing divisional model PDM#1 by dividing (or extracting) the part of the post-processing model PM#1 corresponding to the reference model RM#1 from the post-processing model PM#1.

Incidentally, the post-processing divisional model PDM also represents a part of the actual three-dimensional shape of the workpiece W after processing. Therefore, the post-processing divisional model PDM may also be referred to as a post-processing model. As explained with reference to FIG. 24, the post-processing divisional model PDM, which may also be referred to as a post-processing model, may be acquired by dividing (or extracting) the result showing the three-dimensional shape of the part corresponding to the reference model RM from the result acquired when the measurement system 2 measures the workpiece W after processing (e.g., the post-processing model PM). In other words, the post-processing divisional model PDM may be acquired by acquiring results showing the three-dimensional shape of a part of the workpiece W after processing corresponding to the reference model RM from the results acquired by the measurement system 2 when measuring the workpiece W after processing. As mentioned above, the reference model RM is a model showing the three-dimensional shape of a part of the workpiece W before it is actually used. The workpiece W before processing may be the workpiece W (e.g., a turbine blade) after it has been actually used. In this case, the workpiece W before processing may be referred to as a repair item.

It can be said that aligning the reference model RM#1 with the post-processing model PM#1 is changing the positional relationship between a coordinate system of the reference model RM#1 and a coordinate system of the post-processing model PM#1 so that corresponding parts of the reference model RM#1 and the post-processing model PM#1 coincide. The control information generation unit 2211 may acquire a transformation matrix TM#1 for altering the positional relationship between the coordinate system of the reference model RM#1 and the coordinate system of the post-processing model PM#1 by performing the alignment between the reference model RM#1 and the post-processing model PM#1.

Incidentally, the processing system SYS (e.g., control information generation unit 2211) need not perform the operation of the step S16. In other words, the processing system SYS need not acquire the post-processing divisional model PDM. Incidentally, acquiring the post-processing divisional model PDM in the step S16 reduces the computational load when performing the operations described in a step S17 and a step S18 below. Moreover, for example, when comparing the post-processing divisional model PDM with the object model OM in the step S18, noise can be reduced compared to when the post-processing model PM is compared with the object model OM. Here, "noise" may refer to part, which do not correspond to the three-dimensional build object ST formed by the processing apparatus 1 based on the processing control information, within difference between the post-processing divisional model PDM or the post-processing model PM and the object model OM. When the workpiece W is a turbine blade, holes formed on the side surface of the turbine blade according to the design, for example, can be cited as an example of the above noise. In other words, by acquiring the post-processing divisional model PDM, it is possible to suppress extraction of holes formed on the side surface of the turbine blade according to the design, for example, as part of the difference.

Incidentally, the reference model RM#1 may include an area that is not a target of alignment with the post-processing model PM#1. This area may be referred to as a non-alignment-target area or a non-alignment area.

For example, the control information generation unit 2211 may set the non-alignment-target area or the non-alignment area based on an instruction of a user of the processing system SYS. Specifically, the user may input the instruction for setting the non-alignment-target area or the non-alignment area in the reference model RM#1 to the control information generation apparatus 22 using the input apparatus 224. In this case, the output apparatus 225, which can function as a display apparatus, may display the reference model RM#1. The user may perform instructing for setting the non-alignment-target area or the non-alignment area by instructing an area, that corresponds to the non-alignment-target area or the non-alignment area, of the reference mode RM#1 displayed by the output apparats 225, by using the input apparatus 224. Alternatively, the control information generation unit 2211 may automatically set the non-alignment-target area or the non-alignment area according to a predetermined condition without using the user's instruction.

For example, the control information generation unit 2211 may set a part, that is to be targeted by alignment with the post-processing model PM#1, (i.e., a part other than the non-alignment-target area or the non-alignment area) of the reference model RM#1 based on an instruction of the user of the processing system SYS. Specifically, the user may input an instruction to the control information generation apparatus 22 using the input apparatus 224 to set the part, that is the target of alignment with the post-processing model PM#1, of the reference model RM#1. Alternatively, the control information generation unit 2211 may automatically set the part, that is the target of alignment with the post-processing model PM#1, of the reference model RM#1 according to a predetermined condition without using a user instruction. In this case, the control information generation unit 2211 may set a part, that is a part other than a part targeted for alignment with the post-processing model PM#1, of the reference model RM#1 as the non-alignment-target area or the non-alignment area. Incidentally, the non-alignment-target area or the non-alignment area may be displayed in an arbitrary color tone (e.g., black) on the reference model RM#1 displayed by the output apparatus 225.

Thus, by limiting the part, that is used for alignment with the post-processing model PM#1, of the reference model RM#1, the computational load associated with aligning the reference model RM#1 and the post-processing model PM#1 can be reduced. Incidentally, the non-alignment-target area of the non-alignment area may not be set.

Returning to FIG. 23 again, the control information generation unit 2211 acquires a transformation matrix for aligning the post-processing divisional model PDM (or the post-processing model PM) with the object model OM (the step S17). Incidentally, the object model OM is a three-dimensional model representing the three-dimensional shape of the workpiece W before the processing apparatus 1 builds the three-dimensional structural object ST based on the processing control information. Therefore, the object model OM may also be referred to as the pre-processing model. Consequently, the transformation matrix acquired in the step S17 can be described as the transformation matrix for aligning the post-processing divisional model PDM (or the post-processing model PM) with the object model OM, which may also be referred to as the pre-processing model.

Incidentally, the correspondence between the post-processing divisional model PDM (or the post-processing model PM) and the object model OM may be performed by the user of the processing system SYS. Alternatively, the correspondence between the post-processing divisional model PDM (or the post-processing model PM) and the object model OM may be performed automatically by the control information generation unit 2211.

In the step S17, the control information generation unit 2211 may acquire a first transformation matrix for changing the positional relationship between the coordinate system of the reference model RM and the coordinate system of the post-processing divisional model PDM (or the coordinate system of the post-processing model PM). The transformation matrix TM#1 described above corresponds to one example of the first transformation matrix. Incidentally, if the operation of the step S16 is not performed (in other words, if the post-processing divisional model PDM is not acquired), the control information generation unit 2211 may acquire the first transformation matrix in the step S17 by performing positional alignment between the reference model RM and the post-processing model PM.

As described above, it can be said that acquiring the post-processing divisional model PDM is acquiring a result indicating a three-dimensional shape of a part of the post-processed workpiece W. It can be said that the first transformation matrix (e.g., the transformation matrix TM#1) acquired during the process of acquiring the post-processing divisional model PDM is information when the result indicating the three-dimensional shape of the part of the post-processed workpiece W is acquired.

The control information generation unit 2211 may acquire a second transformation matrix for changing the positional relationship between the coordinate system of the reference model RM and the coordinate system of the object model OM. The control information generation unit 2211 may acquire the second transformation matrix by performing alignment between the reference model RM and the object model OM.

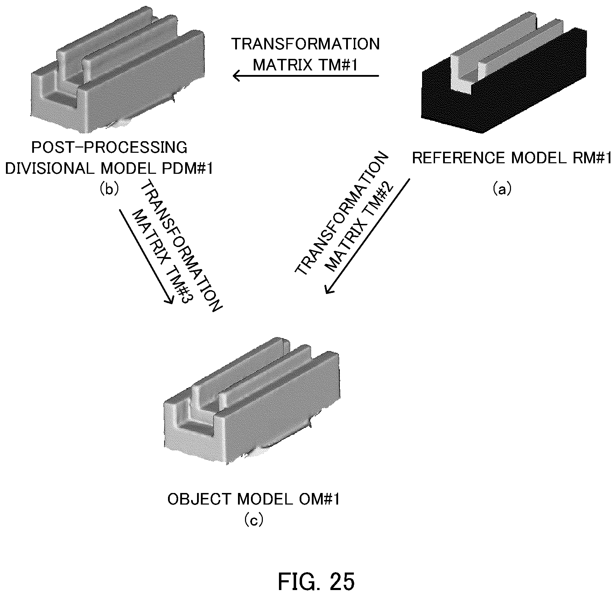

Alignment between the reference model RM and the object model OM will be further described with reference to FIG, 25. FIG. 25(a) is a figure that illustrates the reference model RM#1 as an example of the reference model RM. FIG. 25(b) is a figure that illustrates the post-processing divisional mode PDM#1 as an example of the post-processing divisional model PDM. FIG. 25(c) is a figure that illustrates the object mode OM#1 as an example of the object model OM. Incidentally, the reference model RM#1 may be a three-dimensional model corresponding to the deformation model TM (in other words, the deformed reference model RM).

The control information generation unit 2211 may align the reference model RM#1 with the object model OM#1 based on an instruction of the user of the processing system SYS. Specifically, the user may input the instruction to the control information generation apparatus 22 for aligning the reference model RM#1 and the object model OM#1 using the input apparatus 224. In this case, the output apparatus 225, which can function as a display apparatus, may display the reference model RM#1 and the object model OM#1. The user may align the reference model RM#1 and the object model OM#1 by moving at least one of the reference model RM#1 and the object model OM#1 displayed by the output apparatus 225 using the input apparatus 224.

The control information generation unit 2211 may align the reference model RM#1 and the object model OM#1 by performing a matching process using the reference model RM#1. The matching process itself may be the same as an existing matching process. Therefore, a detailed description of the matching process is omitted.

Incidentally, the control information generation unit 2211 may perform alignment between the reference model RM#1 and the object model OM#1 by performing the matching process using the reference model RM#1 after aligning the reference model RM#1 with the object model OM#1 based on an instruction of the user. In other words, the control information generation unit 2211 may perform detailed alignment between the reference model RM#1 and the object model OM#1 by performing the matching process using the reference model RM#1 after rough aligning between the reference model RM#1 and the object model OM#1 based on the instruction of the user.

It can be said that aligning the reference model RM#1 and the object model OM#1 is changing the positional relationship between the coordinate system of the reference model RM#1 and the coordinate system of the object model OM#1 so that corresponding parts of the reference model RM#1 and the object model OM#1 match. The control information generation unit 2211 may acquire a transformation matrix TM#2 for changing the positional relationship between the coordinate system of the reference model RM#1 and the coordinate system of the object model OM#1 by performing the alignment between the reference model RM#1 and the object model OM#1. This transformation matrix TM#2 corresponds to an example of the second transformation matrix described above.

Incidentally, the control information generation unit 2211 may acquire the second transformation matrix in the aforementioned the step S13 (corresponding to the step S4 and the step S5 in FIG. 12). For example, the control information generation unit 2211 may align the object model OM with the reference model RM to acquire the difference model DM. The control information generation unit 2211 may acquire the second transformation matrix by aligning the object model OM with the reference model RM.

For example, the control information generation unit 2211 may align the object model OM with the reference model RM to acquire the deformation model TM (i.e., the deformed reference model RM). The control information generation unit 2211 may acquire the second transformation matrix by aligning the object model OM with the reference model RM. In this case, the control information generation unit 2211 may generate the deformation model TM by deforming the reference model RM to match the three-dimensional shape indicated by the object model OM. As described above, the deformation model TM may also be referred to as the target model. Therefore, it can be said that the second transformation matrix is the information acquired when generating the deformation model TM as the target model.

Incidentally, as described with reference to FIG. 21 and FIG. 22, when the difference model DM is generated by deforming the object model OM without using the reference model RM, the control information generation unit 2211 may acquire the second transformation matrix in a process different from the processing in the step S13. In this case, the control information generation unit 2211 need not acquire the second transformation matrix. If the control information generation unit 2211 does not acquire the second transformation matrix, it may perform alignment between the post-processing divisional model PDM (or the post-processing model PM) and the object model OM without using the second transformation matrix.

The control information generation unit 2211 may acquire a third transformation matrix based on the first transformation matrix and the second transformation matrix for aligning the post-processing divisional model PDM (or the post-processing model PM) with the object model OM. As described above, the first transformation matrix is a transformation matrix for changing the positional relationship between the coordinate system of the reference model RM and the coordinate system of the post-processing divisional model PDM (or the coordinate system of the post-processing model PD). The second transformation matrix is a transformation matrix for changing the positional relationship between the coordinate system of the reference model RM and the coordinate system of the object model OM. Therefore, based on the first transformation matrix and the second transformation matrix, the control information generation unit 2211 can acquire the third transformation matrix for changing the positional relationship between the coordinate system of the post-processing divisional model PDM (or the coordinate system of the post-processing model PD) and the coordinate system of the object model OM (in other words, to align the post-processing divisional model PDM (or the post-processing model PM) with the object model OM). For example, the control information generation unit 2211 may acquire the third transformation matrix by performing the multiplication of the first transformation matrix and the second transformation matrix.

Returning to FIG. 23 again, the control information generation unit 2211 performs alignment between the post-processing divisional model PDM (or the post-processing model PM) and the object model OM using the transformation matrix (e.g., the third transformation matrix) acquired through the operation of the step S17 (the step S18). As described above, the object model OM may also be referred to as the pre-processing model. Therefore, it can be said that in the operation in the step S18, alignment between the post-processing divisional model PDM (or the post-processing model PM) and the pre-processing model is performed.

Alignment between the post-processing divisional model PDM and the object model OM will be further described with reference to FIG. 25. The control information generation unit 2211 may acquire a transformation matrix TM#3 for aligning the post-processing divisional model PDM#1 with the object model OM#1 based on the transformation matrix TM#1 and the transformation matrix TM#2. Incidentally, the transformation matrix TM#3 corresponds to one example of the third transformation matrix described above. The control information generation unit 2211 performs the alignment between the post-processing divisional model PDM#1 and the object model OM#1 using the transformation matrix TM#3.

As described above, the transformation matrix TM#1, as an example of the first transformation matrix, may be acquired by performing the alignment between the reference model RM#1 and the post-processing model PD#1. Furthermore, the transformation matrix TM#2, as an example of the second transformation matrix, may be acquired by performing the alignment between the reference model RM#1 and the object model OM#1. Errors occur both in the alignment between the reference model RM#1 and the post-processing model PD#1, and in the alignment between the reference model RM#1 and the object model OM#1. Therefore, when aligning the post-processing divisional model PDM#1 with the object model OM#1 using the transformation matrix TM#3, the aforementioned errors may cause a part of the post-processing divisional model PDM#1 to fail to match the corresponding part of the object model OM#1.

Therefore, the control information generation unit 2211 may perform detailed alignment between the post-processing divisional model PDM#1 and the object model OM#1 using existing techniques, such as the ICP algorithm, after performing the alignment using the transformation matrix TM#3.

Incidentally, the control information generation unit 2211 need not perform the alignment between the post-processing divisional model PDM and the object model OM using the third transformation matrix described above. In this case, the control information generation unit 2211 may perform the alignment between the post-processing divisional model PDM and the object model OM using existing techniques such as the ICP algorithm.

However, the third transformation matrix is calculated based on the first transformation matrix and the second transformation matrix already acquired in operations prior to the step S18. Therefore, using the third transformation matrix reduces the overall computational load of the operations illustrated in the flowchart of FIG. 23.

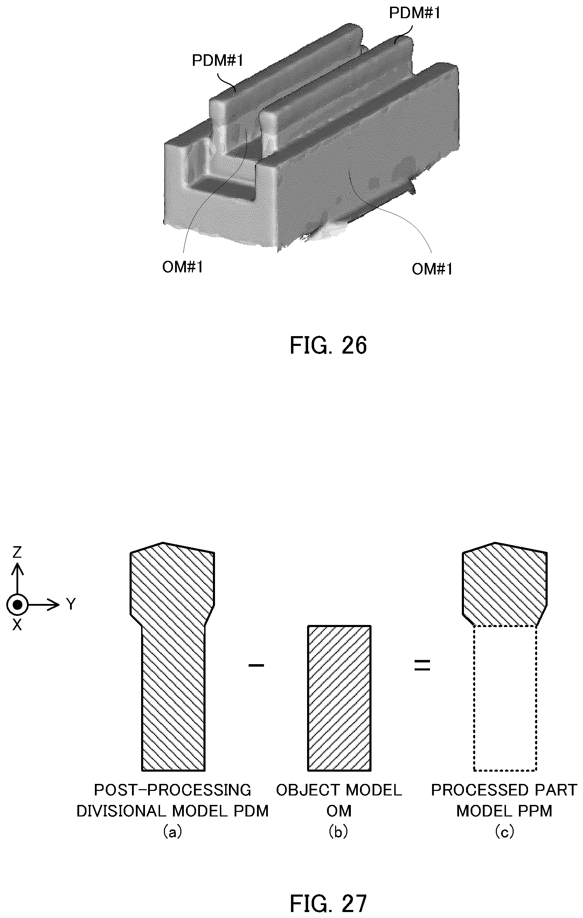

The control information generation apparatus 22 may control an output apparatus 225, which can function as a display apparatus, to display the post-processing divisional model PDM (or the post-processing model PM) and the object model OM that were aligned in the step S18. As a result, the output apparatus 225 may display, for example, an image as illustrated in FIG. 26. FIG. 26 is a figure that illustrates an example of the aligned post-processing divisional model and object model.

The user of the processing system SYS may operate the image displayed on the output apparatus 225 using the input apparatus 224. For example, the user may perform operations using the input apparatus 224 to change the display mode of the image displayed on the output apparatus 225. As one example, the user may perform operations using the input apparatus 224 to change the display size of the image displayed on the output apparatus 225.

Returning to FIG. 23 again, the control information generation unit 2211 acquires a processed part model PPM representing a three-dimensional shape corresponding to the difference between the aligned post-processing divisional model PDM (or post-processing model PM) and the object model OM (a step S19).

The operation of the step S19 will be further described with reference to FIG. 27. FIG. 27(a) is a figure that schematically illustrates the post-processing divisional model PDM. FIG. 27(b) is a figure that schematically illustrates the object model OM. FIG. 27(c) is a figure that schematically illustrates the processed part model PPM.

The control information generation unit 2211 acquires the processed part model PPM based on the object model OM acquired in the step S11 and the post-processing divisional model PDM acquired in the step S16 (or the post-processing model PM acquired in the step S15). For example, the control information generation unit 2211 may acquire the processed part model PPM (see FIG. 27(c)) as a three-dimensional model corresponding to the difference between the post-processing segmentation model PDM illustrated in FIG. 27(a) and the object model OM illustrated in FIF. 27(b).

A specific example of the operation in the step S19 will be further described. In the step S18, after the post-processing divisional model PDM (or the post-processing model PM) and the object model OM are aligned in a predetermined coordinate space, the control information generation unit 2211 may extract a plurality of points, as extracted points Pext, satisfying a predetermined distance condition from among the plurality points included in the post-processing divisional model PDM (or the post-processing model PM). Specifically, the control information generation unit 2211 may extract points, as extracted points Pext, satisfying the condition that an inter-model distance D1 between one point of the post-processing divisional model PDM (or the post-processing model PM) and one point of the object model OM closest to that point is greater than or equal to an inter-model distance threshold TH_M.

The plurality of extracted points Pext satisfying the predetermined distance condition correspond to the difference between the post-processing divisional model PDM (or the post-processing model PM) and the object model OM. The plurality of extracted points Pext indicate the three-dimensional shape of the difference between the post-processing divisional model PDM (or the post-processing model PM) and the object model OM. Therefore, the control information generation unit 2211 may generate a processed part model PPM based on the plurality of extracted points Pext.

The control information generation apparatus 22 may control the output apparatus 225, which is functionable as a display apparatus, to display an extracted point display image 61 for displaying the extracted plurality of extracted points Pext. As a result, the output apparatus 225 may display the extracted point display image 61.

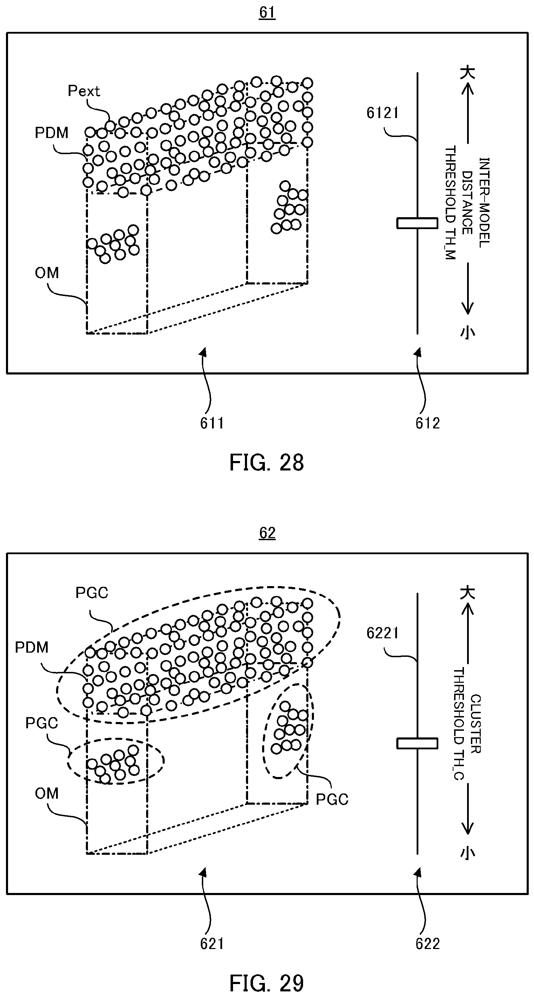

An example of the extracted point display image 61 is illustrated in FIG. 28. As illustrated in FIG. 28, the extracted point display image 61 may include a display image 611 for displaying the plurality of extracted points Pext. In the display image 611 illustrated in FIG. 28, the plurality of extracted points Pext are displayed in three dimensions within a predetermined coordinate space. However, a display method different from that illustrated in FIG. 28 may be used for displaying the plurality of extracted points Pext within the display image 611.

In display image 611, the plurality of extracted points Pext may be displayed together with at least one of the post-processing divisional model PDM and the object model OM. In the example illustrated in FIG. 28, the plurality of extracted points Pext are displayed together with both the post-processing divisional model PDM and the object model OM in display image 611.

The control information generation apparatus 22 may change the display mode of a group of display objects, including the plurality of extracted points Pext displayed in the display image 611, based on an input of the user using the input apparatus 224. For example, the control information generation apparatus 22 may translate the display objects within a predetermined coordinate space defined within the display image 611. For example, the control information generation apparatus 22 may rotate the display object within a predetermined coordinate space defined within the display image 611. For example, the control information generation apparatus 22 may enlarge or reduce the display object within a predetermined coordinate space defined within the display image 611.

The extracted point display image 61 may include a display image 612 containing an operation object 6121 operable by the user to adjust the inter-model distance threshold TH_M used to extract the extracted point Pext. In this case, the user may adjust (i.e., set or change) the inter-model distance threshold TH_M by operating the operation object 6121 using the input apparatus 224.

In the example illustrated in FIG. 28, a slider (i.e., a slider bar) is used as the operable object 6121. In this case, the user may adjust the inter-model distance threshold TH_M to increase it by performing an operation to move the slider in a first direction (e.g., the upward direction in FIG. 28). On the other hand, the user may adjust the inter-model distance threshold TH_M to decrease it by performing an operation to move the slider in a second direction opposite to the first direction (e.g., the downward direction in FIG. 28).

Incidentally, a display object other than a slider may be used as the operation object 6121. For example, the operation object 6121 may be a display object capable of specifying one candidate value to be set as the inter-model distance threshold TH_M from among a plurality of candidate values for the inter-model distance threshold TH_M. Examples of such display objects include at least one of a combo box, a drop-down list, and a radio button.

The input apparatus 224 used by the user to operate the operation object 6121 may be configured to accept user input for operating the operation object 6121. For example, the input apparatus 224 may be configured to accept at least one of slide input, pinch input, and spin input. In this case, the user may adjust the inter-model distance threshold TH_M by performing at least one of slide input, pinch input, and spin input.

The plurality of extracted points Pext extracted as described above may include extracted points Pext that do not indicate a difference between the post-processing divisional model PDM (or the post-processing model PM) and the object model OM. In other words, the plurality of extracted points Pext may include extracted points Pext that constitute noise and should not be used to generate the processed part model PPM.

The control information generation unit 2211 may perform clustering on the plurality of extracted points Pext after extracting them. Specifically, the control information generation unit 2211 may generate at least one point cloud cluster PGC by performing clustering on the plurality of extracted points Pext. Specifically, the control information generation unit 2211 may generate at least one point cloud cluster PGC by classifying two extracted points Pext into the same point cloud cluster PGC if a distance D2 between the two extracted points Pext satisfies the condition of being less than or equal to a predetermined cluster threshold TH_C. Subsequently, the control information generation unit 2211 may generate a processed part model PPM based on at least one point cloud cluster PGC.

In this case, it can be said that clustering the plurality of extracted points Pext is a process, in which a labeling process of connected components in a graph is applied to a point cloud, and a process classifying each extracted point Pext into a cluster, considering two extracted points Pext separated by the distance D2 less than or equal to the cluster threshold TH_C as connected. The point cloud cluster PGC may also be referred to as a cluster region. The control information generation unit 2211 may omit performing clustering of the plurality of extracted points Pext.

The control information generation apparatus 22 may control the output apparatus 225, which is capable of functioning as a display apparatus, to display a point cloud cluster display image 62 for displaying at least one generated point cloud cluster PGC. As a result, the output apparatus 225 may display the point cloud cluster display image 62.

An example of the point cloud cluster display image 62 is illustrated in FIG. 29. As illustrated in FIG. 29, the point cloud cluster display image 62 may include a display image 621 for displaying at least one generated point cloud cluster PGC. In the display image 621 illustrated in FIG. 29, at least one point cloud cluster PGC is displayed in three dimensions within a predetermined coordinate space. However, a display method different from that illustrated in FIG. 29 may be used for displaying at least one point cloud cluster PGC within the display image 621.

In display image 621, at least one point cloud cluster PGC may be displayed together with at least one of the post-processing divisional model PDM and the object model OM. In the example illustrated in FIG. 29, at least one point cloud cluster PGC is displayed together with both the post-processing divisional model PDM and the object model OM in display image 621.

The control information generation apparatus 22 may change the display mode of a group of display objects, including at least one point cloud cluster PGC displayed in the display image 621, based on user input using the input apparatus 224. For example, the control information generation apparatus 22 may translate the display objects within a predetermined coordinate space defined within the display image 621. For example, the control information generation apparatus 22 may rotate the display object within a predetermined coordinate space defined within the display image 621. For example, the control information generation apparatus 22 may scale the display object within a predetermined coordinate space defined within the display image 621.

The point cloud cluster display image 62 may include a display image 622 containing an operable object 6221 that the user can operate to adjust the cluster threshold TH_C used to generate the point cloud cluster PGC. In this case, the user may adjust (i.e., set or change) the cluster threshold TH_C by operating the operation object 6221 using the input apparatus 224.

In the example illustrated in FIG. 29, a slider (i.e., a slider bar) is used as the operable object 6221. In this case, the user may adjust the cluster threshold TH_C to increase it by performing an operation to move the slider in a first direction (e.g., the upward direction in FIG. 29). On the other hand, the user may adjust the cluster threshold TH_C to decrease it by performing an operation to move the slider in a second direction opposite to the first direction (e.g., the downward direction in FIG. 29).

Incidentally, a display object other than a slider may be used as the operation object 6221. For example, the operation object 6221 may be a display object capable of specifying one candidate value to be set as the cluster threshold TH_C from among a plurality of candidate values for the cluster threshold TH_C. Examples of such display objects include at least one of a combo box, a drop-down list, and a radio button.

The input apparatus 224 used by the user to operate the operation object 6221 may be configured to accept an input of the user for operating the operation object 6221. For example, input apparatus 224 may be configured to accept at least one of slide input, pinch input, and spin input. In this case, the user may adjust cluster threshold TH_C by performing at least one of slide input, pinch input, and spin input.

Returning to FIG. 23 again, the control information generation unit 2211 acquires the difference between the differential model DM and the processed part model PPM based on the differential model DM acquired in the step S13 and the processed part model PPM acquired in the step S19. This difference is the difference between the three-dimensional build object ST actually fabricated by the processing apparatus 1 based on the processing control information derived from the difference model DM and the difference model DM itself. The control information generation unit 2211 extracts the amount of difference between the processed part model PPM and the difference model DM based on the acquired difference (a step S20). Incidentally, if the processing system SYS (e.g., the control information generation unit 2211) did not perform the operation of the step S16, control information generation unit 2211 may extract the difference amount between the post-processing model PM and the difference model DM (the step S20).

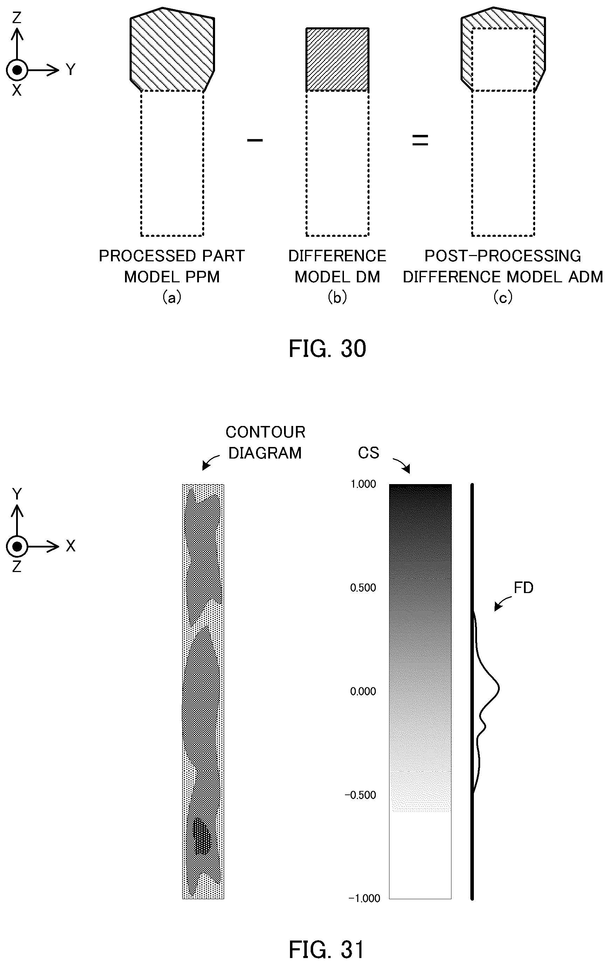

The operation of the step S20 will be described with reference with FIG. 30. FIG. 30(a) is a figure that schematically illustrates the processed part model PPM. FIG. 30(b) is a figure that schematically illustrates the difference model DM. FIG. 30(c) is a figure that schematically illustrates the post-processing difference model ADM.

For example, the control information generation unit 2211 may extract a three-dimensional model corresponding to the difference between the processed part model PPM illustrated in FIG. 30(a) and the difference model DM illustrated in FIG, 30(b) as the post-processing difference model ADM (see FIG. 30(c)).

In the step S20, operations similar to those described in the step S19 may be performed. In other words, the control information generation unit 2211 may extract a plurality of points, as extracted points, satisfying a predetermined distance condition from among the plurality of points included in the machined part model PPM. Specifically, the control information generation unit 2211 may extract points, as the extracted points, that satisfy the condition that the distance between one point in the processed part model PPM and one point in the differential model DM closest to that point is greater than or equal to an inter-model distance threshold.

The plurality of extracted points satisfying predetermined distance conditions correspond to the difference between the processed part model PPM and the difference model DM. Therefore, the control information generation unit 2211 may acquire the post-processing difference model ADM based on the plurality of extracted points. In this case, the control information generation apparatus 22 may control the output apparatus 225, which is capable of functioning as a display device, to display an extracted point display image for displaying the plurality of extracted points. As a result, the output apparatus 225 may display an extraction point display image similar to the aforementioned extraction point display image 61. This extracted point display image may include a display image containing an operable object that the user can manipulate to adjust the inter-model distance threshold used for extracting the extracted points.

Alternatively, the control information generation unit 2211 may perform clustering of the plurality of extracted points after extracting them. Specifically, the control information generation unit 2211 may generate at least one point cloud cluster by performing clustering of the plurality of extracted points. Specifically, the control information generation unit 2211 may generate at least one point cloud cluster by classifying two extracted points into the same point cloud cluster if the distance between the two extracted points satisfies a condition of being less than or equal to a predetermined cluster threshold. Subsequently, the control information generation unit 2211 may acquire a post-processing difference model ADM based on at least one point cloud cluster. In this case, the control information generation apparatus 22 may control the output apparatus 225, which is functionable as a display apparatus, to display a point cloud cluster display image for displaying the generated at least one point cloud cluster. As a result, the output apparatus 225 may display a point cloud cluster display image similar to the aforementioned point cloud cluster display image 62. This point cloud cluster display image may include a display image containing an operable object that the user can manipulate to adjust the cluster threshold used to generate the point cloud clusters.

The control information generation unit 2211 may extract the distance between one point included in the post-processing difference model ADM (i.e., one of the plurality of extracted points described above) and one point in the difference model DM closest to that one point as a difference amount.

The control information generation unit 2211 generates difference information regarding the difference between the processed part model PPM and the difference model DM based on the difference amount extracted in the step S20. Moreover, the control information generation unit 2211 may generate a plurality of pieces of difference information for each direction in which a difference occurs. For example, in the example illustrated in FIG. 30, the control information generation unit 2211 may generate difference information for the X-direction, difference information for the Y-direction, and difference information for the Z-direction.

The control information generation unit 2211 may generate display data for displaying the difference indicated by the difference information in a predetermined manner based on the difference information. An example of the predetermined manner is a contour diagram (e.g., see FIG. 31). The contour diagram may be colored with colors that change gradually based on the difference amount extracted in the step S20 (in other words, the difference between the processed part model PPM and the difference model DM). Therefore, the display data for displaying the contour diagram can be said to be display data for displaying the difference indicated by the difference information according to the difference amount.

Incidentally, the contours of the areas within the contour diagram that are colored may be the same as the contours of the post-processing difference model ADM when viewed from a predetermined direction. In this case, the control information generation unit 2211 may include data within the display data for displaying at least a part of the three-dimensional shape indicated by the post-processing difference model ADM.

Incidentally, the control information generation unit 2211 may change the color applied to the contour diagram for each direction in which a difference occurs. For example, control information generation unit 2211 may generate display data, in which colors applied to a contour diagram based on the difference information for the X-direction, a contour diagram based on the difference information for the Y-direction and a contour diagram based on the difference information for the Z-direction are different from each other, such that the user of the processing system SYS can distinguish between the contour diagram based on the difference information for the X-direction, the contour diagram based on the difference information for the Y-direction and the contour diagram based on the difference information for the Z-direction. Incidentally, the control information generation unit 2211 may generate display data in which at least one character or graphic (e.g., an arrow) indicating the direction in which the difference occurs is displayed together with the contour diagram, instead of or in addition to changing the color applied to the contour diagram for each direction in which a difference occurs.

In other words, the control information generation unit 2211 may generate display data for displaying the difference information in a predetermined manner according to the direction in which the difference between the processed part model PPM and the difference model DM, indicated by the difference information, has occurred.

Incidentally, when extracting the difference amount described above, the control information generation unit 2211 may extract the difference amount using the deformed difference model DM and the post-processing difference model ADM after deforming the difference model DM.

For example, the control information generation unit 2211 may deform the difference model DM by removing one or more points from the plurality of points (i.e., point cloud) constituting the difference model DM. For example, the control information generation unit 2211 may remove one or more points corresponding to corners of the difference model DM from the plurality of points constituting the difference model DM.

For example, the control information generation unit 2211 may deform the difference model DM by applying processing to blunt the corners of the difference model DM (in other words, a process to round the corners). The processing to blunt the corners of the difference model DM may be, for example, at least one of smoothing processing (in other words, smoothing processing) applied to the three-dimensional model, and using a low-pass filter in the frequency domain.

Measurement of the workpiece W by the measurement system 2 is subject to spatial resolution limitations, for example, due to sensor pixel pitch. Consequently, the measurement results of the workpiece W by the measurement system 2 (e.g., the post-processing model PM, the post-processing divisional model PDM, the processed part model PPM, etc.) may not accurately reproduce the actual three-dimensional shape of the workpiece W. For example, even if an actual corner of the workpiece W (i.e., the boundary part between one face of the workpiece W and another face adjacent to that face) has a sharp shape, the measurement result of the workpiece W by the measurement system 2 may render the corner of the workpiece W with a blunter shape than the actual shape.

On the other hand, since the differential model DM is an ideal shape of the workpiece W generated by calculation, sharp corners are represented as sharp corners in the differential model DM. Therefore, even if the actual three-dimensional shape of the workpiece W (e.g., the shape of the corner) matches or is extremely close to the three-dimensional shape indicated by the difference model DM, when the measurement results of the workpiece W acquired by the measurement system 2 are compared with the difference model DM, it is possible that a difference exceeding the tolerance range will be determined.

Therefore, the control information generation unit 2211 may deform the difference model DM by removing one or more points from the plurality of points constituting the difference model DM, or by applying a processing to the difference model DM to blunt the corners of the difference model DM. Subsequently, the control information generation unit 2211 may extract the difference amount using the deformed difference model DM and the post-processing difference model ADM (i.e., an example of the measurement result of the workpiece W by the measurement system 2). With this configuration, it is possible to suppress the determination that a difference exceeding the allowable range exists when the actual three-dimensional shape of the workpiece W (e.g., the shape of the corners) matches or is extremely close to the three-dimensional shape indicated by the differential model DM.

Subsequently, the control information generation apparatus 22 may control the output apparatus 225, which is capable of functioning as a display apparatus, to perform a display based on the display data generated by the control information generation section 2211. As a result, the output apparatus 225 may display a contour diagram (see FIG. 31) illustrating a contour diagram as a display based on the display data. The contour diagram represents the post-processing difference model ADM as viewed from a predetermined direction. For example, the contour diagram in FIG. 31 represents the post-processing difference model ADM as viewed from the Z-direction.

As illustrated in FIG. 31, the output apparatus 225 may display, together with the contour diagram, a color scale CS indicating the relationship between the colors in the contour diagram and the amount of difference between the processed part model PPM and the difference model DM. In this case, the display data may include information concerning the color scale CS. The difference amount indicated alongside the color scale CS may represent the range of difference amounts extracted in the step S20. When the range of difference amounts is "1.000" to "-1.000", the range may be displayed in segments such as "1.000", "0.500", "0.000", "-0.500", and "-1.000", as illustrated in FIG. 31. Incidentally, the divisions of the difference amount range need not be equal. For example, as illustrated in FIG. 31, the output apparatus 225 may display the frequency distribution FD of the difference values along with the contour diagram. Incidentally, in the frequency distribution FD, the line segments extending vertically in FIG. 31 indicate points with zero frequency. In this case, the display data may include information regarding the frequency distribution FD of the difference values. In the frequency distribution FD illustrated in FIG. 31, the frequency is high near a difference amount of 0.000. In this case, it can be said that the three-dimensional structural object was built substantially as intended by the additive processing. The control information generation unit 2211 may generate display data containing data for displaying at least one of the color scale CS and the frequency distribution FD.

Incidentally, either the difference model DM or the post-processing model PM (or the post-processing divisional model PDM) may be displayed alongside the contour diagram. In other words, the control information generation unit 2211 may generate display data containing data for displaying at least one of the difference model DM and the post-processing model PM (or the post-processing divisional model PDM).

The control information generation unit 2211 may generate processing control information based on the post-processing difference model ADM in parallel with generating the display data. The processing control information generated based on the post-processing difference model ADM is processing control information for bringing the three-dimensional build object ST, formed by the processing apparatus 1 in the step S14, closer to (typically, matching) the three-dimensional shape indicated by the differential model DM. In this case, the control information generation unit 2211 may determine the processing conditions included in the processing control information based on the differential information. In other words, the control information generation unit 2211 may change the processing conditions from those in the step S14 based on the difference information. Since the processing apparatus 1 is controlled based on the processing control information, it can be said that the control information generation unit 2211 determining (or changing) the processing conditions based on the difference information is equivalent to the control information generation unit 2211 performing feedback control of the processing apparatus 1.

The processing apparatus 1 may perform at least one of removal processing, which removes a part of the three-dimensional structure ST formed in the step S14 based on processing control information generated based on the post-processing difference model ADM, and additive processing, which forms a build object on the three-dimensional structure ST.

As described above, in the operation illustrated in the flowchart of FIG. 23 (specifically, steps S18 to S20), the processed part model PPM, which indicates the difference between the post-processing divisional model PDM (or the post-processing model PM) and the object model MO, is extracted (or generated). Subsequently, the post-processing difference model ADM, which indicates the difference between the processed part model PPM and the difference model DM, is extracted (or generated).

In the operation of extracting (or generating) the post-processing difference model ADM from the post-processing divisional model PDM (or the post-processing model PM), as illustrated in FIG. 27 and FIG. 30, it can be said that parts corresponding to the object model OM and the difference model DM, respectively, are removed from the post-processing divisional model PDM (or the post-processing model PM).

Here, the difference model DM is a three-dimensional model showing the difference between the reference model RM or the transformed model TM (i.e., the transformed reference model RM) and the object model OM. Therefore, it can be said that the difference model DM combined with the object model OM is equivalent to the reference model RM or the transformed model TM.

Therefore, the control information generation unit 2211 may extract (or generate) the post-processing difference model ADM based on the post-processing divisional model PDM (or the post-processing model PM) and the reference model RM or the transformed model TM (i.e., the transformed reference model RM), instead of performing steps S18 to S20 in FIG. 23. In other words, the control information generation unit 2211 may extract (or generate) the post-processing difference model ADM as a three-dimensional model showing the difference between the post-processing divisional model PDM (or the post-processing model PM) and the reference model RM or the deformed model TM (i.e., the deformed reference model RM).

### (3-2) Other Methods for Generating Difference Information

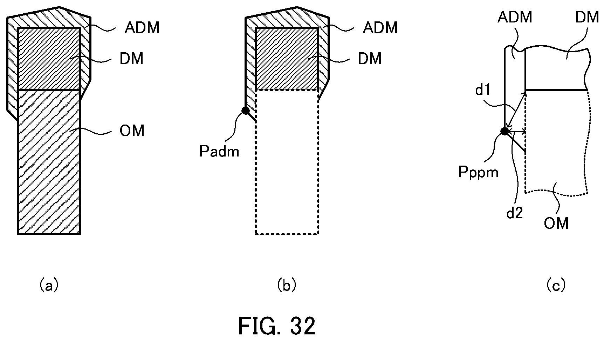

As a result of the processing apparatus 1 performing additive processing based on the processing control information, a three-dimensional structural object may be built on the side surface of the pre-processed workpiece W (corresponding to the object model OM in FIG. 32(a)), for example, as illustrated in FIG. 32(a) (see the post-processing difference model ADM in FIG. 32(a)). In this case, as described above, extracting the distance between a point contained in the post-processing difference model ADM and a point in the differential model DM closest to that point as the differential amount presents the following issue.

For example, the distance between the point Pppm (see FIG. 32(b)) included in the post-processing difference model ADM and one point in the difference model DM closest to that point Pppm is a distance d1 (see FIG. 32(c)). On the other hand, the distance between the point Pppm and the point on the object model OM closest to the point Pppm is a distance d2 (see FIG. 32(c)). Incidentally, distances d1 and d2 correspond to examples of the aforementioned differential amount.

Here, the combined three-dimensional shape formed by the three-dimensional shape represented by the object model OM and the three-dimensional shape represented by the differential model DM corresponds to at least one of the reference model RM and the deformation model TM, which are the target shapes of the workpiece W after processing (e.g., see FIG. 9 and FIG. 22). Therefore, it can be said that the distance d2 is the distance between the point Pppm and one point on the target shape that is closest to the point Pppm.

Even though the difference between the point Pppm and the target shape is the distance d2, if the distance between one point included in the post-processing difference model ADM and one point in the difference model DM closest to that point is extracted as the difference amount, the difference amount for the point Pppm becomes the distance d1.

If the distance d1 exceeds the allowable range for the difference amount while the distance d2 is within that allowable range, the point Pppm may be evaluated as, for example, "excessively built up." In other words, the point Pppm, which should normally be evaluated as within the allowable range, may be erroneously evaluated as, for example, "excessively built up."

Therefore, the control information generation unit 2211 may calculate a first distance between a point (e.g., the point Pppm) included in the post-processing difference model ADM and a point in the difference model DM closest to that point, and a second distance between a point included in the post-processing difference model ADM and a point in the object model OM closest to that point. The control information generation unit 2211 may extract the shorter of the first distance and the second distance as the difference amount.

Alternatively, the control information generation unit 2211 may extract the distance between a point included in the post-processing difference model ADM (e.g., the point Pppm) and a point in the reference model RM or the deformation model TM closest to that point as the difference amount.

Incidentally, the control information generation unit 2211 may generate a composite model corresponding to at least one of the reference model RM and the deformation model TM by synthesizing the object model OM and the difference model DM instead of using the reference model RM or the deformation model TM. In this case, the control information generation unit 2211 may extract the distance between a point (e.g., the point Pppm) included in the post-processing difference model ADM and a point in the composite model closest to said one point as the aforementioned difference amount.

Incidentally, when the object model OM and the difference model DM are mesh models (e.g., polygonal mesh models), the control information generation unit 2211 may perform a remeshing process on the composite model after generating it by synthesizing the object model OM and the difference model DM. This configuration reduces mesh errors arising from the synthesis of the object model OM and the difference model DM.

The control information generation unit 2211 may generate difference information regarding the difference between the processed part model PPM and the difference model DM based on the extracted difference amount as described above. This configuration suppresses the possibility of erroneous evaluation for a single point (e.g., the point Pppm) contained in the post-processing difference model ADM. As a result, it is possible to appropriately detect, for example, parts within the post-processing difference model ADM that are evaluated as "excessively built-up."

For example, as illustrated in FIG. 8 and FIG. 9, when the processing apparatus 1 performs additive processing to build a three-dimensional structure ST on the upper part of a workpiece W, a part of which is defected,, the three-dimensional structure ST built may be slightly larger than the size of the three-dimensional shape indicated by the difference model DM. In other words, the size of the built three-dimensional structure ST may be intentionally made larger than the size of the three-dimensional shape indicated by the differential model DM. In this case, the control information generation unit 2211 may generate processing control information such that, for example, the difference between the size of the three-dimensional structure ST and the size of the three-dimensional shape indicated by the difference model DM is within an allowable range, and the size of the three-dimensional structure ST is larger than the size of the aforementioned three-dimensional shape.

In this case, the control information generation unit 2211 may generate processing control information for removing a part of the built three-dimensional build object ST such that a size of the three-dimensional build object ST built based on the difference information relating to the difference between the processed part model PPM and the difference model DM closes to a size (in other words, a design value) of the three-dimensional shape indicated by the difference model DM..

### (3-3) Display Example of Inspection Result

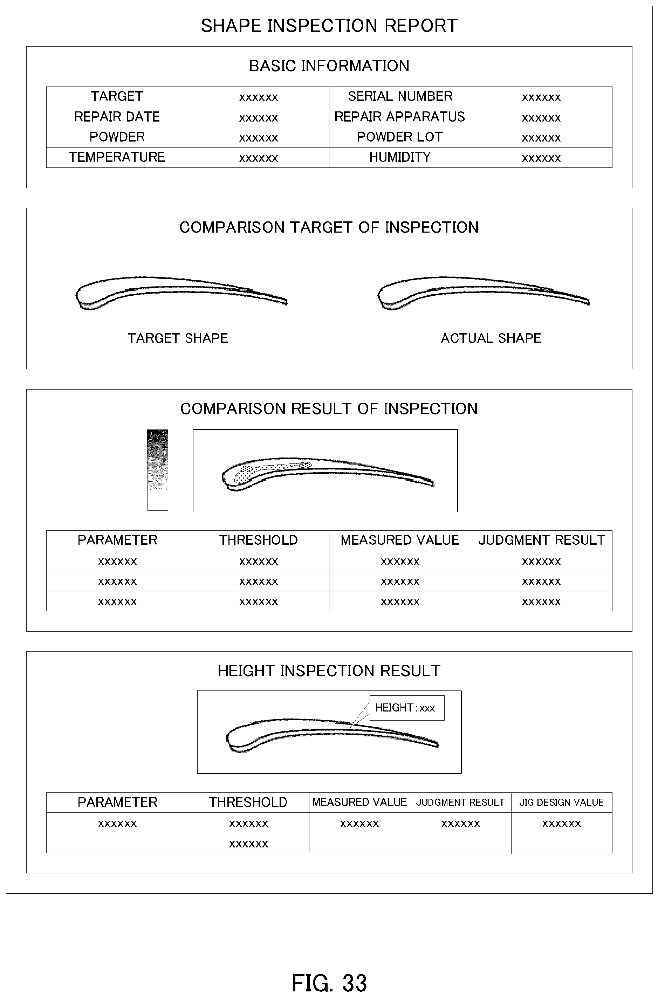

A display example of inspection result will be described with reference to FIG. 33. As described above, the control information generation apparatus 22 may control the output apparatus 225, which can function as a display apparatus, to perform a display based on display data generated by the control information generation unit 2211. The output apparatus 225 may display an inspection information image as a display based on the display data.

As an example of an inspection information image, the shape inspection report illustrated in FIG. 33 may be displayed. The shape inspection report may include display items such as "Basic Information," "Comparison Target of Inspection," "Comparison Result of Inspection," and "Height Inspection Result." Incidentally, the shape inspection report may not include the "Height Inspection Result." Incidentally, the shape inspection report may include only the "Comparison Result of Inspection." Incidentally, the shape inspection report may also include other display items in addition to "Basic Information," "Comparison Target of Inspection," "Comparison Result of Inspection," and "Height Inspection Result." For example, storage apparatus 222 may store at least one of a file and a data structure for displaying the shape inspection report illustrated in FIG. 33 on the output apparatus 225 as a display apparatus.

The "Basic Information" may include information indicating the target and information indicating the processing conditions. Here, the "target" corresponds to the workpiece W, which is the processing target of the processing apparatus 1 and the measurement target of the measurement system 2. Examples of information indicating the target include information indicating the target's name or type designation, and information for identifying the target (e.g., a serial number). Examples of information indicating processing conditions include information indicating date and time, information indicating the processing apparatus, information regarding materials, information regarding temperature, and information regarding humidity. As an example of information indicating date and time, the "repair date" illustrated in FIG. 33 can be cited. As an example of information indicating date and time, the processing date and time indicating when the workpiece W was processed by the processing system SYS can be cited. As information indicating the processing apparatus, information for identifying the repair apparatus corresponding to the processing system SYS can be cited. Information concerning materials includes, for example, information indicating the type of powder and information indicating the powder lot. Information concerning temperature includes, for example, at least one of the ambient air temperature, the temperature of the atmosphere inside the apparatus, and the temperature of the workpiece W surface during processing. Information concerning humidity includes, for example, at least one of the ambient air humidity and the humidity of the atmosphere inside the apparatus. Incidentally, the information included in the "basic information" may be input by the user of the processing system SYS, and items other than those exemplified may be added as appropriate.

The "inspection comparison targets" may include the target shape of the target and the actual shape of the target. The target shape of the target may correspond to the three-dimensional shape of either the reference model RM or the deformation model TM (in other words, the reference model RM after deformation). The target shape of the target may also be a three-dimensional shape corresponding to the difference model DM. The actual shape of the target may be a three-dimensional shape corresponding to either the post-processing model PM or the post-processing divisional model PDM. The actual shape of the target may also be a three-dimensional shape corresponding to the processed part model PPM.

The "Comparison Results of Inspections" may include contour plots, color scale CS, and frequency distribution FD (FIG. 31) based on the aforementioned differential information. The "comparison results of the inspection" may also include information indicating an evaluation of at least one of the parameters related to the shape of the target and the parameters related to the processing. The parameters related to the shape of the target include, for example, at least one of the size, curvature, weight, and material of the build object. The parameters related to the processing may include, for example, at least one of the following: the target size, target shape, target weight, material of the build object; the size, shape, weight, and material of support members added during processing; information regarding the laser power and spot diameter used during processing; the temperature of the workpiece surface during processing; and information regarding the size and shape of the supplied build material. The parameters related to the shape of the target and the parameters related to the processing may partially overlap. The information indicating the evaluation may include one or more of the following: a threshold as a tolerance limit, an actual measured value based on differential information, and a determination result based on the threshold and the actual measured value.

The "height inspection result" may include height information and an image showing the three-dimensional shape of the target. Such an image may be generated based on at least one of, for example, the post-processing model PM, the post-processing divisional model PDM, and the post-processed part model PPM. The "height inspection result" may include information indicating an evaluation concerning the maximum height of the target. This evaluation information may include one or more of a threshold, the measured value (i.e., the maximum height), a determination result based on the threshold and the measured value, and the fixture design value.

For example, if the measured value for a parameter is within the threshold, the judgment result may display "OK" or "Acceptable". For example, if the measured value for a parameter exceeds the threshold, the judgment result may display "NG" or "Excessive". The judgment result may, for example, indicate the degree of agreement between the measured value and the threshold for a single parameter. For example, if the measured value and the threshold for a single parameter are equal, the judgment result may display "0". For example, if the measured value for a parameter is less than the threshold, the determination result may display a value corresponding to the difference between the measured value and the threshold (e.g., "-20"). For example, if the measured value for a parameter is greater than the threshold, the determination result may display a value corresponding to the difference between the measured value and the threshold (e.g., "+10").

When the user of the processing system SYS superimposes a cursor (e.g., a mouse cursor) onto the image using the input apparatus 224, the height of the target at the superimposed cursor position may be displayed. For example, the control information generation apparatus 22 may acquire cursor position information indicating the position of the cursor as an instruction of the user. The control information generation apparatus 22 may identify the part of the three-dimensional shape illustrated by the image corresponding to the position indicated by the cursor position information based on the cursor position information. The control information generation apparatus 22 may identify the height of the identified part based on the height information. The control information generation apparatus 22 may control the output apparatus 225, functionable as a display device, to display at least one of characters, graphics, and images indicating the identified height.

Incidentally, the three-dimensional shape of the target contained in the above image may be translated, enlarged, reduced, and/or rotated according to the instructions of the user via the input apparatus 224. Moreover, an arbitrary cross-section of the three-dimensional shape of the target may be displayed according to the instructions of the user via the input apparatus 224.

### (3-4) Height Information Calibration Operation

The height information possessed by the three-dimensional model (e.g., at least one of the object model MO and the post-processing model PD) generated by the measurement system 2 measuring the workpiece W does not necessarily match the height information possessed by the CAD model corresponding to the workpiece W. Therefore, when comparing the above three-dimensional model with the CAD data, it may be difficult for the user of the processing system SYS to recognize the correspondence between the above three-dimensional model and the CAD data.

By the way, the workpiece W is often measured by the measurement system 2 while the workpiece W is held in a predetermined jig. In this case, the three-dimensional model generated by the measurement system 2 measuring the workpiece W includes a part corresponding to at least part of the jig. Moreover, the top surface of the CAD model corresponding to the jig is often set to be perpendicular to the Z-axis (i.e., the height direction) (in other words, parallel to the XY plane (i.e., the horizontal plane)).

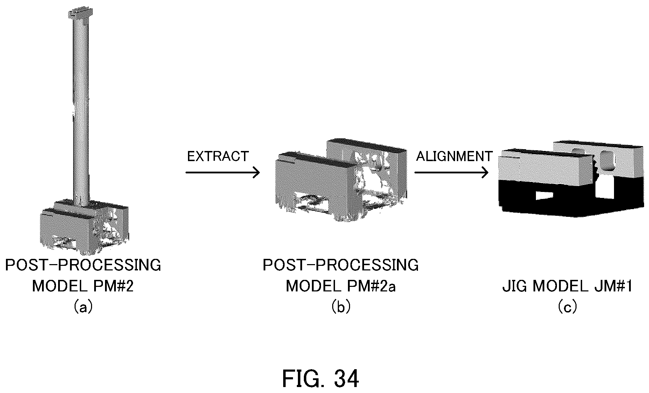

A method for calibrating the height information possessed by the three-dimensional model using the three-dimensional model generated by the measurement system 2 measuring the workpiece W held in the jig and the CAD model corresponding to the jig will be described with reference to FIG. 34. FIG. 34(a) is a figure that illustrates a post-processing model PM#2 as another example of the post-processing model PM. FIG. 34(b) is a figure that illustrates a post-processing model PM#2a, which is a part of the post-processing model PM#2 illustrated in FIG. 34(a). FIG. 34(c) is a figure that illustrates a jig model JM#1 as an example of a CAD model corresponding to the jig.

The control information generation apparatus 2211 may extract the post-processing model PM#2a, which is the part of the post-processing model PM#2 corresponding to the jig, based on instructions of the user of the processing system SYS. Specifically, the user may input instructions to the control information generation apparatus 22 using the input apparatus 224 to specify the part of the post-processing model PM#2 corresponding to the jig. In this case, the output apparatus 225, which can function as a display apparatus, may display the post-processing model PM#2. The user may provide the above instructions by specifying the part corresponding to the jig on the post-processing model PM#2 displayed by the output apparatus 225 using the input apparatus 224.

Incidentally, the post-processing model PM#2 may be point cloud information indicating the actual three-dimensional shape of the workpiece W held in the jig using a plurality of points. In this case, the control information generation unit 2211 may extract the post-processing model PM#2a by extracting the plurality of points included in the part corresponding to the jig from the post-processing model PM#2.

Next, the control information generation unit 2211 may align the post-processing model PM#2a with the jig model JM#1. The control information generation unit 2211 may align the post-processing model PM#2a with the jig model JM#1 based on instructions of the user of the processing system SYS. Specifically, the user may input instructions to the control information generation apparatus 22 for aligning the post-processing model PM#2a and the jig model JM#1 using the input apparatus 224. In this case, the output apparatus 225, which can function as a display apparatus, may display the post-processing model PM#2a and the jig model JM#1. The user may align the post-processing model PM#2a and the jig model JM#1 by moving at least one of the post-processing model PM#2a and the jig model JM#1 displayed by the output apparatus 225 using the input apparatus 224.

The control information generation unit 2211 may align the post-processing model PM#2a and the jig model JM#1 by performing a matching process using the jig model JM#1. The matching process itself may be the same as an existing matching process. Therefore, a detailed description of the matching process is omitted.

Incidentally, the control information generation unit 2211 may align the post-processing model PM#2a with the jig model JM#1 based on instructions of the user, and then perform a matching process using the jig model JM#1 to align the post-processing model PM#2a with the jig model JM#1. In other words, based on instructions of the user, the control information generation unit 2211 may perform a rough alignment between the post-processing model PM#2a and the jig model JM#1, and then perform a detailed alignment between the post-processing model PM#2a and the jig model JM#1 by using the jig model JM#1 for the matching process.

It can be said that performing alignment between the post-processing model PM#2a and the jig model JM#1 is changing the positional relationship between the coordinate system of the post-processing model PM#2a and the coordinate system of the jig model JM#1 so that the post-processing model PM#2a and the jig model JM#1 coincide. The control information generation unit 2211 may acquire a transformation matrix TM#4 for changing the positional relationship between the coordinate system of the post-processing model PM#2a and the coordinate system of the jig model JM#1 by performing the alignment between the post-processing model PM#2a and the jig model JM#1.

The coordinate system of the post-processing model PM#2a and the coordinate system of the post-processing model PM#2 are the same. Therefore, using the transformation matrix TM#4 enables alignment between the post-processing model PM#2 and the jig model JM#1.

The control information generation unit 2211 may align the post-processing model PM#2 with the jig model JM#1 using the transformation matrix TM#4. After performing the alignment between the post-processing model PM#2 and the jig model JM#1 using the transformation matrix TM#4, the control information generation unit 2211 may further perform alignment between the post-processing model PM#2 and the jig model JM#1 using existing techniques, such as an ICP algorithm.

Then after, based on the results of the alignment between the post-processing model PM#2 and the jig model JM#1, the control information generation unit 2211 may identify the part of the post-processing model PM#2 corresponding to the top surface of the jig indicated by the jig model JM#1. The control information generation unit 2211 may calibrate the height of the identified part (e.g., the height indicated by the height information of the post-processing model PM#2) based on the height information possessed by the jig model JM#1. Specifically, the control information generation unit 2211 may modify the height information possessed by the post-processing model PM#2 such that the height of the specified part becomes equal to the height of the top surface of the jig indicated by the jig model JM#1.

As a result, the modified height information (in other words, the calibrated height information) becomes the same as the height information possessed by the CAD model corresponding to the workpiece W having the three-dimensional shape indicated by the post-processing model PM#2. In other words, the above operation enables the height information possessed by the three-dimensional model generated by the measurement system 2 measuring the workpiece W (e.g., at least one of the object model MO and the post-processing model PD) to be made consistent with the height information possessed by the CAD model corresponding to the workpiece W.

For example, the height displayed in the "height inspection result" illustrated in FIG. 32 may be the height indicated by the calibrated height information (in other words, the modified height information) acquired through the above-described operation.

For example, the control information generation apparatus 22 may control the output apparatus 225, which can function as a display apparatus, to display a post-processing model PM (e.g., the post-processing model PM#2) having the calibrated height information. As a result, the output apparatus 225 may display the post-processing model PM.

The control information generation apparatus 22 may further acquire cursor position information indicating the position of a cursor (e.g., a mouse cursor) as an instruction of the user of the processing system SYS. In other words, the control information generation apparatus 22 may acquire cursor position information indicating the cursor's position on the screen where the post-processing model PM is displayed as an instruction of the user. The control information generation apparatus 22 may identify a part of the post-processing model PM corresponding to the position indicated by the cursor position information based on the cursor position information. The control information generation apparatus 22 may identify the height of the identified part based on calibrated height information. The control information generation apparatus 22 may control the output apparatus 225 to display at least one of characters, graphics, and images indicating the identified height. As a result, for example, the output apparatus 225 may display the height of the post-processing model PM in the area where the post-processing model PM and the cursor overlap on the screen.

With this configuration, the user of the processing system SYS can easily recognize the correspondence between the three-dimensional model generated by the measurement system 2 measuring the workpiece W (e.g., at least one of the object model MO and the post-processing model PD) and the CAD model corresponding to the workpiece W.

In the above example embodiment, repair was performed by additive processing on items requiring repair, such as turbine blades. However, items requiring repair may also be repaired by removal processing, or by combining additive and removal processing. In this case, removal processing may be performed on the area including the additive processing part after the additive processing, or additive processing may be performed on the area including the removal processing part after the removal processing. The former approach offers the advantage of improving the dimensional accuracy of the added part. The latter approach offers the advantage of enhancing the bond between the repair item and the added part, as it involves enlarging the area of a minor defect, such as a crack, before performing the additive repair. It is also possible to perform the additive repair after the removal processing and then remove the area containing this added part.

### (4) Holding Tool

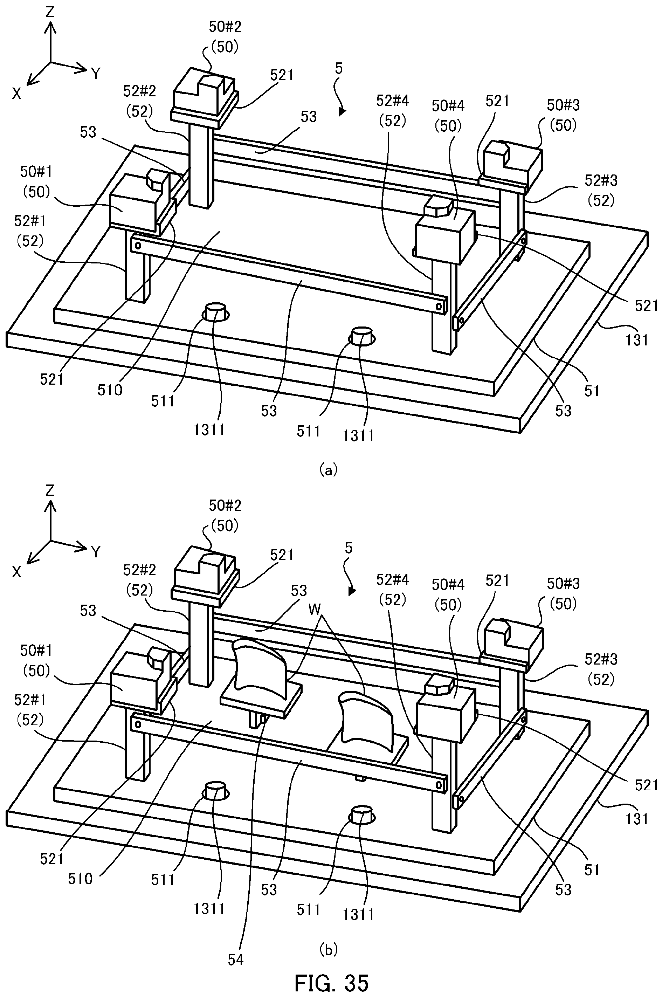

With reference to FIG. 35(a) and FIG. 35(b), the structure of the holding tool 5 that holds the workpiece W will be described. FIG. 35(a) is a perspective view that illustrates the structure of the holding tool 5 that does not hold the workpiece W, and FIG. 35(b) is a perspective view that illustrates the structure of the holding tool 5 that actually holds the workpiece W. FIG. 35(a) and FIG. 35(b) illustrate the holding tool 5 placed on the stage 131 of the processing apparatus 1. Incidentally, the structure of the holding tool 5 illustrated in FIG. 35(a) and FIG. 35(b) is one example, and the structure of the holding tool 5 is not limited to the structures illustrated in FIG. 35(a) and FIG. 35(b).

As illustrated in FIG. 35(a) and FIG. 35(b), the holding tool 5 includes a bottom member 51, a plurality of support members 52, and a plurality of connecting members 53. In an example illustrated in FIG. 35(a) and FIG. 35(b), the holding tool 5 includes four support members 52 (specifically, support members 52#1, 52#2, 52#3 and 52#4) and four connecting members 53. However, the holding tool 5 may include a single support member 52. The holding tool 5 may include a single connecting member 53. The holding tool 5 may not include the connecting member(s) 53. Incidentally, the holding tool 5 may be kinematically supported. The holding tool 5 may be kinematically supported by 3 points. The holding tool 5 may be kinematically supported by less than or equal to 2 points, or greater than or equal to 4 points.

The bottom member 51 is a plate-shaped member. An upper surface of the bottom member 51 (in the examples illustrated in FIG. 35(a) and FIG. 35(b), a surface facing toward the +Z side) may be a surface along the XY plane. A lower surface of the bottom member 51 (in the examples illustrated in FIG. 35(a) and FIG. 35(b), a surface facing toward the -Z side) may be a surface along the XY plane. Note that a shape of the bottom member 51 is not limited to a rectangular shape. The bottom member 51 is placed on the stage 131 of the processing apparatus 1. Specifically, the bottom member 51 is placed on the stage 131 in a state where the lower surface of the bottom member 51 faces toward the stage 131. Therefore, the holding tool 5 is placed on the stage 131 through the bottom member 51. The stage 131 supports the holding tool 5 through the bottom member 51.

The bottom member 51 may be placed (namely, positioned) at a determined position on the stage 131. Namely, the holding tool 5 may be placed (namely, positioned) at the determined position on the stage 131 through the bottom member 51. Incidentally, a position that is determined as a position at which the holding tool 5 is placed may be referred to as a "reference placement position.

In order to place the bottom member 51 at the reference placement position, a mark for a position alignment may be formed on at least one of the bottom member 51 and the stage 131. In the examples illustrated in FIG. 35(a) and FIG. 35(b), the mark for the position alignment is formed each of the bottom member 51 and the stage 131. For example, as illustrated in FIG. 35(a) and FIG. 35(b), a plurality of pins 1311 may be formed on the stage 131 as the marks for the position alignment. The pin 1311 is a member that protrude from the stage 131 along the Z-axis direction. Incidentally, information related to a position of the pin 1311 on the stage 131 may be information known to the processing system SYS. Furthermore, as illustrated in FIG. 35(a) and FIG. 35(b), a plurality of through holes 511 may be formed in the bottom member 51 as the marks for the position alignment. The through hole 511 penetrates the bottom member 51 along the Z-axis direction. Incidentally, two through holes 511 are formed in the bottom member 51. However, three or more through holes, or a single through hole may be formed in the bottom member 51. In this case, as illustrated in FIG. 35(a) and FIG. 35(b), the bottom member 51 may be placed on the stage 131 so that the pins 1311 are inserted into the through holes 511. The bottom member 51 may be placed on the stage 131 in a state where the pins 1311 are inserted into the through holes 511. Therefore, an arrangement aspect of the through holes 511 is the same as an arrangement aspect of the pins 1311. Furthermore, the number of the through holes 511 is the same as (alternatively, may be larger than) the number of the pins 1311. As a result, the bottom member 51 is placed on the stage 131 at the position determined by the pins 1311 and through holes 511 (namely, the reference placement position). Therefore, in this case, information related to a placing position of the bottom member 51 (namely, a placing position of the holding tool 5) on the stage 131 is information known to the processing system SYS.

Incidentally, the pin 1311 that is the mark for the position alignment may not penetrate the through hole 511 of the bottom member 51 of the holding tool 5. For example, a side surface of the bottom member 51 (for example, one of or both of a side surface along the XZ plane and a side surface along the YZ plane in the state illustrated in FIG. 35(a) and FIG. 35(b)) may be pressed against the pins 1311. Moreover, the mark for the position alignment is not limited to the pin 1311. A member having a surface that is allowed to contact the bottom member 51 (for example, a member similar to a below-described stopper 523) may be used as the mark for the position alignment, in addition to or instead of the pin 1311.

At least a part of the upper surface of the bottom member 51 serves as a placement surface 510 on which the workpiece W is placed. The workpiece W is placed on the placement surface 510. The placement surface 510 can support the workpiece W placed on the placement surface 510. The placement surface 510 can hold the workpiece W placed on the placement surface 510. In this case, the placement surface 510 may include at least one of a mechanical chuck, an electro-static chuck, and a vacuum suction chuck to hold the workpiece W. Alternatively, a workpiece holding member 54 (for example, a jig) for holding the workpiece W may be positioned on the placement surface 510. Alternatively, the placement surface 510 may not hold the workpiece W placed on the placement surface 510. In this case, the workpiece W may be placed on the placement surface 510 without a clamp.

A single workpiece W may be placed on the placement surface 510. Alternatively, a plurality of workpieces W may be placed on the placement surface 510. In the example illustrated in FIG. 35(b), two workpieces W are placed on the placement surface 510.

Each of the plurality of support members 52 is a post-shaped member extending from the upper surface of the bottom member 51 upwardly (toward the +Z side in the example illustrated in FIG. 35(a) and FIG. 35(b)). Each of the plurality of support members 52 is a member for supporting the above-described base plate 50. Therefore, each of the plurality of support members 52 supports the plurality of base plates 50, respectively. In the example illustrated in FIG. 35(a) and FIG. 35(b), the plurality of support members 52#1 to 52#4 support a plurality of base plates 50#1 to 50#4, respectively. Namely, the plurality of base plates 50 are positioned in the holding tool 5. However, in a case where the holding tool 5 includes a single support member 52, a single base plate 50 may be positioned in the holding tool 5.

Incidentally, in the example illustrated in FIG. 35(a) and FIG. 35(b), the plurality of support members 52 are positioned at vertexes of a rectangular area in the upper surface of the bottom member 51. However, an arrangement aspect of the plurality of support members 52 is not limited to the example illustrated in FIG. 35(a) and FIG. 35(b). Moreover, in the example illustrated in FIG. 35(a) and FIG. 35(b), the four support members 52 are positioned on the bottom member 51. However, the number of the support members 52 is not limited to four. Three or fewer or five or more support members 52 may be positioned on the bottom member 51.

Each support member 52 includes a plate fixing member 521 to which the base plate 50 is fixed. In this case, each support member 52 supports the base plate 50 through the plate fixing member 521. As one example, each support member 52 may support the base plate 50 from below the base plate 50. Namely, each support member 52 may support the base plate 50 through a tip of each support member 52. In this case, each support member 52 may include the plate fixing member 521 at its tip. The tip of each support member 52 may serve as the plate fixing member 521. Incidentally, at least one of the plurality of support members 52 may not include the plate fixing member 521.

The base plate 50 may be detachably fixed to the plate fixing member 521. For example, the base plate 50 may be fixed to the plate fixing member 521 by using a fixing screw. In this case, the base plate 50 may be detached from the plate fixing member 521 by loosening the fixing screw.

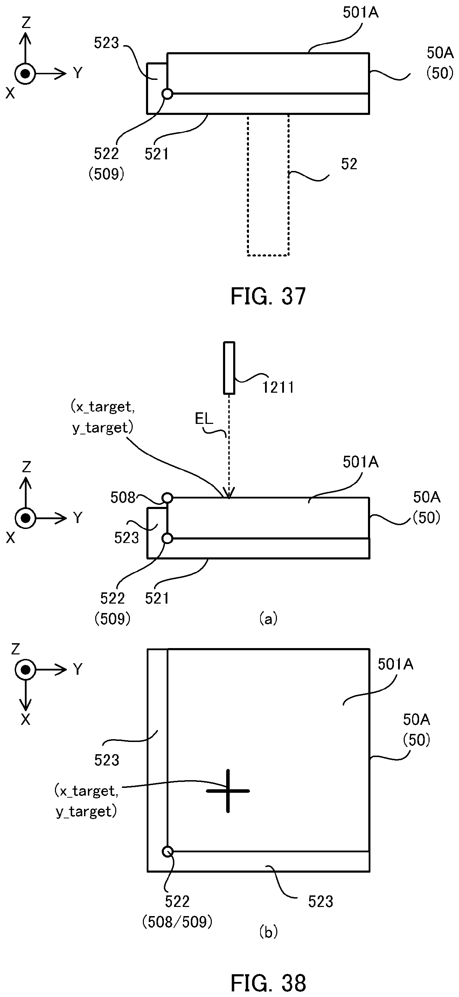

The base plate 50 may be attached to the plate fixing member 521 so that a positional relationship between a reference part 522 (see FIG. 37, for example) of the holding tool 5 and the base plate 50 is a predetermined positional relationship. The base plate 50 may be supported by the support member 52 so that the positional relationship between the reference part 522 of the holding tool 5 and the base plate 50 is the predetermined positional relationship. The base plate 50 may be positioned in the holding tool 5 so that the positional relationship between the reference part 522 of the holding tool 5 and the base plate 50 is the predetermined positional relationship. In other words, the base plate 50 may be positioned in the holding tool 5 to have the predetermined positional relationship with respect to the reference part 522 of the holding tool 5. In this case, information related to the positional relationship between the reference part 522 of the holding tool 5 and the base plate 50 may be information known to the processing system SYS.

The plurality of support members 52 may include at least two support members 52 positioned at positions that are different along the X-axis direction. Furthermore, the plurality of support members 52 may include at least two support members 52 positioned at positions that are different along the Y-axis direction. More specifically, the plate fixing members 521 of at least two of the plurality of support members 52 may be positioned at positions that are different along the X-axis direction. The plate fixing members 521 of at least two of the plurality of support members 52 may be positioned at positions that are different along the Y-axis direction. Namely, positions of the plate fixing members 521 of at least two of the plurality of support members 52 may be different in a lateral direction along which the base plate 50 is supported. The positions of the plate fixing members 521 of at least two of the plurality of support members 52 may be different in a depth direction. Incidentally, the "lateral" here may mean a distance in the X-axis direction from the bottom member 51, and the "depth" here may mean a distance in the Y-axis direction from the bottom member 51. As a result, at least two of the plurality of base plates 50 positioned in the holding tool 5 may be positioned at positions that are different from each other in the lateral direction. At least two of the plurality of base plates 50 positioned in the holding tool 5 may be positioned at positions that are different from each other in the depth direction.

The plurality of support members 52 may be positioned on the bottom member 51 so as to surround at least a part of the placement surface 510 on which the workpiece W is placed. Namely, the plurality of support members 52 may be positioned around at least a part of the placement surface 510. In this case, the plurality of base plates 50, which are supported by the plurality of support members 52, respectively, are also positioned in the holding tool 5 so that the plurality of base plates 50 surround at least a part of the placement surface 510.

Heights of at least two of the plurality of support members 52 may be different. More specifically, heights of the plate fixing members 521 of at least two of the plurality of support members 52 may be different. Namely, heights at which the plate fixing members 521 of at least two of the plurality of support members 52 support the base plates 50 may be different. Incidentally, the "height" here may mean a distance in the Z-axis direction from the bottom member 51. As a result, at least two of the plurality of base plates 50 positioned in the holding tool 5 may be positioned at positions whose heights are different from each other. However, the heights of all of the plurality of support members 52 may be the same.

The height of at least one of the plurality of support members 52 may be set to a height that corresponds to the height of the workpiece W placed on the placement surface 510. For example, the height of at least one of the plurality of support members 52 may be set to a height that is the same as the height of the workpiece W placed on the placement surface 510. For example, the height of at least one of the plurality of support members 52 may be set so that a difference from the height of the workpiece W placed on the placement surface 510 is smaller than an allowable amount.

Incidentally, at least a part of each support member 52 may be used as the base plate 50. In this case, each support member 52 may not support the base plate 50 independently.

Each of the plurality of connecting members 53 connects two adjacent support members 52. Therefore, each connecting member 53 may be a member extending along a direction along which the two adjacent support members 52 are aligned. Each connecting member 53 may be a member extending along a direction that intersects a direction along which the support member 52 extends. In the example illustrated in FIG. 35(a) and FIG. 35(b), each connecting member 53 may extend along the X-axis direction or the Y-axis direction, because the support member 52 extends along the Z-axis direction and the two adjacent support members 52 are aligned along the X-axis direction or the Y-axis direction. In this case, one end of each connecting member 53 may be connected to two adjacent support members 52, and one end of each connecting member 53 may be connected to the two adjacent support members 52.

Incidentally, a plurality of connecting members 53 may connect the two adjacent support members 52, in addition to or instead of a single connecting member 53.

### (4-1) Calibration Operation

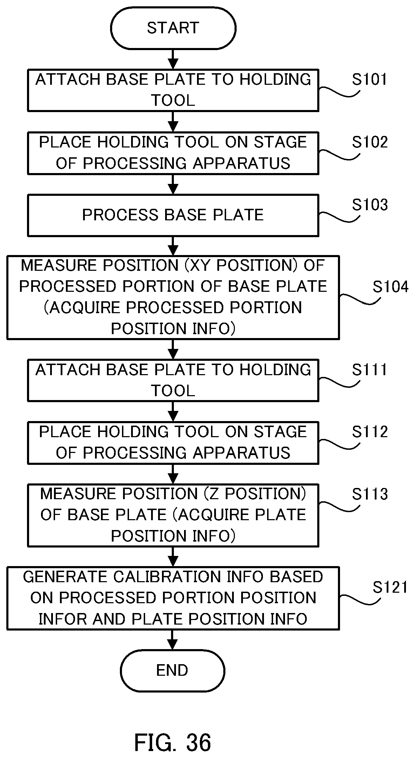

With reference to FIG. 36, the calibration operation will be described. FIG. 36 is a flowchart that illustrates a flow of the calibration operation. Incidentally, "the X -axis, the Y-axis, and the Z-axis" used in the description of the calibration operation mean the X-axis, the Y-axis, and the Z-axis in the processing coordinate system, respectively", if there is no special notation.

As illustrated in FIG. 36, first, the base plate 50 is attached to the holding tool 5 (a step S101). Namely, the base plate 50 is fixed to the plate fixing member 521 of the support member 52 of the holding tool 5. Since the holding tool 5 includes the plurality of support members 52, the plurality of base plates 50 are attached to the plurality of support members 52, respectively at the step S101.

Incidentally, in a case where a positional relationship between the base plate 50 and the plate fixing member 521 does not change in a period from a time at which the base plate 50 is attached to the holding tool 5 to a time at which the base plate 50 is processed at a below-described step S103, the base plate 50 may not be fixed to the plate fixing member 521.

Incidentally, in the present example embodiment, another base plate 50 is also attached to the holding tool 5 instead of the base plate 50 attached to the holding tool 5 at the step S101, as described in detail later. Therefore, in the below-described description, the base plate 50 attached to the holding tool 5 at the step S101 is referred to as a "base plate 50A". The base plate 50A attached to the holding tool 5 at the step S101 is used as the base plate 50 that is processed by the processing apparatus 1. Therefore, the base plate 50A may be referred to as a reference member for processing.

FIG. 37 illustrates one example of the base plate 50A. As illustrated in FIG. 37, the base plate 50A may be a plate-shaped member (alternatively, a cuboid-shaped member). An upper surface of the base plate 50A is used as a reference surface 501A that is processed by the processing apparatus 1. The reference surface 501A is typically a planar surface. The reference surface 501A may be a surface along the XY plane in a situation where the holding tool 5 is set in the processing apparatus 1 (especially, placed at the reference placement position). However, the base plate 50A illustrated in FIG. 37 is one example, and the base plate 50A that is different from the base plate 50A illustrated in FIG. 37 may be attached to the holding tool 5 at the step S101 in FIG. 36.

As described above, the plurality of support members 52 may include at least two support members 52 positioned at positions that are different along the X-axis direction. Therefore, the plurality of base plates 50A may also include at least two base plates 50A positioned at positions that are different along the X-axis direction. Namely, the plurality of base plates 50A may include at least two base plates 50A that respectively include at least two reference surfaces 501A positioned at positions that are different along the X-axis direction.

As described above, the plurality of support members 52 may include at least two support members 52 positioned at positions that are different along the Y-axis direction. Therefore, the plurality of base plates 50A may also include at least two base plates 50A positioned at positions that are different along the Y-axis direction. Namely, the plurality of base plates 50A may include at least two base plates 50A that respectively include at least two reference surfaces 501A positioned at positions that are different along the Y-axis direction.

Again in FIG. 36, then, the holding tool 5 to which the base plates 50A has been attached is placed on the stage 131 of the processing apparatus 1 (a step S102). Namely, the holding tool 5 is placed at the reference placement position of the stage 131 (the step S102). Incidentally, when the calibration operation is performed, the workpiece W may not be placed in the holding tool 5. Alternatively, when the calibration operation is performed, the workpiece W may be placed in the holding tool 5.

Then, the processing apparatus 1 processes the base plate 50A attached to the holding tool 5 (the step S103). Specifically, the processing apparatus 1 processes the base plate 50A by performing the processing at a predetermined target coordinate in the processing coordinate system. For example, the processing apparatus 1 may move the processing head 121 by using the head driving system 122 so that the predetermined target coordinate in the processing coordinate system is allowed to be irradiated with the processing light EL. Then, the processing apparatus 1 may process the base plate 50A by irradiating the predetermined target coordinate with the processing light EL. Namely, the processing apparatus 1 may form the processed portion of the base plate 50A at the predetermined target coordinate by irradiating the predetermined target coordinate with the processing light EL.

In the present example embodiment, as illustrated in FIG. 38(a) and FIG. 38(b), an example in which the predetermined target coordinate includes at least a target position x_target along the X-axis direction and a target position y_target along the Y-axis direction will be described. However, the predetermined target coordinate may include a target position along the Z-axis direction. The predetermined target coordinate (x_target, y_target) may be a coordinate at which the reference surface 501A of the base plate 50A is expected to be positioned in a state where the holding tool 5 is placed at the reference placement position of the stage 131. The target coordinate (x_target, y_target) that has a predetermined positional relationship with respect to the reference part 509 of the base plate 50A may be set. For example, a position of a corner part 5091 of the base plate 50A may be considered to be the same as a position of the reference part 509 in the X-axis direction and the Y-axis direction, and the target coordinate (x_target, y_target) that has the predetermined positional relationship with respect to the corner part 5091 may be set. Alternatively, a position that is away from the corner part 5091 by a target distance in the X-axis direction and a position that is away from the corner part 5091 by a target distance in the Y-axis direction may be set as the target coordinate (x_target, y_target).

FIG. 38(a) and FIG. 38(b) further illustrates one example of the processed portion. In an example illustrated in FIG. 38(a) and FIG. 38(b), the processing apparatus 1 forms a cross-shaped processed portion, which includes two linear processed portions that intersect each other, on the reference surface 501A of the base plate 50A (especially, at the predetermined target coordinate). In this case, the processing apparatus 1 may process the base plate 50A so that a position at which the two linear processed portions intersect is the target coordinate (x_target, y_target). However, the processing apparatus 1 may form the processed portion having a shape that is different from the shape illustrated in FIG. 38(a) and FIG. 38(b). For example, the processing apparatus 1 may form a point-shaped processed portion.

Incidentally, the processing apparatus 1 may form a plurality of processed portions that include two linear processed portions that intersect each other on one base plate 50 (e.g., the base plate 50A). In other words, the processing apparatus 1 may perform a process of forming the processed portion on one base plate 50 multiple times.

A characteristic of the processed portion that should be formed on the base plate 50A by the processing apparatus 1 may be determined in advance or may be changed as needed. The characteristic of the processed portion may include at least one of a position, a shape, and a size of the processed portion. For example, the characteristic of the processed portion may be changed based on an accuracy required for the calibration information. Namely, the characteristic of the processed portion may be changed based on an accuracy required as an accuracy of the position of the holding tool 5 indicated by the calibration information.

Since the plurality of base plates 50A are attached to the holding tool 5, the processing apparatus 1 processes the plurality of base plates 50A in sequence. Specifically, the processing apparatus 1 processes the plurality of base plates 50A in sequence by performing the processing at a plurality of target coordinates, which correspond to the plurality of base plates 50A, respectively, in sequence.

Again in FIG. 36, the processing apparatus 1 measures the position of the processed portion of the base plates 50A (a step S104). In the present example embodiment, an example in which the processing apparatus 1 measures at least the position of the processed portion along at least one of the X-axis direction and the Y-axis direction will be described. However, the processing apparatus 1 may measure the position of processed portion along the Z-axis direction.

The measurement of the position of the processed portion by the processing apparatus 1 may mean an acquisition of information that directly or indirectly indicate the position of the processed portion. For example, in a case where the processing apparatus 1 has the measurement apparatus (typically, an imaging apparatus) that is configured to measure the position of processed portion by imaging the base plate 50A, the measurement of the position of processed portion may mean imaging the base plate 50A. In this case, the processed portion position information indicating the measured result of the position of the processed portion may include an image generated by imaging the base plate 50A. In this case, the image in which the processed portion is captured is information that directly or indirectly indicates the position of the processed portion because the processed portion is captured in the image.

In a case where the processed portion is the cross-shaped processed portion described above (alternatively, includes the plurality of processed portions that intersect each other), the processing apparatus 1 may measure a position of an intersecting point of the plurality of linear processed portions as the position of the processed portion. As one example, the processing apparatus 1 may measure positions of two points at which a virtual outer frame surrounding the processed portion and one linear processed portion intersect, and measure a position of a line connecting the two points as the position of the one linear processed portion. Then, the processing apparatus 1 may measure the position of the intersecting point of the plurality of linear processed portions as the position of the processed portion.

In a case where the processed portion is the cross-shaped processed portion described above (alternatively, includes the plurality of processed portions that intersect each other), the processing apparatus 1 may measure the positions of at least two processed portions, which are designated by the user of the processing system SYS, of the plurality of processed portions. Then, the processing apparatus 1 may measure the position of the intersecting point of the plurality of linear processed portions as the position of the processed portion. Alternatively, in a case where the processed portion is a processed portion having any shape, the processing apparatus 1 may measure the position of a part of the processed portion, which is designated by the user of the processing system SYS, as the position of the processed portion.

The user may designate the processed portion (alternatively, a part thereof), which is measured by the processing apparatus 1, by referring to information that is related to the measured result of the processing apparatus 1 and that is displayed on a non-illustrated display apparatus of the processing apparatus 1. For example, in a case where the processing apparatus 1 generates the image in which the base plate 50A is captured by imaging the base plate 50A, the user may designate the processed portion (alternatively, a part thereof), which is measured by the processing apparatus 1, by referring to the image in which the processed portion is captured. In this case, the user may designate the position of the processed portion in the image displayed on the display apparatus, then, the display apparatus enlarges the image around the designated position to enlarge the processed portion, and the user may designate the processed portion (alternatively, a part thereof), which is measured by the processing apparatus 1, by referring to the enlarged image.

The processing apparatus 1 may measure a position of the reference part 509 of the base plate 50A, in addition to or instead of measuring the position of processed portion. In this case, the processing apparatus 1 may output, as the processed portion position information, information related to a positional relationship between the reference part 509 of the base plate 50A and the position of the processed portion. For example, the processing apparatus 1 may output, as the processed portion position information, information related to the position of the processed portion relative to the reference part 509 of the base plate 50A.

The processing apparatus 1 may measure a position of the sub-reference part 508 (see FIG. 38(a) and FIG. 38(b)), which is a part of the base plate 50A and which has a known positional relationship with respect to the reference part 509 of the base plate 50A, in addition to or instead of measuring the position of processed portion. A corner part (for example, a vertex) of the base plate 50A is one example of the sub-reference part 508 of the base plate 50A. Especially, the sub-reference part 508 of the base plate 50A may be a part that can be directly measured by the processing apparatus 1. In this case, the processing apparatus 1 may output, as the processed portion position information, information related to a relationship between a position of the sub-reference part 508 of the base plate 50A and the position of the processed portion. For example, the processing apparatus 1 may output, as the processed portion position information, information related to the position of the processed portion relative to the position of the sub-reference part 508 of the base plate 50A.

The base plate 50A may be placed at a position that is mechanically determined in advance in the processing apparatus 1. Especially, the base plate 50A may be placed in the processing apparatus 1 so that the reference part 509 of the base plate 50A is positioned at a position that is mechanically determined in advance in the processing apparatus 1. In this case, information related to the position of the base plate 50A (especially, the position of the reference part 509) is information known to the processing apparatus 1. In this case, the processing apparatus 1 may output, as processed portion position information, information related to the position of the processed portion relative to the position of the reference part 509 or the sub-reference part 508 of the base plate 50A by measuring the position of the processed portion.

In a case where the vertex of the base plate 50A is used as the reference part 509, the processing apparatus 1 measures the position of the reference part 509 or the sub-reference part 508 of the base plate 50A by measuring positions of at least two sides of the base plate 50A that intersect at the vertex corresponding to the reference part 509. For example, in the example illustrated in FIG. 38(b), the processing apparatus 1 may measure the positions of a left side and a lower side of the base plate 50A in FIG. 38(b). In this case, a position at which the at least two sides intersect is the position of the reference part 509, and a position of a part of the base plate 50A that has a known positional relationship with respect to the position at which the at least two sides intersect is the position of the sub-reference part 508. As a result, the processing apparatus 1 may output, as processed portion position information, information related to the position of the processed portion relative to the position of the reference part 509 or the sub-reference part 508 of the base plate 50A by measuring the position of the processed portion.

The user of the processing system SYS may input information related to the position of the reference part 509 or the sub-reference part 508 of the base plate 50A to the processing apparatus 1. As a result, the processing apparatus 1 may output, as processed portion position information, information related to the position of the processed portion relative to the position of the reference part 509 or the sub-reference part 508 of the base plate 50A by measuring the position of the processed portion.

Again in FIG. 36, after the base plate 50A is detached from the holding tool 5, a new base plate 50 (in the below-described description, it is referred to as a "base plate 50B") is attached to the holding tool 5 (a step S111). Namely, the base plate 50B is attached to the holding tool 5 instead of the base plate 50A. Specifically, the base plate 50B is fixed to the plate fixing member 521 of the support member 52 of the holding tool 5. Since the holding tool 5 includes the plurality of support members 52, the plurality of base plates 50B are attached to the plurality of support members 52, respectively, at the step S111. The base plate 50B attached to the holding tool 5 at the step S111 is used as the base plate 50 that is measured by the processing apparatus 1. Therefore, the base plate 50B may be referred to as a reference member for measurement.

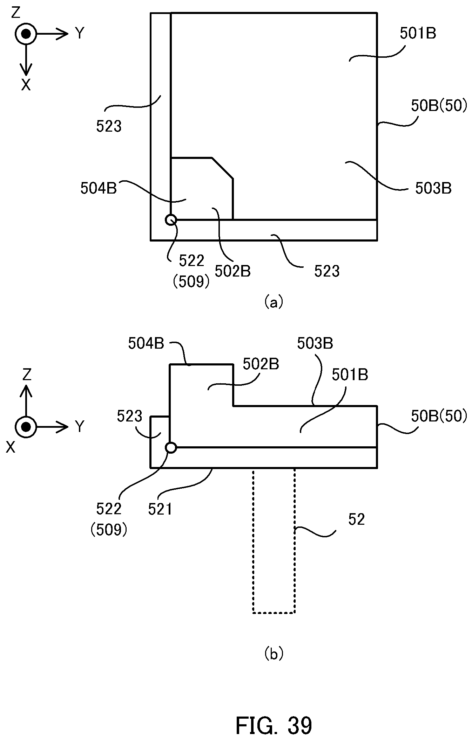

FIG. 39(a) and FIG. 39(b) illustrates one example of the base plate 50B. As illustrated in FIG. 39(a) and FIG. 39(b), a shape of the base plate 50B is different from a shape of the base plate 50A. In an example illustrated in FIG. 39(a) and FIG. 39(b), the base plate 50B includes a first plate part 501B and a second plate part 502B that projects upwardly from the first plate part 501B. An upper surface of the first plate part 501B may be used as a reference surface 503B that is measured by the processing apparatus 1. An upper surface of the second plate part 502B may be used as a reference surface 504B that is measured by the processing apparatus 1. A height of the reference surface 503B is different from a height of the reference surface 504B.

One reason why the base plate 50B includes the second plate part 502B corresponding to a convex part is that the shape measurement apparatus 21 measures the three-dimensional shapes of the holding tool 5 and the workpiece W (namely, measures three-dimensional position of each point of the surface of the holding tool 5 and each point of the surface of the workpiece W in the measurement coordinate system) in the processing path generation operation described below. A measurement of the three-dimensional shape of the holding tool 5 by the shape measurement apparatus 21 includes A measurement of the three-dimensional shape of the base plate 50B (namely, a measurement of the position of the base plate 50B in the measurement coordinate system) by the shape measurement apparatus 21. In this case, the shape measurement apparatus 21 can measure the three-dimensional shape of the base plate 50B more appropriately, compared to a case where the base plate 50B does not include the second plate part 502B.

Information related to a positional relationship between at least one of the reference surfaces 503B and 504B and the reference part 522 of the support member 52 may be information known to the processing system SYS in a state where the base plate 50B is attached to the support member 52. For example, information related to the positional relationship between the reference surface 503B and the reference part 522 in the Z-axis direction may be information known to the processing system SYS. For example, information related to the positional relationship between the reference surface 504B and the reference part 522 in the Z-axis direction (for example, information related to a distance Δz between the reference surface 504B and the reference part 522 in the Z-axis direction illustrated in FIG. 39(b)) may be information known to the processing system SYS. Incidentally, since the reference part 522 of the support member 52 contacts the reference part 509 of the base plate 50B as described above, information related to a positional relationship between at least one of the reference surfaces 503B and 504B and the reference part 509 of the base plate 50B may be regarded as information known to the processing system SYS.

A shape of the second plate part 502B in a planar view may be a shape that is asymmetrical about a point. Especially, a shape of the reference surface 504B of the second plate part 502B in a planar view may be a shape that is asymmetrical about a point. In the example illustrated in FIG. 39(a), the shape of the reference surface 504B in a planar view is a shape (a pentagon in effect) obtained by cutting off one vertex of a square. Namely, the shape of the reference surface 504B in a planar view is a shape in which a notch is formed in part. Furthermore, the reference part 509 of the base plate 50B (namely, the reference part 522 of the holding tool 5) and the second plate part 502B may have a predetermined positional relationship. For example, in the example illustrated in FIG. 39(a), a vertex of the reference surface 504B that is opposite to the notch along a diagonal direction of the reference surface 504B is set as the reference part 509 of the base plate 50B (namely, the reference part 522 of the holding tool 5). In this case, the control information generation apparatus 22 can determine the reference part 509 of the base plate 50B (namely, the reference part 522 of the holding tool 5) in the below-described processing path generation operation appropriately, compared to a case where the shape of the reference surface 504B in a planar view is a shape that is symmetrical about point.

A characteristic of the base plate 50B (as one example, a characteristic of the second plate part 502B) may be determined in advance or may be changed as needed. The characteristic of the base plate 50B may include at least one of a position, a shape, and a size of the base plate 50B. For example, the characteristic of the base plate 50B may be changed based on an accuracy required for the calibration information. Namely, the characteristic of the base plate 50B may be changed based on an accuracy required as an accuracy of the position of the holding tool 5 indicated by the calibration information. The same is applied to a characteristics of the base plate 50A.

However, the base plate 50B illustrated in FIG. 39(a) and FIG. 39(b) is one example, and the base plate 50B that is different from the base plate 50B illustrated in FIG. 39(a) and FIG. 39(b) may be attached to the holding tool 5 at the step S111 in FIG. 36. Alternatively, the base plate 50B having a shape that is the same as the shape of the base plate 50A may be attached to the holding tool 5 at the step S111.

Again in FIG. 36, then, the holding tool 5 to which the base plate 50B is attached is placed on the stage 131 of the processing apparatus 1 (a step S112). Namely, the holding tool 5 is placed at the reference placement position of the stage 131 (the step S112).

Then, the processing apparatus 1 measures the position of the base plate 50B (the step S113). Namely, the processing apparatus 1 acquires information related to the position of the base plate 50B in the processing apparatus 1. Specifically, the processing apparatus 1 measures the position of the base plate 50B in the processing coordinate system. For example, the processing apparatus 1 may measure the position of the reference surface 503B of the base plate 50B as the position of the base plate 50B. For example, the processing apparatus 1 may measure the position of the reference surface 504B of the base plate 50B as the position of the base plate 50B. In the below-described description, an example in which the processing apparatus 1 measures the position of the reference surface 504B of the base plate 50B as the position of the base plate 50B will be described.

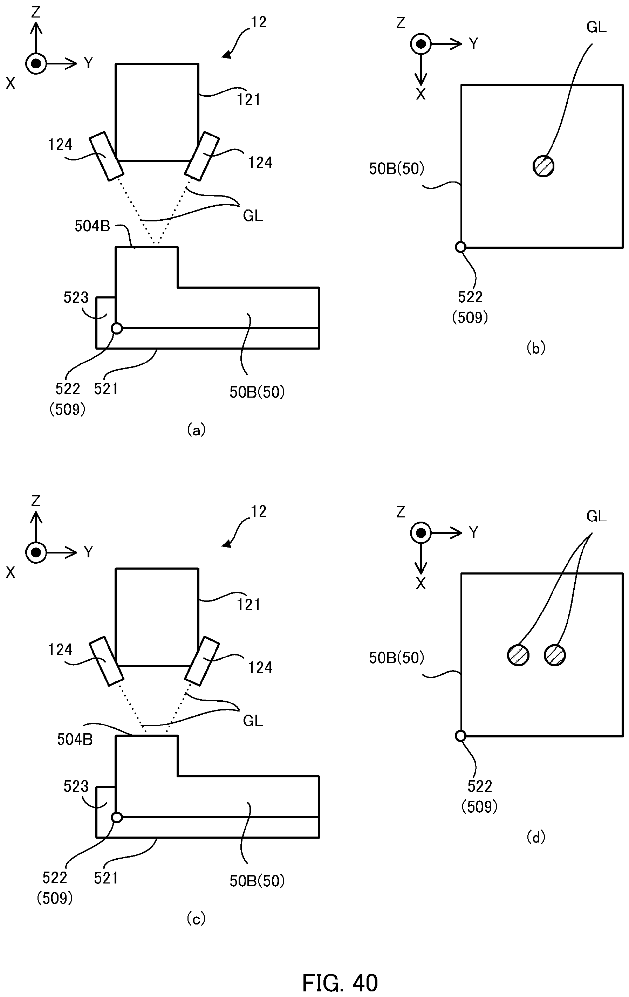

In the present example embodiment, an example in which the processing apparatus 1 measures the position of the base plate 50B in at least the Z-axis direction (namely, the height of the base plate 50B, and the position in the Z-axis direction is referred to as a "Z position" in the below-described description) will be described. In this case, the processing apparatus 1 may measure the position of the reference surface 504B in the Z-axis direction (namely, the height of the reference surface 504B). Here, it is assumed that the processing apparatus 1 has a plurality of guide light irradiation apparatuses 124 (see FIG. 40, for example) and an imaging apparatus.

The processing apparatus 1 measures the Z position of the reference surface 504B by using the plurality of guide light irradiation apparatuses 124 and the imaging apparatus. Specifically, the plurality of guide lights GL emitted from the plurality of guide light irradiation apparatuses 124, respectively, intersect each other at the predetermined intersecting position below the processing head 121. Therefore, in a case where the reference surface 504B is positioned at the intersecting position, the plurality of guide lights GL intersect each other on the reference surface 504B, as illustrated in FIG. 40(a) and FIG. 40(b). As a result, the plurality of guide lights GL form a single beam spot on the reference surface 504B. On the other hand, in a case where the reference surface 504B is not positioned at the intersecting position, the plurality of guide lights GL do not intersect on the reference surface 504B, as illustrated in FIG. 40(c) and FIG. 40(d). As a result, the plurality of guide lights GL form a plurality of beam spots on the reference surface 504B, respectively. Therefore, in a case where the plurality of guide lights form the single beam spot on the reference surface 504B, the reference surface 504B is positioned at the intersecting position, which is determined with respect to the processing head 121, in the Z-axis direction. Namely, the Z position of the reference surface 504B in the Z-axis direction can be determined.

Therefore, the control apparatus 17 moves at least one of the processing head 121 and the stage 131 along the Z-axis direction so that the plurality of guide lights form the single beam spot on the reference surface 504B based on the image generated by the imaging apparatus imaging states of the plurality of guide lights GL (especially, states of the plurality of guide lights GL on the reference surface 504B). Then, in a case where the plurality of guide lights GL form the single beam spot on the reference surface 504B, the control apparatus 17 acquires information related to the position (especially, the Z position) of the processing head 121 in the processing coordinate system. Once the Z position of the processing head 121 in the processing coordinate system is determined, the intersecting position in the processing coordinate system is also determined. Once the intersecting position in the processing coordinate system is determined, the Z position of the reference surface 504B in the processing coordinate system is also determined. This is because the reference surface 504B is positioned at the intersecting position. Once the Z position of the reference surface 504B in the processing coordinate system is determined, the Z position of the reference part 522 of the holding tool 5 in the processing coordinate system is also determined. This is because the information related to the positional relationship between the reference surface 504B and the reference part 522 in the Z-axis direction is the information known to the processing system SYS as described above. Therefore, it can be said that the information related to the position (especially, the Z position) of the processing head 121 in the processing coordinate system in the state where the plurality of guide lights GL form the single beam spot on the reference surface 504B is information indirectly indicating the Z position of the reference surface 504B. The processing apparatus 1 may transmit this information related to the position (especially, the Z position) of the processing head 121 to the processing apparatus 1 as the plate position information indicating the measured result of the position of the base plate 50.

Incidentally, the processing apparatus 1 may measure the position of the reference surface 504B by using a method that is different from the method using the plurality of guide light irradiation apparatuses 124 and the imaging apparatus. For example, the processing apparatus 1 may measure the position of the reference surface 504B by using a time of flight method that measures a period from a time at which light is emitted to the reference surface 504B to a time at which the light returns from the reference surface 504B. For example, the processing apparatus 1 may measure the position of the reference surface 504B by using an optical interferometry method that detects interference light generated by an interference between light through the reference surface 504B and light not through the reference surface 504B. In this case, the light used in the optical interferometry method may be light generated by a light comb light source. For example, the processing apparatus 1 may measure the position of the reference surface 504B by using a non-contact measurement method by the above-described shape measurement head 211. For example, the processing apparatus 1 may measure the position of the reference surface 504B by using a contact measurement method using a probe that contacts the reference surface 504B.

Since the plurality of base plates 50B are attached to the holding tool 5, the processing apparatus 1 measures the positions of the plurality of base plates 50B in sequence. As a result, the processing apparatus 1 may transmit the plate position information indicating the measured results of the positions of the plurality of base plates 50 to the processing apparatus 1. Incidentally, the processing apparatus 1 may include a plurality of Z-position measurement apparatuses each of which includes the plurality of guide light irradiation apparatuses 124 and the imaging apparatus. In this case, the processing apparatus 1 may simultaneously measure the positions of the plurality of base plates 50B by using the plurality of Z-position measurement apparatuses, respectively.

Again in FIG. 36, then, the processing apparatus 1 generates the calibration information (a step S121). Specifically, the processing apparatus 1 generates the calibration information based on the processed portion position information, which has been acquired at the step 105, and the plate position information, which has been acquired at the step S113.

In order to generate the calibration information, the processing apparatus 1 may calculate, based on the processed portion position information, the position in the X-axis direction of the reference part 522 of the holding tool 5 in the processing coordinate system. In the below-described description, the position in the X-axis direction is referred to as an "X position. Furthermore, the processing apparatus 1 may calculate, based on the processed portion position information, the position in the Y-axis direction of the reference part 522 of the holding tool 5 in the processing coordinate system. In the below-described description, the position in the Y-axis direction is referred to as a "Y position.

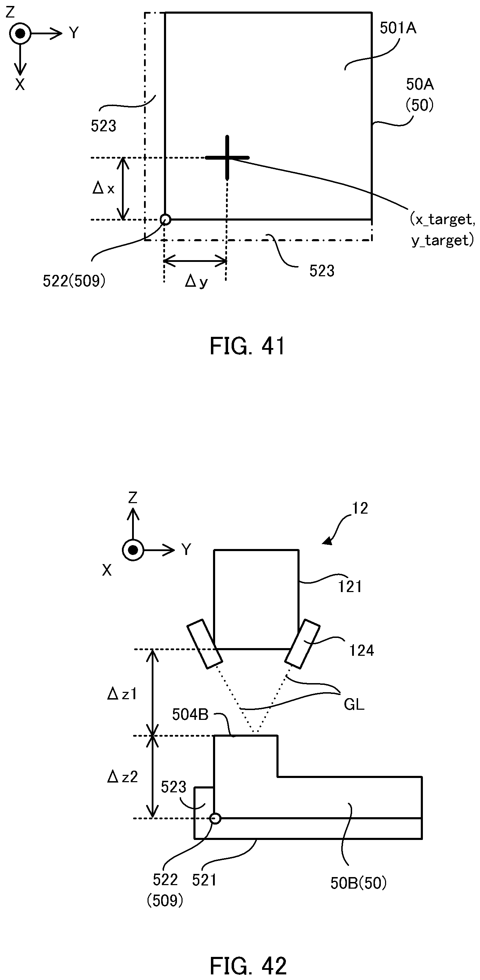

Specifically, as illustrated in FIG. 41, the processing apparatus 1 may calculate a positional relationship between the processed portion of the base plate 50A and the reference part 509 of the base plate 50A based on the processed portion position information. In a case where the processing apparatus 1 measures the position of the reference part 509 of the base plate 50A, the processing apparatus 1 may calculate a positional relationship between the processed portion of the base plate 50A and the reference part 509 of the base plate 50A based on the processed portion position information. In a case where the processing apparatus 1 measures the position of the sub-reference part 508, which has the known positional relationship with respect to the reference part 509 of the base plate 50A, the processing apparatus 1 may calculate the position of the reference part 509 of the base plate 50A, which has the known positional relationship with respect to the sub-reference part 508, based on the processed portion position information. Then, the positional relationship between the processed portion of base plate 50A and the reference part 509 of base plate 50A may be calculated. An operation for calculating the positional relationship between the processed portion of the base plate 50A and the reference part 509 of the base plate 50A may include an operation for calculating a distance Δx in the X-axis direction between the processed portion of the base plate 50A and the reference part 509 of the base plate 50A. The operation for calculating the positional relationship between the processed portion of the base plate 50A and the reference part 509 of the base plate 50A may include an operation for calculating a distance Δy in the Y-axis direction between the processed portion of the base plate 50A and the reference part 509 of the base plate 50A. Then, the processing apparatus 1 may calculate at least one of the X position and the Y position of the reference part 509 of the base plate 50A in the processing coordinate system. For example, since the processed portion of the base plate 50A is formed at the predetermined target coordinates (x_target, y_target) in the processing coordinate system, the X position and the Y position of the processed portion in the processing coordinate system correspond to the target position x_target along the X-axis direction and the target position y_target along the Y-axis direction, respectively. In this case, the processing apparatus 1 may calculate the X position of the reference part 509 of the base plate 50A in the processing coordinate system by adding (alternatively, subtracting in some case) the distance Δx, which is calculated based on the processed portion position information, to the X position x_target of the processed portion. The processing apparatus 1 may calculate the Y position of the reference part 509 of the base plate 50A in the processing coordinate system by adding (alternatively, subtracting in some case) the distance Δy, which is calculated based on the processed portion position information, to the Y position y_target of the processed portion. Furthermore, since the reference part 509 of the base plate 50A contacts the reference part 522 of the holding tool 5 as described above, the X position and the Y position of the reference part 509 of the base plate 50A are equivalent to the X position and the Y position of the reference part 522 of the holding tool 5, respectively. As a result, the processing apparatus 1 acquires information related to the X position and the Y position of the reference part 509 of the base plate 50A as information related to the X position and the Y position of the reference part 522 of the holding tool 5.

Incidentally, if there is no placement error (an attachment error) when the holding tool 5 is placed at the reference placement position of the processing apparatus 1 at the step S102, the calculated X position and Y position of the reference part 522 in the processing coordinate system are the same as designed positions. In reality, there is a possibility that the calculated X position and Y position of the reference part 522 in the processing coordinate system deviate from the designed positions due to such error. The control information generation apparatus 22 may acquire information related to a difference between the X position and the Y position of the reference part 522 and the designed positions as information related to the X position and the Y position of the reference part 522 of the holding tool 5.

Since the plurality of base plates 50A are attached to the holding tool 5 as described above, the holding tool 5 includes a plurality of reference parts 522 that correspond to the plurality of base plates 50A, respectively. In this case, the processing apparatus 1 may calculate the X position and Y position of each of the plurality of reference parts 522.

In order to generate the calibration information, the processing apparatus 1 may further calculate a position in the Z-axis direction (namely, a Z position) of the reference part 522 of the holding tool 5 based on the plate position information. Specifically, as described above, the plate position information indicates the position (especially, the Z position) of the processing head 121 in the processing coordinate system in a state where the plurality of guide lights GL form the single beam spot on the reference surface 504B. Namely, the plate position information indicates the position (especially, the Z position) of the processing head 121 in the processing coordinate system in a state where the reference surface 504B is positioned at the intersecting position at which the plurality of guide lights GL intersect. Therefore, as illustrated in FIG. 42, the processing apparatus 1 may calculate a Z position of the reference surface 504B in the processing coordinate system by adding (alternatively, subtracting in some case) a distance Δz1 between the processing head 121 and the intersecting position in the Z-axis direction to the position of the processing head 121 indicated by the plate position information. In this case, information related to the distance Δz1 between the processing head 121 and the intersecting position in the Z-axis direction may be information known to the processing system SYS. Incidentally, the intersecting position at which the plurality of guide lights GL intersect may be used as the position of the processing head 121 in the processing coordinate system without using the information of the distance Δz1. Moreover, as illustrated in FIG. 42, the processing apparatus 1 may calculate a Z position of the reference part 522 in the processing coordinate system by adding (alternatively, subtracting in some case) a distance Δz2 between the reference surface 504B and the reference part 522 of the holding tool 5 in the Z-axis direction to the Z position of the reference surface 504B. In this case, information related to the distance Δz2 between the reference surface 504B and the reference part 522 in the Z-axis direction may be information known to the processing system SYS. Incidentally, the intersection position at which the plurality of guide lights GL intersect may be used as the position of the processing head 121 in the processing coordinate system without using the information related to the distance Δz1.

Since the plurality of base plates 50B are attached to the holding tool 5 as described above, the holding tool 5 includes a plurality of reference parts 522 that correspond to the plurality of base plates 50B, respectively. In this case, the control information generation apparatus 22 may calculate the Z position of each of the plurality of reference parts 522.

Then, the processing apparatus 1 may calculate the position of the holding tool 5 in the processing coordinate system based on the positions (namely, the X positions, the Y positions, and the Z positions) of the plurality of reference parts 522 in the processing coordinate system. For example, the processing apparatus 1 may calculate at least one of the X position, the Y position, and the Z position of the holding tool 5. For example, the control information generation apparatus 22 may calculate the position (a θX position) of the holding tool 5 in the θX direction that is a rotational direction around the X-axis. For example, the processing apparatus 1 may calculate the position (a θY position) of the holding tool 5 in the θY direction that is a rotational direction around the U-axis. For example, the control information generation apparatus 22 may calculate the position (a θZ position) of the holding tool 5 in the θZ direction that is a rotational direction around the Z-axis.

As one example, the processing apparatus 1 may calculate any one of the X position, the Y position, and the θZ position of the holding tool 5 based on the X position and Y position of one reference part 522. The processing apparatus 1 may calculate any two of the X position, the Y position, and the θZ position of the holding tool 5 based on the X positions and Y positions of two reference part 522. The processing apparatus 1 may calculate the X position, the Y position, and the θZ position of the holding tool 5 based on the X positions and Y positions of at least three reference part 522.

However, the processing apparatus 1 may not calculate the X position, the Y position, and the θZ position of the holding tool 5. In this case, the processing apparatus 1 may not calculate the X position and the Y position of the reference part 522. The processing apparatus 1 may not process the base plate 50A. The processing apparatus 1 may not measure the processed portion of the base plate 50A. The processing system SYS may not include the processing apparatus 1.

As another example, the processing apparatus 1 may calculate any one of the Z position, the θX position, and the θY position of the holding tool 5 based on the Z position of one reference part 522. The processing apparatus 1 may calculate any two of the Z position, the θX position, and the θY position of the holding tool 5 based on the Z positions of two reference parts 522. The processing apparatus 1 may calculate the Z position, the θX position, and the θY position of the holding tool 5 based on the Z positions of at least three reference parts 522.

However, the processing apparatus 1 may not calculate the Z position, the θX position, and the θY position of the holding tool 5. In this case, the processing apparatus 1 may not calculate the Z position of the reference part 522. The processing apparatus 1 may not measure the base plate 50B. The processing apparatus 1 may not include the plurality of guide light irradiation apparatuses 124 and the imaging apparatus.

In the above-described example, the processing apparatus 1 forms the processed portion on the upper surface of the base plate 50 by irradiating the processing light EL to the base plate 50. However, a heat-sensitive member having heat sensitivity (i.e., sensitivity) to the processing light EL may be attached to the upper surface of the base plate 50, or a light-sensitive member having light sensitivity (i.e., sensitivity) to the processing light EL may be attached to the upper surface of the base plate 50. In this case, in the step S104, the base plate 50 to which the heat-sensitive member or the light-sensitive member is attached may be measured.

The processing system SYS performs the above-described calibration operation for each combination pattern of the processing apparatus 1 and the holding tool 5. As a result, the calibration information is generated (namely, acquired) for each combination pattern of the processing apparatus 1 and the holding tool 5. The processing system SYS performs the calibration operation before the processing apparatus 1 starts processing the workpiece W.

### (4-2) Processing Path Generation Operation

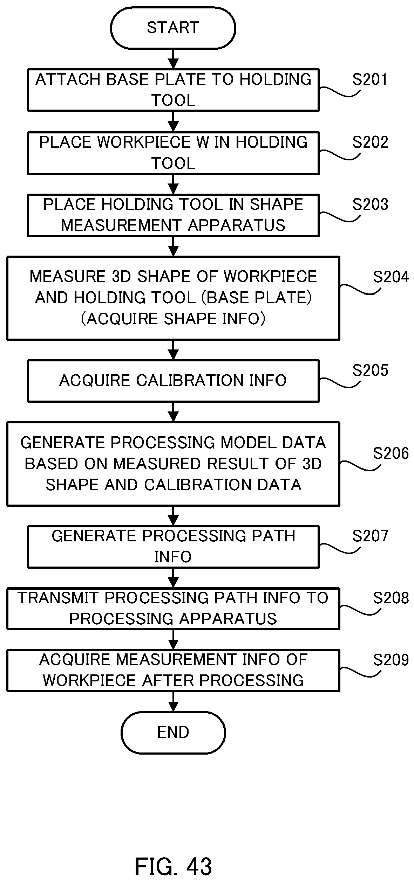

Next, with reference to FIG. 43, the processing path generation operation will be described. FIG. 43 is a flowchart that illustrates a flow of the processing path generation operation.

As illustrated in FIG. 43, first, the base plate 50 is attached to the holding tool 5 (a step S201). At the step S201, the base plate 50B, which is attached to the holding tool 5 in the above-described calibration operation, is attached to the holding tool 5. However, the step S201 may be omitted in a case where the base plate 50B is already attached to the holding tool 5, such as a case after the above-described step S111. Incidentally, the base plate 50 that is different from the base plate 50B may be attached to the holding tool 5. In parallel to or before or after the operation at the step S201, the workpiece W, which should be actually processed by the processing apparatus 1, is placed in the holding tool 5 (a step S202). Namely, the workpiece W is held by the holding tool 5.

Then, the holding tool 5, to which the base plate 50B is attached and which holds the workpiece W, is placed on the stage 213 of the shape measurement apparatus 21 (a step S203). Therefore, the transport apparatus 3 transports the holding tool 5 to the measurement system 2. Then, the transported holding tool 5 is placed on the stage 213.

Incidentally, a surface treatment may be performed on the surface of the workpiece W held by the holding tool 5 before the holding tool 5 is placed on the stage 213. A polishing is one example of the surface treatment. For example, the surface of the workpiece W may be polished by sandblasting.

Then, the shape measurement apparatus 21 measures the three-dimensional shape of each of the holding tool 5 placed on the stage 213 and the workpiece W held by the holding tool 5 (a step S204). Especially, the shape measurement apparatus 21 may measure, as the three-dimensional shape of the holding tool 5, a three-dimensional shape of the base plate 50B attached to the holding tool 5. The shape measurement apparatus 21 transmits the measurement information, which indicates the measured result of the three-dimensional shape of each of the holding tool 5 and the workpiece W, to the control information generation apparatus 22. The measurement information may include information indicating a three-dimensional position of each of a plurality of points of the surface of the holding tool 5 and a plurality of points of the surface of the workpiece W in the measurement coordinate system of the shape measurement apparatus 21. Point cloud data is one example of the measurement information.

When the three-dimensional shape of each of the holding tool 5 and the workpiece W is measured, the shape measurement apparatus 21 may move the shape measurement head 211 by using the head driving system 212. The shape measurement apparatus 21 may move the stage 213 by using the stage driving system 214. Namely, the shape measurement apparatus 21 may change a positional relationship between the shape measurement head 211 and each of the holding tool 5 and the workpiece W. For example, the shape measurement apparatus 21 may measure the three-dimensional shape of each of the holding tool 5 and the workpiece W in a state where the positional relationship between the shape measurement head 211 and each of the holding tool 5 and the workpiece W is a first positional relationship. Then, the shape measurement apparatus 21 may measure the three-dimensional shape of each of the holding tool 5 and the workpiece W in a state where the positional relationship between the shape measurement head 211 and each of the holding tool 5 and the workpiece W is a second positional relationship that is different from the first positional relationship. In this case, there is a higher possibility that the shape measurement head 211 can measure the three-dimensional shape of a certain part of the measurement target object that could not be measured before the shape measurement head 211 moves. Namely, the blind spot of the shape measurement head 211 is reduced or eliminated.

Here, as illustrated in above-described FIG. 35(a) and FIG. 35(b), the heights of at least two of the plurality of connecting members 53 may be different as described above. In this case, there is a lower possibility that a certain particular part of the workpiece W is hidden by the connecting members 53 as viewed from the shape measurement head 211, compared to a case where the heights of all of the plurality of connecting members 53 are the same. For example, there is a lower possibility that the particular part of the workpiece W, which is positioned at the same height as the connecting member 53, is always hidden by the connecting member 53 as viewed from the shape measurement head 211. As a result, the blind spot of the shape measurement head 211 is reduced or eliminated.

In parallel with or before or after the operations from the step S201 to the step S204, the control information generation apparatus 22 acquires the calibration information corresponding to the combination pattern of the processing apparatus 1 and the holding tool 5 (a step S205). Namely, the control information generation apparatus 22 acquires the calibration information corresponding to the actual combination pattern of the processing apparatus 1 that is actually used to process the workpiece W and the holding tool 5 that actually holds the workpiece W.

Then, the control information generation apparatus 22 generates the processing path information based on the measurement information acquired at the step S204 and the calibration information acquired at the step S205 (a step S206 to a step S207).

Specifically, first, the control information generation apparatus 22 generates processing model data (a step S206). The processing model data indicates a three-dimensional model (processing model) having a three-dimensional shape of a processing part, which should be processed by the processing apparatus 1, in the processing coordinate system. In a case where the processing apparatus 1 performs the additive manufacturing, the processing part may include the build object that should be built on the workpiece W by the processing apparatus 1 performing the additive manufacturing. In a case where the processing apparatus 1 performs the subtractive manufacturing, the processing part may include a structural object that should be removed from the workpiece W by the processing apparatus 1 performing the subtractive manufacturing.

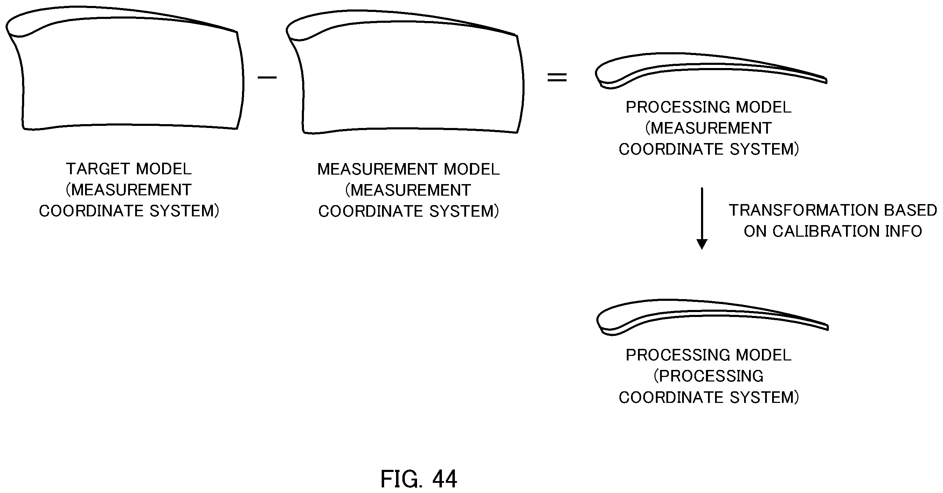

In order to generate the processing model data, as illustrated in FIG. 44, the control information generation apparatus 22 acquires target model data that indicates a three-dimensional model (a target model) having a target three-dimensional shape of the processed workpiece W in the measurement coordinate system. The target model data may be stored in the storage apparatus in advance, for example.

Furthermore, as illustrated in FIG. 44, the control information generation apparatus 22 generates, based on the measurement information, measurement model data that indicates a three-dimensional model (a measurement model) having a current three-dimensional shape (namely, an actual three-dimensional shape) of the workpiece W in the measurement coordinate system. In other words, the control information generation apparatus 22 acquires workpiece shape information that is included in the measurement information and that is related to the current three-dimensional shape (namely, the actual three-dimensional shape) of the workpiece W, and generates the measurement model data indicating the measurement model from the acquired workpiece shape information. Alternatively, the workpiece shape information itself may be used as the measurement model data.

Here, in a case where at least one of the shape measurement head 211 and the stage 213 moves in order to measure the three-dimensional shape of each of the holding tool 5 and the workpiece W as described above, the control information generation apparatus 22 may generate single measurement model data by merging the measurement information (before movement) indicating the three-dimensional shape of each of the holding tool 5 and the workpiece W before the shape measurement head 211 and the stage 213 move and the measurement information (after movement) indicating the three-dimensional shape of each of the holding tool 5 and the workpiece W after the shape measurement head 211 and the stage 213 move. Namely, the control information generation apparatus 22 may perform a stitching (in other words, a combining) of the measurement information. In this case, the control information generation apparatus 22 may generate the measurement model data by using the single measurement information acquired by merging the measurement information (before movement) and the measurement information (after movement).

Specifically, the control information generation apparatus 22 may merge the measurement information (before movement) and the measurement information (after movement) so that a certain part of the holding tool 5 indicated by the measurement information (before movement) is positioned at a position that is the same as a position of the same part of the holding tool 5 indicated by the measurement information (after movement). The control information generation apparatus 22 may merge the measurement information (before movement) and the measurement information (after movement) so that a certain part of the workpiece W indicated by the measurement information (before movement) is positioned at a position that is the same as a position of the same part of the workpiece W indicated by the measurement information (after movement).

The control information generation apparatus 22 may integrate the measurement information (before movement) and the measurement information (after movement) based on the positions of the plurality of base plates 50B indicated by the measurement information. For example, the control information generation apparatus 22 may merge the measurement information (before movement) and the measurement information (after movement) so that the position of the reference part 509 of one base plate 50B indicated by the measurement information (before movement) is the same as the position of the reference part 509 of the same base plate 50B indicated by the measurement information (after movement). Here, in a case where the plurality of base plates 50B surround the workpiece W as described above, an accuracy of merging the measurement information (before movement) and the measurement information (after movement) improves.

Then, as illustrated in FIG. 44, the control information generation apparatus 22 calculates, as the processing model, a three-dimensional model (a difference model) that corresponds to a difference between the target model indicated by the target model data and the measurement model indicated by the measurement model data. Namely, the control information generation apparatus 22 generates, as the processing model data indicating the processing model, difference model data indicating the difference model corresponding to the difference between the target model and the measurement model.

However, the measurement model data indicates the actual three-dimensional shape of the workpiece W in the measurement coordinate system, and the target model data indicates the target three-dimensional shape of the workpiece W in the measurement coordinate system. Therefore, as illustrated in FIG. 44, if the measurement model data and the target model data are used as they are, the control information generation apparatus 22 merely generates the processing model data that indicates the processing model (the difference model) in the measurement coordinate system. Therefore, the control information generation apparatus 22 uses not only the measurement model data and target model data but also the measurement information and the calibration information to generate the processing model data that indicates the processing model (the difference model) in the processing coordinate system.

As a first method, as illustrated in FIG. 44, the control information generation apparatus 22 may generate the processing model data that indicates the processing model in the processing coordinate system by transforming the processing model data indicating the processing model in the measurement coordinate system calculated in the above-described procedure described above to the processing model data indicating the processing model in the processing coordinate system based on the measurement information and the calibration information.

Specifically, the above-described measurement information includes the information related to the three-dimensional shapes of the plurality of base plates 50B attached to the holding tool 5. In this case, the control information generation apparatus 22 may calculate the position of each of the plurality of base plates 50B in the measurement coordinate system based on the measurement information (especially, the information related to the three-dimensional shapes of the plurality of base plates 50B). Especially, the control information generation apparatus 22 may calculate the position of the reference part 509 of each of the plurality of base plates 50B in the measurement coordinate system based on the measurement information. Specifically, as described above with reference to FIG. 39(a), the control information generation apparatus 22 may determine the reference part 509 of the base plate 50B based on the shape of the second plate part 502B (especially, the shape of the reference surface 504B). For example, the control information generation apparatus 22 may determine the shape of the second plate part 502B (especially, the shape of the reference surface 504B) based on the measurement information, and determine the reference part 509 of the base plate 50B based on the determined shape of the second plate part 502B (especially, the shape of the reference surface 504B). Then, the control information generation apparatus 22 may calculate the position of the determined reference part 509 of the base plate 50B in the measurement coordinate system based on the measurement information.

As one example, the control information generation apparatus 22 may calculate positions of at least three side surfaces of the second plate part 502B based on the measurement information. Feature points of the at least three side surfaces of the second plate part 502B may be determined in advance, and the control information generation apparatus 22 may calculate the positions of the at least three side surfaces of the second plate part 502B by performing a fitting processing for adjusting a position of the feature point with respect to the measurement information (for example, the point cloud data of the base plate 50B). Then, the position of the reference part 509 of the base plate 50B (for example, the position of the vertex) may be determined based on the positions of the at least three side surfaces of the second plate part 502B. For example, the control information generation apparatus 22 may calculate a position of the notch of the second plate part 502B based on the positions of the at least three side surfaces of the second plate part 502B, and calculate the position of the reference part 509 based on the position of the notch. For example, the control information generation apparatus 22 may calculate, as the position of the reference part 509, a position at which the at least three side surfaces of the second plate part 502B intersect.

As another example, the user may designate the reference part 509 of the base plate 50B by referring to the measurement information displayed on the output apparatus 225 (especially, the display apparatus) of the control information generation apparatus 22. For example, the output apparatus 225 may display the point cloud data (alternatively, an display object indicating a three-dimensional shape) that is one example of the measurement information, and the user may designate the reference part 509 on the point cloud data or any display object. In this case, the control information generation apparatus 22 may calculate the position of the reference part 509 designated by the user.

As another example, the control information generation apparatus 22 may calculate the position of the reference part 509 of the base plate 50B by automatically recognizing the reference part 509 of the base plate 50B. For example, the control information generation apparatus 22 may automatically recognize the reference part 509 of the base plate 50B by recognizing the shape of the base plate 50B based on template information indicating the shape of the base plate 50B. Then, the control information generation apparatus 22 may calculate the position of the reference part 509 of the base plate 50B.

As another example, the shape measurement apparatus 21 may automatically measure the position of the reference part 509 of the base plate 50B by automatically recognizing the reference part 509 of the base plate 50B. For example, the shape measurement apparatus 21 may automatically recognize the reference part 509 of the base plate 50B by recognizing the shape of the base plate 50B based on the template information indicating the shape of the base plate 50B. Then, the shape measurement apparatus 21 may measure the reference part 509 of the base plate 50B.

Incidentally, the positions of the plurality of reference parts 509 that are included in the plurality of base plates 50B, respectively, are equivalent to the positions of the plurality of reference parts 522 of the holding tool 5 as described above. Therefore, the control information generation apparatus 22 may be considered to calculate the positions of the plurality of reference parts 522. Namely, the measurement information may be considered to include information related to the positions of the plurality of reference parts 522 and the control information generation apparatus 22 may be considered to calculate the positions of the plurality of reference parts 522 based on the measurement information.

Then, the control information generation apparatus 22 may calculate the position of the holding tool 5 in the measurement coordinate system based on the positions of the plurality of reference parts 522 in the measurement coordinate system, if necessary. For example, the control information generation apparatus 22 may calculate at least one of the X position, the Y position, the Z position, the θX position, the θY direction, and the θZ position of the holding tool 5 in the measurement coordinate system.

On the other hand, the calibration information indicates the position of the holding tool 5 in the processing coordinate system. Therefore, the control information generation apparatus 22 may generate a transformation matrix (for example, a rigid body transformation matrix) for transforming a position in either one of the processing coordinate system and the measurement coordinate system to a position in the other one of the processing coordinate system and the measurement coordinate system, based on the position of the holding tool 5 in the processing coordinate system indicated by the calibration information and the position of the holding tool 5 in the measurement coordinate system calculated from the measurement information. Alternatively, the calibration information indicates the positions of the plurality of reference parts 522 in the processing coordinate system in addition to or instead of the position of the holding tool 5 in the processing coordinate system. Therefore, the control information generation apparatus 22 may generate the transformation matrix (for example, the rigid body transformation matrix) for transforming the position in either one of the processing coordinate system and the measurement coordinate system to the position in the other one of the processing coordinate system and the measurement coordinate system, based on the positions of the plurality of reference parts 522 in the processing coordinate system indicated by the calibration information and the positions of the plurality of reference parts 522 in the measurement coordinate system calculated from the measurement information.

As a result, the control information generation apparatus 22 may transform the processing model data indicating the processing model in the measurement coordinate system to the processing model data indicating the processing model in the processing coordinate system by using the generated transformation matrix. As a result, the control information generation apparatus 22 can generate the processing model data indicating the processing model in the processing coordinate system.

Here, in a case where the plurality of base plates 50B surround the workpiece W (namely, the plurality of reference parts 522 of the holding tool 5 surround the workpiece W) as described above, an error of a coordinate transformation by the transformation matrix is smaller, compared to a case where the plurality of base plates 50B do not surround the workpiece W. Therefore, in a case where the plurality of base plates 50B surround the workpiece W, the control information generation apparatus 22 can generate the processing model data that indicates the processing model in the processing coordinate system more accurately.

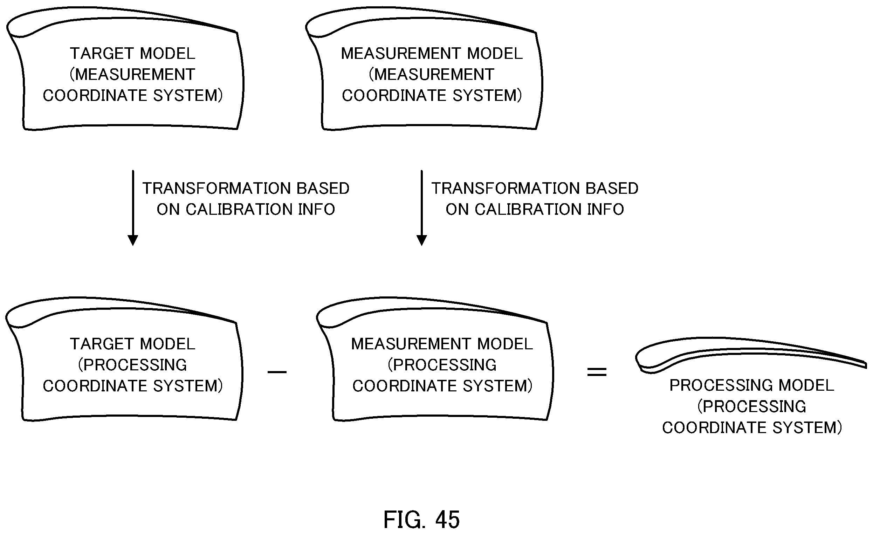

As a second method, the control information generation apparatus 22 may transform the measurement model data and the target model data by using the transformation matrix before generating the processing model data indicating the processing model in the measurement coordinate system, as illustrated in FIG. 45. Specifically, the control information generation apparatus 22 may transform the measurement model data indicating the actual three-dimensional shape of the workpiece W in the measurement coordinate system to the measurement model data indicating the actual three-dimensional shape of the workpiece W in the processing coordinate system based on the transformation matrix. Furthermore, the control information generation apparatus 22 may transform the measurement model data indicating the target three-dimensional shape of the workpiece W in the measurement coordinate system to the measurement model data indicating the target three-dimensional shape of the workpiece W in the processing coordinate system based on the transformation matrix. Then the control information generation apparatus 22 generates the difference model data indicating the difference model corresponding to the difference between the target model indicated by the transformed target model data and the measurement model indicated by the transformed measurement model data as the processing model data indicating the processing model in the processing coordinate system.

Incidentally, both of the above-described two methods may be considered to be equivalent to an operation for determining the positional relationship between the workpiece W and the base plate 50B in the measurement coordinate system based on the measurement information and generating the processing model data based on the determined positional relationship and the calibration information. This is because both of the measurement information and the calibration information include the information related to the position of the base plate 50B, and therefore, the control information generation apparatus 22 may be considered to generate the transformation matrix based on the information related to the position of the base plate 50B that is included in both of the measurement information and the calibration information and transform the position of the workpiece W in the measurement coordinate system to the position of the workpiece W in the processing coordinate system based on the generated transformation matrix.

Again in FIG. 43, then, the control information generation apparatus 22 generates the processing path information based on the processing model data generated at the step S206 (a step S207). Specifically, the control information generation apparatus 22 generates the processing path information indicating the position that should be irradiated with the processing light EL to process the processing part having the three-dimensional shape indicated by the processing model data generated at the step S206. Incidentally, an operation for generating the processing path information from the three-dimensional model that is processing target itself may be the same as an existing operation. Therefore, the detail of the operation for generating the processing path information based on the processing model data is omitted.

Then, the control information generation apparatus 22 transmits (in other words, inputs) the processing path information generated at the step S207 to the processing apparatus 1 (especially, the control apparatus 17) (step S208).

Then, the processing apparatus 1 processes the workpiece W based on the processing path information transmitted from the control information generation apparatus 22. Specifically, first, the holding tool 5 holding the workpiece W is taken out of the shape measurement apparatus 21. Then, the holding tool 5 holding the workpiece W is transported from the shape measurement apparatus 21 to the processing apparatus 1. For example, the holding tool 5 holding the workpiece W may be transported from the shape measurement apparatus 21 to the processing apparatus 1 by the transport apparatus 4. Then, the holding tool 5 holding the workpiece W is placed on the stage 131 of the processing apparatus 1. Namely, the holding tool 5 is placed at the reference placement position of the stage 131. Then, the processing apparatus 1 starts processing the workpiece W based on the processing path information.

Incidentally, as described above, the processing path information is generated before the processing apparatus 1 processes the workpiece W. In this case, the control information generation apparatus 22 may generate the processing path information before the holding tool 5 taken out of the shape measurement apparatus 21 is placed in the processing apparatus 1. The control information generation apparatus 22 may generate the processing path information after the holding tool 5 taken out of the shape measurement apparatus 21 is placed in the processing apparatus 1.

After the processing apparatus 1 performs processing on the workpiece W based on the processing path information, the holding tool 5 holding the processed workpiece W may be transported by the transport apparatus 3 from the processing apparatus 1 to the measurement apparatus 2 (e.g., the shape measurement apparatus 21). Subsequently, the shape measurement apparatus 21 measures the three-dimensional shapes of both the holding tool 5 placed on the stage 213 and the processed workpiece W held by the holding tool 5 (a step S209). Incidentally, the processing in the step S209 corresponds to the processing described above in "(3) Inspection after Building".

Incidentally, for a more detailed description of "(4-1) Calibration Operation" and "(4-2) Processing Path Generation Operation," refer, for example, to International Application No. PCT/JP2022/017163.

As described above, after the holding tool 5 and the workpiece W held by the holding tool 5 are measured by the shape measurement apparatus 21 of the measurement system 2, the holding tool 5 holding the workpiece W is transferred from the shape measurement apparatus 21 to the processing apparatus 1. Then, the holding tool 5 holding the workpiece W is placed onto the stage 131 of the processing apparatus 1. At this time, the position of the holding tool 5 holding the workpiece W on the stage 131 may deviate from the position of the holding tool 5 on the stage 131 during the processing of the step S104 described above (see FIG. 36).

Therefore, after the processing described in the step S208 (see FIG. 43), the processing apparatus 1 may perform the following processing before starting processing of the workpiece W based on the processing path information. After the holding tool 5 holding the workpiece W is placed on the stage 131, the processing apparatus 1 may re-measure the position of the processed portion on the base plate 50 (e.g., the base plate 50A). Then, the processing apparatus 1 may compare the position of the processed portion measured during the processing of the step S104 described above with the position of the processed portion measured again. The processing apparatus 1 may correct the processing path based on the difference between the position of the processed portion measured during the processing of the step S104 and the position of the processed portion measured again. Correcting the processing path may include, for example, at least one of changing the processing position, changing the processing route, and changing the power of the processing light EL.

With this configuration, even if the position of the holding tool 5 on the stage 131 shifts from its position during the processing in the step S104 when the holding tool 5 holding the workpiece W is transferred from the shape measurement apparatus 21 to the processing apparatus 1, the workpiece W can be processed appropriately.

Incidentally, the measurement of the processed portion by the processing apparatus 1 may be performed not only by an imaging device but also by optical measurement apparatuses such as a light beam measuring instrument or a three-dimensional scanner.

### <Supplementary Note>

Regarding the above-described example embodiments, below described Supplementary notes are further disclosed.

### (Supplementary Note 1)

A display method comprising:
acquiring a difference model indicating difference between an object model acquired by measuring a three-dimensional shape of an object and a target model indicating a target shape of the object after a processing, generated based on the object model;
acquiring a post-processing model indicating at least a part of the three-dimensional shape of a post-processing object, which is the object processed based on the difference model, by measuring the post-processing object;
generating difference information relating to a difference between the difference model and the post-processing model; and
displaying difference indicated by the difference information.

### (Supplementary Note 2)

A display method comprising:
acquiring a difference model indicating difference between an object model acquired by measuring a three-dimensional shape of an object and a target model indicating a target shape of the object after a processing;
acquiring a post-processing model indicating at least a part of the three-dimensional shape of a post-processing object, which is the object processed based on the difference model, by measuring the post-processing object;
generating difference information relating to a difference between the difference model and the post-processing model; and
displaying difference indicated by the difference information.

### (Supplementary Note 3)

A display method comprising:
acquiring a target model, which indicates a target shape of an object after a processing, generated based on an object model acquired by measuring a three-dimensional shape of the object;
acquiring a post-processing model indicating at least a part of a three-dimensional shape of a post-processing object, which is the object processed based on the object mode and the target model, by measuring the post-processing object;
generating difference information relating to a difference between the target model and the post-processing model; and
displaying difference indicated by the difference information.

The present invention is not limited to the above-described example embodiments and may be allowed to be changed, if desired, without departing from the essence or spirit of the invention which can be read from the claims and the entire specification, and an information processing method and a processing apparatus which involve such changes, are also intended to be within the technical scope of the present invention.

### Description of Reference Codes

- SYS: processing system
- 1: processing apparatus
- 2: measurement system
- 21: shape measurement apparatus
- 22: control information generation apparatus
- W: workpiece
- OM: object model
- RM: reference model
- TM: deformation model
- DM: difference model
- PM: post-processing model
- PDM: post-processing divisional model
- PPM: processed part model
- ADM: post-processing difference model

## Claims

1. An information processing method comprising:
acquiring a difference model indicating difference between an object model acquired by measuring a three-dimensional shape of an object and a target model indicating a target shape of the object after a processing, generated based on the object model;
acquiring a post-processing model indicating at least a part of a three-dimensional shape of a post-processing object, which is the object processed based on the difference model, by measuring the post-processing object; and
generating difference information relating to a difference between the difference model and the post-processing model.

2. The information processing method according to claim 1, further comprising:
generating display data for displaying difference indicated by the difference information on a display apparatus according to a difference amount.

3. The information processing method according to claim 2, wherein
the display data includes data for displaying at least one of the difference model and the post-processing model.

4. The information processing method according to any one of claims 1 to 3, wherein
the target model is generated by extending at least a part of the object model.

5. The information processing method according to any one of claims 1 to 3, wherein
the target model is generated by deforming at least a part of a reference model, which indicates a three-dimensional shape of the object before use, based on the object model.

6. The information processing method according to claim 5, wherein
generating the target model includes deforming the reference model such that difference between a three-dimensional shape of a first part of a surface of the reference model and a three-dimensional shape of a second part, which corresponds to the first part, of a surface of the object model becomes small.

7. The information processing method according to claim 5 or 6, wherein
the reference model indicates the three-dimensional shape of a part of the object, and
the post-processing model indicates the three-dimensional shape of a part of the object corresponding to the reference model from the measured three-dimensional shape.

8. The information processing method according to claim 4, wherein
the target model is generated by removing a part of the object model after extending at least a part of the object model.

9. The information processing method according to claim 4, wherein
the target model is generated by
extending at least a part of the object model, and
deforming at least a part of the extended object model based on the object model.

10. The information processing method according to claim 9, wherein
the target model is generated by removing a part of the object model after at least a part of the object model is deformed.

11. The information processing method according to claim 9, wherein
generating the target model includes deforming the extended object model such that difference between a three-dimensional shape of a first part of a surface of the extended object model and a three-dimensional shape of a second part, which corresponds to the first part, of a surface of the object model becomes small.

12. The information processing method according to any one of claims 1 to 11, wherein
the post-processing model includes a processed part model, which is a three-dimensional shape of a processed part based on the difference model, and
the difference information is generated based on the difference model and the processed part model.

13. The information processing method according to claim 12, wherein
the processed part model is acquired based on difference between the object model and the post-processing model.

14. The information processing method according to claim 12 or 13, wherein
the processed part model is acquired further using information in generating the target model.

15. The information processing method according to any one of claims 12 to 14, wherein
the post-processing model is generated by acquiring a result indicating a three-dimensional shape of a part of the post-processed object, which corresponds to a reference model indicating a three-dimensional shape of a part of the object before use, from a result of measuring the post-processing object, and
the processed part model is acquired further using information in acquiring a result indicating a three-dimensional shape of a part of the post-processing object.

16. The information processing method according to any one of claims 13 to 15, wherein
the processed part model is acquired by
acquiring a plurality of unit regions corresponding to a part of the post-processing model, wherein the plurality of unit regions have a distance from the object model equal to or greater than a first threshold,
acquiring at least one cluster region, wherein one cluster region is a group of unit regions where a distance between any two unit regions is less than or equal to a second threshold, and
outputting at least one of the acquired cluster regions as the processed part model.

17. The information processing method according to any one of claims 12 to 16, wherein
the difference information is generated further based on the object model.

18. The information processing method according to claim 17, wherein
the difference information is generated based on distance information of the processed part model and the object model, and distance information of the processed part model and the difference model.

19. The information processing method according to any one claims 12 to 18, wherein
the difference information is generated based on a model, which is generated by further deforming the difference model, instead of the difference model.

20. The information processing method according to claim 16, wherein
the first threshold is set by a first input being an input of a user, and
the second threshold is set by a second input being an input of a user.

21. The information processing method according to any one of claims 1 to 20, wherein
a condition when the object is measured is the same as a condition when an object, which has undergone the processing, is measured.

22. The information processing method according to any one of claims 1 to 20, further comprising:
calculating an optimal processing condition based on the difference information and a processing condition of the object.

23. The information processing method according to any one of claims 1 to 22, further comprising:
generating display data for display on the display apparatus according to a direction in which difference between the difference model indicated by the difference information and the post-processing model occurred.

24. A computer program for causing a computer to execute the information processing method according to any one of claims 1 to 23.

25. A recording medium storing a computer program for causing a computer to execute the information processing method according to any one of claims 1 to 23.

26. An information processing apparatus configured to generate the display data using the information processing method according to any one of claims 1 to 23.

27. A processing apparatus configured to perform at least one of a removal processing and an additive processing on an object that has undergone the processing, based on the difference information generated by the information processing method according to any one of claims 1 to 21.

28. An information processing method comprising:
acquiring an object model acquired by measuring a three-dimensional shape of an object;
acquiring a target model indicating a target shape of the object after a processing, generated based on the object model;
acquiring a difference model indicating difference between the object model and the target model;
acquiring a post-processing model indicating at least a part of a three-dimensional shape of a post-processing object, which is the object processed based on the difference model, by measuring the post-processing object; and
generating difference information relating to a difference between the difference model and the post-processing model.

29. An information processing method comprising:
acquiring a difference model indicating difference between an object model acquired by measuring a three-dimensional shape of an object and a target model indicating a target shape of the object after a processing;
acquiring a post-processing model indicating at least a part of a three-dimensional shape of a post-processing object, which is the object processed based on the difference model, by measuring the post-processing object; and
generating difference information relating to a difference between the difference model and the post-processing model.

30. An information processing method comprising:
acquiring a target model indicating a target shape of an object after a processing, generated based on an object model acquired by measuring a three-dimensional shape of the object;
acquiring a post-processing model indicating at least a part of a three-dimensional shape of a post-processing object, which is the object processed based on the object model and the target model, by measuring the post-processing object; and
generating difference information relating to a difference between the target model and the post-processing model.

31. The information processing method according to claim 29 or 30, further comprising:
generating display data for displaying difference indicated by the difference information on a display apparatus according to a difference amount.

32. An information processing method comprising:
acquiring a target model indicating a target shape of an object after a processing;
acquiring a post-processing model indicating at least a part of a three-dimensional shape of a post-processing object, which is the object processed based on the object model and the target model, by measuring the post-processing object; and
generating difference information relating to a difference between the target model and the post-processing model.
